(19)

**Europäisches Patentamt**
**European Patent Office**
**Office européen des brevets**

(11) **EP 4 214 801 B1**

(12) **EUROPEAN PATENT SPECIFICATION**

(45) Date of publication and mention
of the grant of the patent:
**17.04.2024 Bulletin 2024/16**

(21) Application number: **21782910.0**

(22) Date of filing: **21.09.2021**

(51) International Patent Classification (IPC):
*H01Q 1/42* *(2006.01)*    *H01Q 13/00* *(2006.01)*
*H01Q 19/10* *(2006.01)*    *H01Q 21/06* *(2006.01)*
*G01R 29/08* *(2006.01)*    *G01R 27/26* *(2006.01)*

(52) Cooperative Patent Classification (CPC):
**G01R 27/2617; H01Q 1/42;** G01N 22/00;
G01R 29/0871; G01S 7/03; G01S 7/4004;
H01Q 1/3233

(86) International application number:
**PCT/EP2021/075975**

(87) International publication number:
**WO 2022/063794 (31.03.2022 Gazette 2022/13)**

(54) **RADOME MEASUREMENT**

RADOMMESSUNG

MESURE DE RADÔME

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.09.2020 EP 20198374**

(43) Date of publication of application:
**26.07.2023 Bulletin 2023/30**

(73) Proprietor: **Perisens GmbH**
**85622 Feldkirchen (DE)**

(72) Inventor: **PFEIFFER, Florian**
**85551 Kirchheim b. München (DE)**

(74) Representative: **Stellbrink & Partner**
**Patentanwälte mbB**
**Widenmayerstrasse 10**
**80538 München (DE)**

(56) References cited:
WO-A1-2020/074667    DE-A1-102018 216 032
FR-A1- 2 692 360    US-A- 5 371 505
US-A1- 2020 049 751

- QAMAR ZEESHAN ET AL: "An Accurate Method
for Designing, Characterizing, and Testing a
Multi-Layer Radome for mm-Wave Applications",
IEEE ACCESS, IEEE, USA, vol. 8, 29 January 2020
(2020-01-29), pages 23041-23053, XP011770578,
DOI: 10.1109/ACCESS.2020.2970544
- DANIEL BOURREAU ET AL: "A Quasi-Optical
Free-Space Measurement Setup Without
Time-Domain Gating for Material
Characterization in the -Band", IEEE
TRANSACTIONS ON INSTRUMENTATION AND
MEASUREMENT, IEEE, USA, vol. 55, no. 6, 1
December 2006 (2006-12-01), pages 2022-2028,
XP011150783, ISSN: 0018-9456, DOI:
10.1109/TIM.2006.884283

Note: Within nine months of the publication of the mention of the grant of the European patent in the European Patent
Bulletin, any person may give notice to the European Patent Office of opposition to that patent, in accordance with the
Implementing Regulations. Notice of opposition shall not be deemed to have been filed until the opposition fee has been
paid. (Art. 99(1) European Patent Convention).

**Description**

**Field of invention**

The present invention generally relates to a method and system for measuring or testing radomes, particularly, radomes for automotive radars.

**Introduction**

Radars are detection systems or sensors that use electromagnetic waves to determine range, angle or velocity of objects. A radar usually comprises a transmitting unit, or antenna, that radiates electromagnetic waves. The frequency of the emitted electromagnetic wave, or the operational frequency of the radar, can be within a wide range of the electromagnetic spectrum, usually within the radio and microwave part of the spectrum and typically depends on the use scenario of the radar. The lower the operational frequency of the radar the higher the detection range, as the transmitted electromagnetic waves are less attenuated or affected by external factors, e.g. by weather conditions, radar covers, etc. On the other hand, high frequencies can offer a better accuracy and resolution of detection due to the smaller wavelength, but at the same time are highly susceptible to attenuation.

An emerging technology is the use of radar systems in automotive industry. More particularly, radars operating in high frequencies, such as, 20 to 160 GHz, usually between 70 and 90 GHz, can provide a very high range resolution and achievable accuracy. This feature makes such radars preferable for use in parking assistants, blind spot monitoring, brake assistant systems, etc. However, due to the very high operating frequency, such radar systems can suffer from high signal attenuation.

A radar is usually set to operate in open-air conditions. Thus, the radar is exposed to different weather conditions, dust or other external particles and forces that may damage the radar and/or lower the accuracy of its measurements. In cars the radars are wanted to be covered for esthetic reasons so that they are not visible. To alleviate the above, a radome, also referred as a radar dome or radar cover, is implemented around the radar, hence, protecting it against external factors and/or reducing its salience. Typically, the bumper or the emblem of a vehicle is used as a radome to cover and hide the radar.

While hiding the radar (e.g., behind a bumper or emblem of car) can offer protection to the radar and can decrease its salience, it can also affect the operation of the radar. Due to dielectric characteristics of the radome material, the radome may cause unwanted reflections, attenuation, beam deflection, beam broadening, sidelobe increase, etc. These side effects may introduce errors in the radar sensing. The unwanted effects caused by the radome, particularly attenuation and reflection, can become significant when the radar operates in high frequencies. For example, the radars operating in high frequencies, usually used in automotive industry are highly susceptible to suffer from attenuation and other unwanted effects caused by the radome.

Thus, in one hand it is advantageous for various reasons (e.g. protection against weather conditions or external elements or forces and/or improving vehicle design) to cover the radar sensor with a radome. On the other hand, the radome can introduce unwanted effects (e.g. signal attenuation and reflections) that may increase the inaccuracy or decrease the detection or sensing capability of the radar.

Furthermore, the use of radar systems in vehicles, such as for parking assistance, blind spot monitoring, braking assistance, etc., are prone to strict requirements set by legal standards, such that maximum safety can be ensured for traffic participants. These standards or regulations usually require high detection accuracy.

Some attempts have been made trying to alleviate the shortcomings of using a radome.

For example, US 5,371,505 A relates to a method for determining signal transmission characteristics for a selected area of a radome.

US 3,936,736 A relates to a hand held universal radome tester which is an instrument for locating discontinuities and impurities inside a radome wall and for determining the quality of an anti-static paint coating over the exterior surface of a radome.

EP 3,258,288 A1 relates to a method and system for testing the transmission and reflection properties of a radome.

US 5,066,921 A relates to a system for testing radomes to detect defects and evaluate the radome effect on antenna patterns.

Z. Qamar, N. Aboserwal and J. L. Salazar-Cerreno, "An Accurate Method for Designing, Characterizing, and Testing a Multi-Layer Radome for mm-Wave Applications," in IEEE Access, vol. 8, pp. 23041-23053, 2020, doi: 10.1109/ACCESS.2020.2970544, presents an accurate procedure to design, characterize and test a radome for millimeter-wave applications. In this procedure, an accurate analytical model is presented to design a radome structure that takes into consideration the bandwidth, losses, reflections and depolarization factor as a function of frequency and incident angle. To guarantee a good operational electrical performance, the proposed procedure includes a material characterization and accurate test procedure based on the free-space Gaussian beam method and time gating filtering technique. Four radomes (two-monolithic and two A-sandwich) at 82 GHz and 94 GHz are designed, characterized and tested to validate the proposed technique. Results obtained with this procedure are compared with numerical simulations and experimental results. This method is shown to be accurate and versatile for radomes in mm-Wave applications.

FR2692360A1 provides an electromagnetic equipment comprising a plurality of pairs each formed by a transmitter and a microwave receiver arranged to cooperate with each other in the near field. The pairs are arranged in a chosen number and in respective positions chosen as a function of the dimensions and geometry of the radome to be controlled. The wall of the radome is interposed between the transmitter and the receiver of each pair, so that each receiver receives a wave which has undergone a modification of amplitude and/or phase after passing through the wall. The modification of the wave is measured by relative displacement of the radome and of the electromagnetic equipment, so that the pairs scan the entire useful surface of the radome.

In US 2020/049751 a probe is described. The probe includes a probe antenna, a transmitter, a receiver and circuitry including hardware. The probe antenna is constructed of a dielectric material connected to a waveguide. The probe antenna has a far field region. The transmitter is coupled to the probe antenna. The receiver is coupled to the probe antenna. The hardware is configured to communicate with the transmitter to enable the transmitter to direct a pulse of electromagnetic energy to the probe antenna and to receive a reflection signal from the receiver, the hardware is configured to determine a material property of a material within the far-field region of the probe antenna by analyzing the reflection signal.

US5371505A discloses a radome test system and method which avoid the necessity for returning a repaired nose-mount type aircraft radar radome to a radar test range for recertification. Data representative of signal transmission characteristics of a repaired area of the radome wall is derived by use of transmission and reflection coefficient determination techniques. A small antenna radiates a test signal through the radome wall and the test signal is then reflected back to the same antenna now operating in a receiving mode. Reflected test signal data is gathered as the spacing of the reflector from the radome wall is successively changed and such data is used to derive signal transmission characteristics. Data representative of such transmission characteristics for a repaired area and a reference area can then be compared in order to detect the presence of out of specification conditions in the repaired area. In other applications, pre-recorded reference data can be used to accomplish certification testing of radomes as part of the manufacturing process.

## Summary

The present invention seeks to overcome or at least alleviate the shortcomings and disadvantages of the prior art. It is therefore an object of the present invention to provide methods and systems for measuring and testing radomes.

These objects are met by the system and the method of the present invention.

In a first aspect the present invention relates to a method of measuring a property of a radome.

The radome, or radar dome, can be a structural enclosure that can be implemented or provided around a radar sensor (or radar) for protecting the radar. The radome can be weatherproof, thus, protecting the radar sensor from humidity, temperature, dust, etc. While in some cases the radome can be built specifically for protecting the radar, in other cases the radar can be hidden behind a structure, which can play the role of the radome. For example, in cars or robots, the radars can be hidden inside the enclosures of the car or robot (e.g. hidden behind the bumpers of the car or behind the emblems of the cars) for esthetic reasons as well as for protecting the radars. The enclosure would serve as a radome, hiding the radar sensor and protecting it from external factors, such as, weather.

However, as the radome interrupts the path of the signals transmitted and received by the radar sensor, the radome may affect these signals and as a consequence may lower the sensitivity and accuracy of the radar sensing. For example, the radome may cause attenuation, reflection, refraction, scattering, phase shift, frequency shift, change of direction of travel and change of the waveform of the electromagnetic waves that pass through it.

Thus, in one hand it can be advantageous to use the radome for protecting the radar and/or esthetic reasons, while on the other hand the radome interferes with the sensing of the radar. The present invention, addresses this issue by providing, inter alia, a method of measuring a property of the radome.

The property may comprise a dielectric property of the radome. Additionally or alternatively, the property may comprise a property that can be derived from or that can depend on a dielectric property of the radome. For example, the property can comprise a scattering parameter, e.g., a transmissivity and a reflectivity corresponding to the radome. Alternatively or additionally, the property can indicate an effect of a radome on electromagnetic waves that become incident on a surface of the radome. For example, the property can be a measure of an effect that the radome can have on electromagnetic waves that become incident on a surface of the radome. For example, the property may indicate an attenuation, a phase shift, a frequency shift, a change of the waveform and/or a change of the direction of travel of an electromagnetic wave incident on a surface of the radome.

The property can correspond to a transmission side of the radome and/or to a reception side of the radome.

The property can be in the singular or in the plural. In the former case, a single property can correspond to the entire radome. In the latter case, each of the plurality of properties can correspond to a respective side of the radome. In some embodiments, each of the plurality of properties can correspond to a respective on of multiple areas of the radome. That is, each of the plurality of properties can indicate the effect that the respective area of the radome can have on an electromagnetic wave incident on the respective area.

Determining a property of the radome can be advantageous as it can facilitate alleviating (e.g. compensating for) the effect that the radome can have on the sensing of the radar that it can cover. Hence, the accuracy of the radar covered by the radome can be improved. This can be particularly advantageous for radomes used in vehicles and robots, wherein safety of their operation can depend on the accurate operation of the sensors they comprise.

Further, the present method can further allow testing radomes if they meet preset requirements. For example, the radome measuring system can measure the attenuation of a signal caused by the radome and can determine if the radome meets a preset requirement stating the maximum tolerable attenuation that the radome can cause to electromagnetic waves. This can be particularly advantageous on radars used in cars, i.e. automotive radars. In one hand, the automotive radars operate in high frequency ranges, such as, 70 - 90 GHz. Thus, the influence of the radome in this high frequency signals can be significant. On the other hand, strict requirements may be imposed by respective authorities, on the accuracy that automotive radar sensors should comprise, to ensure safety of traffic participants. Thus, testing radomes and their effect can be advantageous for evaluating whether a radome or a radar system meets preset (e.g. legal or standard) requirements.

The method comprises utilizing at least one transmitting antenna facing a first side of the radome and utilizing at least one receiving antenna facing a second side of the radome, wherein the first side is opposite to the second side. In other words, the transmitting antenna and the receiving antenna can be provided on opposite sides of the radome. Put differently, the radome, the transmitting antenna(s) and the receiving antenna(s) can be arranged such that the radome is between the transmitting antenna and the receiving antenna. Said arrangement can allow a signal emitted by the transmitting antenna(s) to become incident on the first side, enter the radome through the first side, and exit the radome from the second side.

The first side can refer to a first surface of the radome and the second side can refer to a second surface of the radome.

The first side of the radome may for example be the transmission side of the radome and the second side of the radome may for example be the reception side of the radome. Typically, when the radome covers a radar, the transmission side can refer to the side (i.e. surface) of the radome that faces the radar sensor and the reception side can refer to the side (i.e. surface) of the radome that faces the external environment. That is, signals emitted by the radar become incident on the transmission side of the radome and signals being received by the radar become incident on the reception side of the radome.

It will be understood, that the present method can reciprocally be carried out in the reverse, i.e., the first side being the reception side and the second side being the transmission side of the radome.

Moreover, the method comprises while the radome is positioned at a first distance from the at least one receiving antenna, the at least one transmitting antenna emitting a first electromagnetic wave and the at least one receiving antenna receiving a portion of the first electromagnetic wave. This can be referred to as a first measurement. The first measurement can comprise emitting the first electromagnetic wave from the at least one transmitting antenna, through the radome, to the at least one receiving antenna. Moreover, the first measurement can comprise, utilizing the at least one receiving antenna to measure or sense the portion of the first electromagnetic wave that reaches the at least one receiving antenna. The portion of the first electromagnetic wave received by the at least one receiving antenna may comprise transmitted and reflected copies of the first electromagnetic wave. The first measurement can be carried out while the radome is at a first position wherein the distance between the radome in the first position and the at least one receiving antenna is equal to a first distance.

In addition, the method can comprise while the radome is positioned at a second distance from the at least one receiving antenna, the at least one transmitting antenna emitting a second electromagnetic wave and the at least one receiving antenna receiving a portion of the second electromagnetic wave. This step of the method can be referred to as a second measurement. The second measurement can be performed similarly or identically to the first measurement while the radome is at second position wherein the distance between the radome in the second position and the at least one receiving antenna is equal to a first distance.

The method can further comprise determining the property of the radome based on the received portion of the first electromagnetic wave and the received portion of the second electromagnetic wave.

The distance between the radome and the at least one receiving antenna can for example be the shortest distance between the radome and the receiving antenna(s). The distance between the radome and the at least one receiving antenna can for example be measured in a direction parallel to the antenna boresight of the receiving antenna(s).

In other words, the present method comprises performing two measurements of the radome, wherein the radome is positioned at different distances from the at least one receiving antenna. Based on the results of the two measurements the property of the radome can be determined.

The present method can be advantageous as it can allow determining different properties of the radome. An electromagnetic wave emitted by the at least one transmitting antenna can traverse through the radome can be received by the at least one receiving antenna. This can facilitate performing a transmission measurement, e.g., measuring transmissivity of the radome. In addition, signals reflected by the second side can be received by the at least one receiving antenna. This can facilitate performing a reflection measurement, e.g., measuring a reflectivity of the radome.

The present method can be advantageous as it can determine a reflection property and a transmission property by performing the first and the second method, as discussed above. Moreover, the present method comprising performing the first and the second measurement not only allows determining both a reflection property and a transmission property using the same two measurements, but it can be more accurate and efficient compared to conventional method. The present method achieves this as the first and the second measurement can allow separating the transmitted parts from the reflected parts of the emitted electromagnetic waves. Hence, the reflected parts can be measured. Thus, on the one hand, the accuracy of the transmission measurement can be improved by compensating for the interference caused by the reflected parts on the transmitted part. On the other hand, a reflection measurement can be performed.

In other words, while measuring a property of the radome it can be advantageous to separate the reflected parts from the transmitted parts. However, due to the small difference between the distance of the path followed by the transmitted parts and the distance of the path followed by the reflected parts, it can be challenging and complex to separate the reflected parts from the transmitted parts. Time gating, which is a typical method used to suppress the unwanted signals (separation of signals using different path length and thus time-of-flight differences) may not be sufficient as it would require a very high frequency bandwidth. To alleviate this, the present method comprises performing a first and a second measurement while the radome is positioned at different distances from the at least one receiving antenna.

The first, and the second electromagnetic waves can be emitted with a same wavelength.

That is, the first and the second electromagnetic waves are emitted with a same frequency.

In general, the first and the second electromagnetic waves can comprise identical waveforms. For example, the first and the second electromagnetic waves can comprise the same frequency and/or the same bandwidth and/or the same center frequency and/or the same amplitude.

This can generally provide better results while determining the property of the radome based on the first and the second measurement.

A difference between the first distance and the second distance depends on the wavelength of the first electromagnetic wave and the wavelength of the second electromagnetic wave.

More particularly, the difference between the first distance and the second distance can be equal to a quarter of the wavelength of the first and second electromagnetic waves multiplied by an odd integer.

For example, the difference between the first distance and the second distance can be equal to a quarter of the wavelength of the first and second electromagnetic waves.

This can facilitate separating a transmitted part and a reflected part that can be comprised by the received portions. That is, each received portion (i.e. the received portion of the first electromagnetic wave and the received portion of the second electromagnetic wave) can comprise a transmitted part and a reflected part. The transmitted part can refer to the part of the electromagnetic wave that can directly be transmitted from the transmitting antenna(s), through the radome, to the receiving antenna(s). The reflected part can refer to the part (i.e. copy) of the electromagnetic wave that can be created when the transmitted part becomes incident on a surface of the receiving antenna and/or on a surface wherein the receiving antenna can be mounted. Said part can be reflected back towards the second side of the radome and from therein can be reflected again back towards the antenna side.

The transmitted parts follow the same path during the first and second measurement. The path can comprise the same distance as the distance between the transmitting antenna(s) and the receiving antenna(s). However, the reflected part during the first measurement and the reflected part during the second measurement can follow different paths that comprise a difference in length corresponding to the difference between the first distance and the second distance. For example, the paths of the reflected parts may differ by a quarter of the wavelength of the first and second electromagnetic waves multiplied by an odd integer. Thus, the reflected parts can be received at the receiving antenna with a phase shift of 180°. In other words, the reflected parts can be received totally out of phase. As such, the reflected parts can be separated from their respective transmitted parts. More particularly, by receiving the reflected parts out of phase, while receiving the transmitted parts in phase, an amplitude of the reflected parts and an amplitude of the transmitted parts can be determined. Based thereon, the property of the radome can be determined. Determining the property of the radome can comprise determining a reflection property of the radome based on a difference between the received portion of the first electromagnetic wave and the received portion of the second electromagnetic wave. As discussed, the transmitted parts can be received in phase, while the reflected parts can be received out of phase. As such, subtracting the received portions (i.e. subtracting signals corresponding to or representing the received portions), the transmitted parts can be negated, while the reflected parts will be summed. This can allow determining an amplitude, which can be a complex amplitude, of the reflected parts. This can further be utilized to determine the reflection property of the radome.

Determining the property of the radome can comprise determining a transmission property of the radome based on a sum between the received portion of the first electromagnetic wave and the received portion of the second electromagnetic wave. As discussed, the transmitted parts can be received in phase, while the reflected parts can be received out of phase. As such, summing the received portions (i.e. summing signals corresponding to or representing the received portions), the transmitted parts will be summed (as they comprise the same sign), while the reflected parts can be negated (as they comprise opposite signs). This can allow determining an amplitude, which can be a complex amplitude, of the transmitted parts. This can further be utilized to determine the transmission property of the radome.

The method can comprise changing a relative position between the radome and the at least one receiving antenna.

Changing a relative position between the radome and the at least one receiving antenna can comprise changing a distance between the radome and the at least one receiving antenna.

More particularly, changing a distance between the radome and the at least one receiving antenna can comprise changing the distance from the first distance to the second distance.

In preferred embodiments, changing a distance between the radome and the at least one receiving antenna can comprise changing the distance by a quarter of the wavelength of the first and second electromagnetic waves multiplied by an odd integer. This, as discussed, can facilitate receiving the reflected parts out phase.

Changing a relative position between the radome and the at least one receiving antenna can comprise at least one of moving the radome and moving the at least one receiving antenna.

That is, in some embodiments, the method can comprise moving the radome from a first position to a second position, wherein at the first position the radome is at the first distance from the receiving antenna(s) and at the second position the radome is at the second distance from the receiving antenna(s). The radome can be moved according to a translational motion.

In some embodiments, the method can comprise moving the receiving antenna(s). It will be understood that moving the receiving antenna(s) can further comprise moving the transmitting antenna(s). The relative position between the transmitting antenna(s) and the receiving antenna(s) is maintained fixed. In other words, in some embodiments, changing the distance between the radome and the at least one receiving antenna from the first distance to the second distance can comprise moving the transmitting and receiving antenna(s). The antenna(s) can be moved according to a translational motion. In some embodiments, the method can comprise moving both the radome and the antennas. Changing a relative position between the radome and the at least one receiving antenna can comprise positioning the radome such that the first side faces the at least one transmitting antenna and the second side faces the at least one receiving antenna. Alternatively or additionally, changing a relative position between the radome and the at least one receiving antenna can comprise positioning the at least one transmitting antenna such that it faces the first side and the at least one receiving antenna such that it faces the second side. In other words, the method can comprise arranging the antennas and the radome such that the radome is positioned between the antennas. This step can be performed at the start of the method or after performing an empty measurement, e.g., to obtain reference data.

Changing a relative position between the radome and the at least one receiving antenna can comprise positioning the radome such that it comprises a distance from the at least one receiving antenna equal to the first distance. Alternatively or additionally, changing a relative position between the radome and the at least one receiving antenna can comprise positioning the at least one receiving antenna such that it comprises a distance from the radome equal to the first distance. This step can be performed prior to performing the first measurement.

Changing a relative position between the radome and the at least one receiving antenna can comprise positioning the radome such that it comprises a distance from the at least one receiving antenna equal to the second distance. Alternatively or additionally, changing a relative position between the radome and the at least one receiving antenna can comprise positioning the at least one receiving antenna such that it comprises a distance from the radome equal to the second distance. This step can be performed prior to performing the second measurement and after performing the first measurement.

In preferred embodiments, while the radome is positioned at the first distance from the at least one receiving antenna the first distance can be smaller than the distance of the radome from the at least one transmitting antenna.

Similarly, while the radome is positioned at the second distance from the at least one receiving antenna the second distance can be smaller than the distance of the radome from the at least one transmitting antenna.

For example, a quotient of the ratio of the first distance over the distance between the at least one transmitting antenna and the at least one receiving antenna can be at most 0.4, preferably at most 0.2. Alternatively or additionally, the ratio can be at least 0.01, preferably at least 0.04. For example, the ratio can be at least 0.01 and at most 0.4, preferably at least 0.04 and at most 0.2. For example, the distance between the transmission antenna and the receiving antenna can be 250mm, and the distance between the radome and the receiving antenna can be 10 mm to 50 mm.

Generally, it can be advantageous for the distance between the radome and the receiving antenna to be smaller (preferably much smaller) than the half of the distance between the transmitting antenna and the receiving antenna. In other words, it can be advantageous to provide the radome closer to the receiving antenna(s) than to the transmitting antenna(s). As an initial matter, the reflections between the receiving antenna and the radome, can be received with a higher amplitude at the receiving antenna. As such, measuring a reflection property of the radome can be facilitated. Additionally, a small distance between the radome and the receiving antenna can increase the likelihood of the reflections created by the second side of the radome being received by the receiving antenna. Further still, the reflection created on the receiver side of the radome can be more easily separated from other reflections, as it follows the shortest path compared to other reflections.

Emitting the first electromagnetic wave can comprises emitting the first electromagnetic wave with a duration of at least $10\mu s$ and at most 100ms, preferably at least 1ms and at most 10ms. In other words, the first measurement can comprise a duration of at least $10\mu s$ and at most 100ms, preferably at least 1ms and at most 10ms. Thus, the first measurement can be performed fast, which can generally increase the time efficiency of the method.

Similarly, emitting the second electromagnetic wave can comprise emitting the second electromagnetic wave with a duration of at least $10\mu s$ and at most 100ms, preferably at least 1ms and at most 10ms. In other words, the second measurement can comprise a duration of at least $10\mu s$ and at most 100ms, preferably at least 1ms and at most 10ms. Thus, the second measurement can be performed fast, which can generally increase the time efficiency of the method.

Moreover, emitting the second electromagnetic wave can comprise emitting the second electromagnetic wave with the same wavelength as the first electromagnetic wave. This can be advantageous as the property of the radome may be frequency dependent. Hence, emitting the first and the second electromagnetic wave with the same wavelength can facilitate determining the property of the radome accurately.

In some embodiments, the method can comprise optionally emitting the second electromagnetic wave with the same phase as the first electromagnetic wave.

Receiving a portion of the first electromagnetic wave can comprise receiving a transmitted part of the first electromagnetic wave. Similarly, receiving a portion of the second electromagnetic wave comprises receiving a transmitted part of the second electromagnetic wave. The transmitted part of the first electromagnetic wave and the transmitted part of the second electromagnetic wave traverse through the radome before being received by the at least one receiving antenna. The transmitted part of an electromagnetic wave can refer to the part of the electromagnetic wave that is directly received by the receiving antenna(s) without being reflected. In other words, the transmitted part follows a shorter path than any other part of the electromagnetic wave received by the transmitting antenna.

Receiving a portion of the first electromagnetic wave can comprise receiving a reflected part of the first electromagnetic wave. Similarly, receiving a portion of the second electromagnetic wave can comprise receiving a reflected part of the second electromagnetic wave. The reflected part of the first electromagnetic wave and the reflected part of the second electromagnetic wave can be reflected by the radome before being received by the at least one receiving antenna. In such embodiments, the reflected part of an electromagnetic wave can refer to parts (i.e. copies) of the electromagnetic wave that are generated by the transmitting antenna, traverse though the radome, become incident on a surface of the receiving antenna (or a surface wherein the receiving antenna is mounted), can be reflected thereby towards the second side of the radome, become incident on the second side of the radome, can be reflected thereby before being received by the receiving antenna(s). It will be understood that there can be other reflections as well. However, such reflections can generally follow longer paths and can either be received with a very small (e.g. negligible) power and/or can be suppressed (e.g. using time-gating). For example, in embodiments wherein the radome can be positioned closer to the receiving antenna, the reflected part can refer to reflections following the shortest path (not to be confused with the transmitted part). In other words, the reflected part can refer to reflections created on the second side.

The reflected part of the first electromagnetic wave and the reflected part of the second electromagnetic wave can be reflected by the second side before being received by the at least one receiving antenna.

The reflected part of the first electromagnetic wave and the reflected part of the second electromagnetic wave can be reflected by a surface facing the second side before being reflected by the radome.

The reflected part of the first electromagnetic wave and the reflected part of the second electromagnetic wave can be reflected by the at least one receiving antenna before being reflected by the radome.

Receiving a portion of the first electromagnetic can comprise measuring an amplitude of the received portion of the first electromagnetic wave. Similarly, receiving a portion of the second electromagnetic can comprise measuring an amplitude of the received portion of the second electromagnetic wave. In some embodiments, measuring an amplitude can comprise measuring a complex amplitude. Measuring a complex amplitude can comprise determining a phasor representing the received portion. In some embodiments, measuring an amplitude can comprise measuring an absolute amplitude. For example, measuring an amplitude can comprise measuring an instantaneous amplitude, such as, measuring an instantaneous complex amplitude and/or an instantaneous absolute amplitude.

In some embodiments, the method can comprise determining the reflection property of the radome based on a difference between the amplitude of the received portion of the first electromagnetic wave and the amplitude of the received portion of the second electromagnetic wave. The amplitude can be an absolute amplitude (i.e. a number) or a complex amplitude (i.e. a phasor). As discussed, the transmitted parts can be received in phase, while the reflected parts can be received out of phase. As such, subtracting the received portions can yield a value indicating the amplitude of the reflected part (as the transmitted parts can be negated), which can then be used to determine the reflection property.

That is, the method can comprise calculating an amplitude of the reflected part of the first electromagnetic wave and/or an amplitude of the reflected part of the second electromagnetic wave based on a difference between the amplitude of the received portion of the first electromagnetic wave and the amplitude of the received portion of the second electromagnetic wave. Again, each amplitude can be a complex amplitude or an absolute amplitude.

Determining the reflection property of the radome based on the difference between the amplitude of the received portion of the first electromagnetic wave and the amplitude of the received portion of the second electromagnetic wave can comprise determining the reflection property based on at least one of the amplitude of the reflected part of the first electromagnetic wave and the amplitude of the reflected part of the second electromagnetic. Again, each amplitude can be a complex amplitude or an absolute amplitude.

Determining the reflection property of the radome can comprise determining a reflection coefficient of the radome. The reflection coefficient can be referred to as the reflectivity of the radome. Moreover, the reflection coefficient can correspond to the second side of the radome. As discussed, the second side can preferably be the reception side of the radome. However, it can also be the transmission side.

Determining a reflection coefficient of the radome can comprise determining a ratio of the amplitude of a reflection created by the second side when an electromagnetic wave is incident on the second side over the amplitude of the electromagnetic wave incident on the second side.

It will be understood that the above ratio is generally a constant depending on physical and/or chemical properties of the radome.

In some embodiments, the method can comprise determining the transmission property of the radome based on a sum of the amplitude of the received portion of the first electromagnetic wave and the amplitude of the received portion of the second electromagnetic wave. The amplitude can be an absolute amplitude (i.e. a number) or a complex amplitude (i.e. a phasor). As discussed, the transmitted parts can be received in phase, while the reflected parts can be received out of phase. As such, summing the received portions can yield a value indicating the amplitude of the transmitted part (as the reflected parts can be negated), which can then be used to determine the transmission property.

That is, the method can comprise calculating an amplitude of the transmitted part of the first electromagnetic wave and/or an amplitude of the transmitted part of the second electromagnetic wave based on a difference between the amplitude of the received portion of the first electromagnetic wave and the amplitude of the received portion of the second electromagnetic wave. Again, each amplitude can be a complex amplitude or an absolute amplitude.

Determining the transmission property of the radome based on a sum of the amplitude of the received portion of the first electromagnetic wave and the amplitude of the received portion of the second electromagnetic wave comprises determining the reflection property based on at least one of the amplitude of the transmitted part of the first electromagnetic wave and the amplitude of the transmitted part of the second electromagnetic. Again, each amplitude can be a complex amplitude or an absolute amplitude.

Determining the transmission property of the radome can comprise determining a transmission coefficient of the radome. The transmission coefficient can be referred to as the transmissivity of the radome. Moreover, the transmission coefficient can correspond to the first side of the radome. As discussed, the first side can preferably be the transmission side of the radome. However, it can also be the reception side.

Determining a transmission coefficient of the radome can comprise determining a ratio of the amplitude of an electromagnetic wave after traversing through the radome from the first side to the second side over the amplitude of the electromagnetic wave before traversing the radome and when it became incident on the first side.

It will be understood that the above ratio is generally a constant depending on physical and/or chemical properties of the radome.

In some embodiments, the method can comprise defining a target area of the radome. In such embodiments, the determined property can correspond to the target area of the radome. For example, the target area of the radome can be a part of the radome expected to intercept the electromagnetic waves generated and/or received by the radar that the radome can cover. For example, in a vehicle, the radars can be provided behind a bumper. That is, in some embodiments the radome may be a bumper of a vehicle. Generally, only a part of a bumper can intercept the electromagnetic waves generated and/or received by the radar that the bumper can cover. In such embodiments, the target area can be defined to be the part of the bumper expected to intercept the electromagnetic waves generated and/or received by the radar that the bumper can cover.

It will be understood, that in some embodiments the target area may include the entire radome. For example, this can typically be the case when the entire radome is expected to cover the radar and/or to intercept the electromagnetic waves generated and/or received by the radar. Typically, in such cases the radome may have a small surface, e.g., the radome can be an emblem of a car and/or a dedicated structure or product configured as a radome.

Defining a target area, on the one hand this can increase, inter alia, the time efficiency of the method, as only a part of the radome can be measured. On the other hand, the target area can be defined to comprise a part of the radome expected to intercept the electromagnetic waves generated and/or received by the radar that the radome can cover. This can increase the accuracy and usability of the determined property, e.g., to predict or estimate the effect that the radome can have on the radar that the radome can cover. It is noted, that simply measuring an arbitrary area of the radome, although it may comprise certain advantages, it may comprise limitations in predicting or estimating the effect that the radome can have on the radar that the radome can cover. This, for example, can be due to non-uniformities in the material and/or thickness of the radome. By measuring a target area of the radome (instead of an arbitrary area) can alleviate said issues.

The method can comprise defining a plurality of measurement cells within the target area. This can facilitate obtaining a more detailed and accurate information regarding the effect that the target area of the radome can have on the radar that the radome covers. More particularly, defining a plurality of measurement cells can facilitate determining a respective property of the target area. This can allow generating property maps indicating the property of multiple portions (i.e. measurement cells) within the target area.

Defining a plurality of measurement cells within the target area can comprise defining the measurement cells within the target area with a density of 5 to 10 measurement cells per centimeter square, such as, 8 measurement cells per centimeter square.

Furthermore, the measurement cells can be uniformly distributed on the target area.

For example, the measurement cells can be defined to form a grid within the target area.

Each of the measurement cells can comprise an area between 50 to 500 millimeter square, preferably 130 to 150 millimeter square, such as, 140 millimeter square.

In some embodiments, the method can comprise changing the relative position between the radome and the at least one transmitting antenna while maintaining the first distance between the radome and the at least one receiving antenna. That is, the radome can be moved within a plane comprising the first distance from the at least one receiving antenna. Alternatively or additionally, the at least one receiving antenna can be moved within a place comprising the first distance from the radome. This can allow changing the area of the radome that the electromagnetic waves emitted by the at least one transmitting can become incident on. For example, said motions may allow the emitted electromagnetic waves to become incident on different measurement cells, while the radome is positioned at the first distance from the at least one receiving antenna. Put differently, said motions may allow carrying out the first measurements for different measurement cells of the radome.

Similarly, changing the relative position between the radome and the at least one transmitting antenna while maintaining the second distance between the radome and the at least one receiving antenna.

Changing the relative position between the radome and the at least one transmitting antenna while maintaining the first distance between the radome and the at least one receiving antenna comprises a first set of sub-motions.

Similarly, changing the relative position between the radome and the at least one transmitting antenna while maintaining the second distance between the radome and the at least one receiving antenna can comprise a second set of sub-motions.

The method can comprise performing the second set of sub-motions after performing the first set of sub-motions. More particularly, the first set of sub-motions can be carried out while performing the first measurement(s) and the second set of sub-motions can be carried out while performing the second measurement(s).

The method can comprise before performing the second set of sub-motions, restoring the relative position between the radome and the at least one transmitting antenna to the relative position before performing the first set of sub-motions. This can allow for the first set of sub-motions and the second set of sub-motions to follow the same path. As such, for example, for each measurement cell, the first measurement and the second measurement can be performed.

The method can comprise before performing the second set of sub-motions, changing the distance between the radome and the at least one receiving antenna to the second distance. Thus, during the first set of sub-motions the radome can be at the first distance from the at least one receiving antenna and during the second set of sub-motions the radome can be at the second distance from the at least one receiving antenna

The first set of sub-motions and the second set of sub-motions can be identical. Again, this can allow the first set of sub-motions and the second set of sub-motions to follow identical paths. For example, for each element in the first set of sub-motions, there can be an element in the second set of sub-motions, such that, after performing the said sub-motions the radome and the antennas can be positioned such that the boresight of the antennas intercept the same measurement cell.

After each sub-motion of the first set of sub-motions the method can comprise the at least one transmitting antenna emitting the first electromagnetic wave and the at least one receiving antenna receiving a portion of the first electromagnetic wave. In other words, the method can comprise repeating the first measurement after each sub-motion.

Similarly, after each sub-motion of the second set of sub-motions the method can comprise the at least one transmitting antenna emitting the second electromagnetic wave and the at least one receiving antenna receiving a portion of the second electromagnetic wave. In other words, the method can comprise repeating the second measurement after each sub-motion.

The first electromagnetic wave emitted after each sub-motion of the first set of sub-motions can become incident on a respective measurement cell. As discussed, this can allow each measurement cell to be measured while the radome is positioned at a first distance from the at least one receiving antenna.

The second electromagnetic wave emitted after each sub-motion of the second set of sub-motions can become incident on a respective measurement cell. Similarly, this can allow each measurement cell to be measured while the radome is positioned at a second distance from the at least one receiving antenna.

Each measurement celli can be traversed at least once by the first electromagnetic wave and at least once by the second electromagnetic wave.

Determining the property of the radome can comprises determining the property of the radome for each measurement cell.

In some embodiments, emitting the first electromagnetic wave can comprise emitting the first electromagnetic wave with a frequency of at least 20 GHz and at most 160 GHz, preferably, at least 70 GHz and at most 90 GHz. This can be particularly advantageous for determining a property of radomes used in the automotive industry, e.g., car bumpers and emblems, wherein the radars typically operate in the said ranges of frequency.

In addition, the second electromagnetic wave can similarly be emitted with a frequency of at least 20 GHz and at most 160 GHz, preferably, at least 70 GHz and at most 90 GHz.

The at least one transmitting antenna emitting a first electromagnetic wave can comprise emitting the first electromagnetic wave such that an incidence angle of the first electromagnetic wave on the first side is at least 80° and at most 100°, preferably 90°. This can be particularly advantageous as it can allow the reflection part of the received portion (discussed above) to be received by the receiving antenna(s) and to not be reflected away from the receiving antenna(s).

Similarly, emitting the second electromagnetic wave can comprise emitting the second electromagnetic wave such that an incidence angle of the second electromagnetic wave on the first side is at least 80° and at most 100°, preferably 90°.

Determining the property of the radome based on the received portion of the first electromagnetic wave and the received portion of the second electromagnetic wave can be performed by a measuring device.

The method can further comprise connecting the measuring device to the at least transmitting antenna and to the at least one receiving antenna by a respective connector.

The connector(s) can comprise electrical conductors and/or waveguides.

Further, the method can comprise utilizing at least one frequency converter. For example, the method can comprise utilizing at least one frequency up-converter which can be provided operatively connected between the measuring device and the at least one transmitting antenna. The frequency up-converted can translate a signal generated by the measuring device to a higher frequency band before providing it to the at least one transmitting antenna. As such, the transmitting antenna(s) can operate at a higher frequency (e.g. radio frequency), while the measuring device can operate at a lower frequency (e.g. intermediate frequency).

Similarly, the method can comprise utilizing at least one frequency down-converter between which can be provided operatively connected between the measuring device and the at least one receiving antenna. The frequency down-converted can translate a signal received from the at least one receiving antenna to a lower frequency band before providing it to the measuring device.

The method can further comprise utilizing a transmitter mount and a receiver mount for supporting the at least one transmitting antenna and the at least one receiving antenna, respectively. In such embodiments, the method can comprise mounting the at least one transmitting antenna on the transmitter mount and mounting the at least one receiving antenna (10R) on the receiver mount.

The method can further comprise utilizing a clamp structure for supporting the at least one transmitting antenna and the at least one receiving antenna. The clamp structure can comprise a transmitter mount of the clamp, a receiver mount of the clamp and a base frame. Moreover, the transmitter mount of the clamp and the receiver mount of the clamp can extend from the same side of the base frame. That is, the transmitter mount of the clamp and receiver mount of the clamp can be attached such that a substantially U-shaped structure of the clamp can be created. The clamp structure can provide support for the at least one transmission antenna and the at least one receiving antenna and can facilitate positioning the at least one transmission antenna and the at least one receiving antenna facing each-other. Additionally, the clamp structure, particularly the base frame, can facilitate keeping the distance (and in general the relative position) between the at least one transmission antenna and the at least one receiving antenna constant. Moreover, the clamp structure can be advantageous as it can allow moving the at least one transmission antenna and at least one receiving, without changing the relative position between them. Thus, the antennas can be transported without changing the alignment between them.

In such embodiments, the method can comprise mounting the at least one transmitting antenna on the transmitter mount of the clamp and mounting the at least one receiving antenna on the receiver mount of the clamp.

The method can comprise utilizing a positioning apparatus to move the at least one transmitting antenna and the at least one receiving antenna relative to the radome.

In some embodiments, the clamp structure can be attached to the positioning apparatus and the method can comprise the positioning apparatus moving the clamp structure to move the at least one transmitting antenna and the at least one receiving antenna relative to the radome. In other words, in some embodiments, the method can comprise utilizing the positioning apparatus to move the clamp structure, thus, changing the relative position between the radome and the at least one receiving antenna. The positioning apparatus and the clamp structure can be configured to be releasably attached to each other.

For example, the positioning apparatus can be a robotic arm.

In some embodiments, the method can comprise utilizing a radome handling apparatus to move the radome relative to the at least one transmitting antenna and to the at least one receiving antenna. The radome handling apparatus can be configured to grab and move the radome.

A distance between the at least one transmitting antenna and the at least one receiving antenna can be at least 10 cm and at most 1 m, such as, 25 cm. For example, the length of the base frame of the clamp structure can be at least 10 cm and at most 1 m, such as, 25 cm.

In some embodiments, the method can comprise providing reference data. The reference data can indicate the effect that the environment (without the radome) can have on the first and second electromagnetic wave. Thus, the effect of the environment can be compensated for. This can increase the accuracy of determining the property of the radome.

The reference data can comprise path loss reference data that can indicate an attenuation caused by the environment between the at least one transmitting antenna and the at least one receiving antenna without the radome. The path loss reference data can comprise a path loss model, a path loss coefficient and/or a path loss exponent.

The path loss reference data can be determined analytically and/or empirically.

In some embodiments, the method can comprise measuring the path loss reference data. The path loss reference data can be measured periodically. For example, the path loss reference data can be measured hourly, daily, weekly, monthly, etc. In some embodiments, the path loss reference data can be measured before providing the radome between the at least one transmitting antenna and the at least one receiving antenna.

Measuring the path loss reference data can comprise while no radome is present between the at least one transmitting antenna and the at least one receiving antenna, the at least one transmitting antenna emitting a first reference electromagnetic signal and the at least one receiving antenna receiving the first reference electromagnetic signal. In addition, the method can comprise determining the path loss reference data based on a difference between the first reference electromagnetic signal as emitted by the at least one transmitting antenna and the first reference electromagnetic signal as received by the at least one receiving antennal. For example, the transmitted amplitude can be compared with the received amplitude of the first reference electromagnetic signal to determine an attenuation of the path between the antennas without the radome.

In some embodiments, the method can comprise measuring the path loss reference data prior to emitting the first electromagnetic signal. In other words, the method can comprise measuring the path loss reference data prior to measuring each radome. This can be advantageous as it can increase the accuracy of determining the property. More particularly, the path loss reference data may vary due to changes in temperature, humidity and/or content of the air (e.g. presence of dust particles). Thus, the path loss reference data may become outdated frequently. Measuring the path loss reference data prior to emitting the first electromagnetic signal can increase the likelihood of the path loss reference data better indicating the effect of the environment (without the radome) on the electromagnetic waves.

In some embodiments, the reference data can comprise reflection reference data.

The reflection reference data can comprise a function that can receive as an input the amplitude of the reflected part of the first electromagnetic wave and/or the amplitude of the reflected part of the second electromagnetic wave and can output the reflection property of the radome.

The reflection reference data can comprise a reflectivity of the at least one receiving antenna and/or the reflectivity of a surface facing the second side. For example, the reflection reference data can comprise the reflectivity of the at least one receiving antenna and the reflectivity of a surface wherein the at least one receiving antenna is mounted, such as, a reflectivity of the receiver mount and/or the reflectivity of the receiver mount of the clamp.

In some embodiments, the method can comprise determining the reflection reference data.

Determining the reflection reference data can comprise while a sample with known properties, instead of the radome, is present between the at least one transmitting antenna and the at least one receiving antenna, the at least one transmitting antenna emitting a second reference electromagnetic signal and the at least one receiving antenna receiving the second reference electromagnetic signal. Moreover, the method can comprise determining the path loss reference data based on a difference between the second reference electromagnetic signal as emitted by the at least one transmitting antenna and the second reference electromagnetic signal as received by the at least one receiving antenna.

For example, a sample with a reflection loss of 10dB can be provided. During the reference measurement to determine the reflection reference data the reflection loss of the sample can be measured to be 11dB (instead of 10dB). In this example, the reflection reference data can comprise an offset of + 1dB. Then, when determining a reflection property of the radome, the offset of + 1dB can be utilized to compensate for the effect of the environment.

In some embodiments, the first side can be a transmission side of the radome and the second side can be a reception side of the radome. In such embodiments, determining a transmission property can comprise determining a transmission coefficient of the transmission side of the radome. The transmission coefficient of the transmission side of the radome may be referred to as the forward gain or as the first transmission coefficient. Furthermore, determining a reflection property can comprise determining a reflection coefficient of the reception side of the radome. The reflection coefficient of the reception side of the radome may be referred to as the output port reflection coefficient or as the second reflection coefficient.

The method can similarly be carried out if the radome is rotated 180° with respect to the preceding embodiment. That is, in some embodiments, the first side can be a reception side of the radome and the second side can be a transmission side of the radome. In such embodiments, determining a transmission property can comprise determining a transmission coefficient of the reception side of the radome. The transmission coefficient of the reception side of the radome may be referred to as the reverse gain or as the second transmission coefficient. Similarly, determining a reflection property can comprise determining a reflection coefficient of the transmission side of the radome. The reflection coefficient of the transmission side of the radome may be referred to as the input port reflection coefficient or as the first reflection coefficient.

The method can be a computer-implemented method. That is, the method can comprise computer instructions which can be executed by a data processing device. This can allow the data processing device to determine the property of the radome. Alternatively or additionally, the data processing device can execute the computer instructions to control the at least one receiving antenna and/or the at least one transmitting antenna and/or the at least one positioning apparatus and/or the at least one radome handing apparatus.

The data processing device can comprise the measuring device.

The present invention also discloses a system for measuring a property of a radome. The system comprises at least one transmitting antenna facing a first side of the radome and at least one receiving antenna facing a second side of the radome, wherein the first side is opposite to the second side. In addition, the system comprises a positioning system configured to change a relative position between the radome and the at least one receiving antenna.

Furthermore, while the radome is positioned at a first distance from the at least one receiving antenna, the at least one transmitting antenna is configured to emit a first electromagnetic wave and the at least one receiving antenna is configured to receive a portion of the first electromagnetic wave.

In addition, while the radome is positioned at a second distance from the at least one receiving antenna, the at least one transmitting antenna is configured to emit a second electromagnetic wave and the at least one receiving antenna is configured to receive a portion of the second electromagnetic wave.

It will be understood that the system and the method discussed above can comprise corresponding features. In other words, features and advantages discussed above with respect to the method can also be valid for the data processing system. For the sake of brevity, they may not be repeated in the following.

The system can further comprise a data processing device configured to determine the property of the radome based on the received portion of the first electromagnetic wave and the received portion of the second electromagnetic wave.

The at least one transmission antenna can be configured to emit electromagnetic waves with a frequency of at least 20 GHz and at most 160 GHz, preferably, at least 70 GHz and at most 90 GHz.

The at least one receiving antenna can be configured to receive electromagnetic waves with a frequency of at least 20 GHz and at most 160 GHz, preferably, at least 70 GHz and at most 90 GHz.

The at least one transmitting antenna and the radome can be configured such that the boresight of the at least one transmitting antenna is perpendicular to the radome.

The system can further comprise a measuring device.

The measuring device can be connected to the at least transmission antenna and to the at least one receiving antenna by a respective connector.

The system can further comprise at least one frequency converter. In some embodiments, the system can comprise at least one frequency up-converter and wherein the measuring device can be connected to the at least one transmission antenna through the frequency up-converter and wherein the frequency up-converter can be configured to translate a signal from the measuring device to a higher frequency band before providing it to the at least one transmission antenna. Alternatively or additionally, the system can comprise at least one frequency down-converter and wherein the measuring device can be connected to the at least one receiving antenna through the frequency down-converter and wherein the frequency down-converter can be configured to translate the signal received from the at least one receiving antenna to a lower frequency band before providing it to the measuring device.

In some embodiments, the system can comprise a transmitter mount configured for mounting therein at least one transmitting antenna and a receiver mount configured for mounting therein at least one receiving antenna.

In preferred embodiments, the system can comprise a clamp structure, wherein the clamp structure can comprise a transmitter mount of the clamp configured for mounting therein at least one transmission antenna, a receiver mount of the clamp configured for mounting therein at least one receiver antenna and a base frame. The transmitter mount of the clamp and the receiver mount of the clamp can extend from the same side of the base frame.

In some embodiments, the clamp structure can be formed as a single part - i.e. without mounting or assembling or attaching smaller parts together.

Alternatively, in some embodiments the clamp structure can comprise several parts that can be assembled together to form the clamp structure.

The positioning system can comprise at least one positioning apparatus, said positioning apparatus configured to move the at least one transmission antenna and the at least one receiving antenna.

For example, the clamp structure can be attached to the positioning apparatus and the positioning apparatus can be configured to move the clamp structure.

The positioning apparatus can be a robotic arm. The robotic arm can comprise a robotic arm base configured to support the robotic arm and a first prolonged member attached on one of its ends with the robotic arm base and on the other end with a second prolonged member. The second prolonged member can be configured to support the at least one transmission antenna and the at least one receiving antenna and/or respective mounting structures of the at least one transmission antenna and the at least one receiving antenna.

The robotic arm can be configured to allow at least one of a relative motion between the robotic arm base and first prolonged member and a relative motion between the first prolonged member and second prolonged member.

A joint between the clamp structure and the positioning apparatus can be configured to provide rotation of the clamp structure.

Alternatively or additionally, the positioning system can comprise a radome handling apparatus to move the radome.

The distance between the at least one transmitting antenna and the at least one receiving antenna can be at least 10 cm and at most 1 m, such as, 25 cm.

The at least one transmission antenna and the at least one receiving antenna can be configured as transceiver antennas.

The system can comprise 1 to 100 transmission antennas and 1 to 100 receiving antennas.

The positioning system can comprise a first robotic arm configured to support and handle at least one transmission antenna and a second robotic arm configured to support and handle at least one receiving antenna.

The at least one transmission antenna and the at least one receiving antenna can be aligned, such that, the main lobe of the at least one transmission antenna and the main lobe of the at least one receiving antenna intersect.

The data processing device can be configured to control the positioning system.

The data processing device can be configured to control the at least one transmitting antenna and the at least one receiving antenna.

In some embodiments, the data processing device can comprise the measuring device.

The system can be configured to carry out the method according to any of the preceding method embodiments.

The system can be configured to carry out the method according to any of the preceding method embodiments to determine the property of the radome.

In a further aspect the present invention relates to a use of the system according to any of the preceding system embodiments and/or the method according to any of the preceding method embodiments to measure the effects of a radar cover on electromagnetic waves traversing through the radar cover and wherein the radar cover is intended for covering at least one radar.

In the preceding use embodiment, the radar cover can be a radome.

In a further aspect, the present invention relates to a use of the system according to any of the preceding system embodiments and/or the method according to any of the preceding method embodiments to measure the effects of a radar cover on electromagnetic waves traversing through the radar cover and wherein the radar cover is intended for covering at least one radar used in a vehicle. Moreover, the radar cover can be a bumper and/or an emblem of the vehicle.

In a further aspect, the present invention relates to a use of the system according to any of the preceding system embodiments and/or the method according to any of the preceding method embodiments during the development and/or production and/or manufacturing of a radar cover or system comprising the radar cover.

In a further aspect, the present invention relates to a use of the system according to any of the preceding system embodiments and/or the method according to any of the preceding method embodiments during the development and/or production and/or manufacturing of a vehicle.

In a further aspect the present invention relates to a production system comprising the system according to any of the preceding system embodiments.

The production system can be configured to produce radomes and test at least one of the produced radomes using the system according to any of the preceding system embodiments.

The production system can be configured to manufacture vehicles, wherein at least one of the vehicles can comprises a radar cover to test the radar cover using the system according to any of the preceding system embodiments.

The present technology is also defined by the following numbered embodiments.

Below, method embodiments will be discussed. These embodiments are abbreviated by the letter "M" followed by a number. When reference is herein made to method embodiments, these embodiments are meant.

M1. A method of measuring a property of a radome (15), the method comprising

utilizing at least one transmitting antenna (10T) facing a first side (152) of the radome (15) and utilizing at least one receiving antenna (10R) facing a second side (154) of the radome (15), wherein the first side (152) is opposite to the second side (154);

while the radome (15) is positioned at a first distance from the at least one receiving antenna (10R), the at least one transmitting antenna (10T) emitting a first electromagnetic wave and the at least one receiving antenna (10R) receiving a portion of the first electromagnetic wave;

while the radome (15) is positioned at a second distance from the at least one receiving antenna (10R), the at least one transmitting antenna (10T) emitting a second electromagnetic wave and the at least one receiving antenna (10R) receiving a portion of the second electromagnetic wave;

determining the property of the radome (15) based on the received portion of the first electromagnetic wave and the received portion of the second electromagnetic wave.

M2. The method according to the preceding embodiment, wherein the first and the second electromagnetic waves are emitted with a same wavelength.

M3. The method according to any of the preceding embodiments, wherein the method is a computer implemented method.

M4. The method according to any of the preceding embodiments, wherein a difference between the first distance and the second distance depends on the wavelength of the first electromagnetic wave and the wavelength of the second electromagnetic wave.

M5. The method according to any of the preceding embodiments and with the features of embodiment M2, wherein the difference between the first distance and the second distance is equal to a quarter of the wavelength of the first and second electromagnetic waves multiplied by an odd integer.

M6. The method according to any of the preceding embodiments and with the features of embodiment M2, wherein the difference between the first distance and the second distance is equal to a quarter of the wavelength of the first and second electromagnetic waves.

M7. The method according to any of the preceding embodiments, wherein determining the property of the radome (15) comprises

determining a reflection property of the radome (15) based on a difference between the received portion of the first electromagnetic wave and the received portion of the second electromagnetic wave.

M8. The method according to any of the preceding embodiments, wherein determining the property of the radome (15) comprises

determining a transmission property of the radome (15) based on a sum between the received portion of the first electromagnetic wave and the received portion of the second electromagnetic wave.

M9. The method according to any of the preceding embodiments, wherein the method comprises changing a relative position between the radome (15) and the at least one receiving antenna (10R).

M10. The method according to the preceding embodiment, wherein changing a relative position between the radome (15) and the at least one receiving antenna (10R) comprises

changing a distance between the radome (15) and the at least one receiving antenna (10R).

M11. The method according to the preceding embodiment, wherein changing a distance between the radome (15) and the at least one receiving antenna (10R) comprises

changing the distance from the first distance to the second distance.

M12. The method according to any of 2 the preceding embodiments, wherein changing a distance between the radome (15) and the at least one receiving antenna (10R) comprises

changing the distance by a quarter of the wavelength of the first and second electromagnetic waves multiplied by an odd integer.

M13. The method according to any of the 4 preceding embodiments, wherein changing a relative position between the radome (15) and the at least one receiving antenna (10R) comprises at least one of

moving the radome (15) and
moving the at least one receiving antenna (10R).

M14. The method according to any of the 5 preceding embodiments, wherein changing a relative position between the radome (15) and the at least one receiving antenna (10R) comprises at least one of

positioning the radome (15) such that the first side (152) faces the at least one transmitting antenna (10T) and the second side (154) faces the at least one receiving antenna (10R) and
positioning the at least one transmitting antenna (10T) such that it faces the first side (152) and the at least one receiving antenna (10R) such that it faces the second side (154).

M15. The method according to any of the 6 preceding embodiments, wherein changing a relative position between the radome (15) and the at least one receiving antenna (10R) comprises at least one of

positioning the radome (15) such that it comprises a distance from the at least one receiving antenna (10R) equal to the first distance and
positioning the at least one receiving antenna (10R) such that it comprises a distance from the radome (15) equal to the first distance.

M16. The method according to any of the 7 preceding embodiments, wherein changing a relative position between the radome (15) and the at least one receiving antenna (10R) comprises at least one of

positioning the radome (15) such that it comprises a distance from the at least one receiving antenna (10R) equal to the second distance and
positioning the at least one receiving antenna (10R) such that it comprises a distance from the radome (15) equal to the second distance.

M17. The method according to any of the preceding embodiments, wherein

while the radome (15) is positioned at the first distance from the at least one receiving antenna (10R) the first distance is smaller than the distance of the radome (15) from the at least one transmitting antenna (10T) and
while the radome (15) is positioned at the second distance from the at least one receiving antenna (10R) the second distance is smaller than the distance of the radome from the at least one transmitting antenna (10T).

M 18. The method according to the preceding embodiment, wherein a quotient of the ratio of the first distance over the distance between the at least one transmitting antenna (10T) and the at least one receiving antenna (10R) is

at most 0.4, preferably at most 0.2 and
at least 0.01, preferably at least 0.04.

M19. The method according to any of the preceding embodiments, wherein the at least one transmitting antenna (10T) emitting the first electromagnetic wave comprises
emitting the first electromagnetic wave with a duration of at least 10µs and at most 100ms, preferably at least 1ms and at most 10ms.
M20. The method according to any of the preceding embodiments, wherein the at least one transmitting antenna (10T) emitting the second electromagnetic wave comprises
emitting the second electromagnetic wave with a duration of at least 10µs and at most 100ms, preferably at least 1ms and at most 10ms.
M21. The method according to any of the preceding embodiments, wherein the at least one transmitting antenna (10T) emitting the second electromagnetic wave comprises
emitting the second electromagnetic wave with the same wavelength as the first electromagnetic wave.
M22. The method according to any of the preceding embodiments, wherein the at least one transmitting antenna (10T) emitting the second electromagnetic wave comprises
emitting the second electromagnetic wave with the same phase as the first electromagnetic wave.
M23. The method according to any of the preceding embodiments, wherein

the at least one receiving antenna (10R) receiving a portion of the first electromagnetic wave comprises receiving a transmitted part of the first electromagnetic wave and
the at least one receiving antenna (10R) receiving a portion of the second electromagnetic wave comprises receiving a transmitted part of the second electromagnetic wave and

wherein the transmitted part of the first electromagnetic wave and the transmitted part of the second electromagnetic wave traverse through the radome (15) before being received by the at least one receiving antenna (10R).

M24. The method according to any of the preceding embodiments, wherein

the at least one receiving antenna (10R) receiving a portion of the first electromagnetic wave comprises receiving a reflected part of the first electromagnetic wave and
the at least one receiving antenna (10R) receiving a portion of the second electromagnetic wave comprises receiving a reflected part of the second electromagnetic wave and

wherein the reflected part of the first electromagnetic wave and the reflected part of the second electromagnetic wave are reflected by the radome (15) before being received by the at least one receiving antenna (10R).

M25. The method according to the preceding embodiment, wherein the reflected part of the first electromagnetic wave and the reflected part of the second electromagnetic wave are reflected by the second side (154) before being received by the at least one receiving antenna (10R).

M26. The method according to any of the 2 preceding embodiments, wherein the reflected part of the first electromagnetic wave and the reflected part of the second electromagnetic wave are reflected by a surface facing the second side (154) before being reflected by the radome (15).

M27. The method according to any of the 3 preceding embodiments, wherein the reflected part of the first electromagnetic wave and the reflected part of the second electromagnetic wave are reflected by the at least one receiving antenna (10R) before being reflected by the radome (15).

M28. The method according to any of the preceding embodiments, wherein the at least one receiving antenna (10R) receiving a portion of the first electromagnetic comprises measuring an amplitude of the received portion of the first electromagnetic wave and

the at least one receiving antenna (10R) receiving a portion of the second electromagnetic comprises measuring an amplitude of the received portion of the second electromagnetic wave.

M29. The method according to the preceding embodiment and with the features of embodiment M7, wherein the method comprises

determining the reflection property of the radome (15) based on a difference between the amplitude of the received portion of the first electromagnetic wave and the amplitude of the received portion of the second electromagnetic wave.

M30. The method according to any of the 2 preceding embodiments and with the features of embodiment M24, wherein the method comprises

calculating an amplitude of the reflected part of the first electromagnetic wave and/or an amplitude of the reflected part of the second electromagnetic wave
based on a difference between the amplitude of the received portion of the first electromagnetic wave and the amplitude of the received portion of the second electromagnetic wave.

M31. The method according to the two preceding embodiments, wherein determining the reflection property of the radome (15) based on a difference between the amplitude of the received portion of the first electromagnetic wave and the amplitude of the received portion of the second electromagnetic wave comprises determining the reflection property based on at least one of

the amplitude of the reflected part of the first electromagnetic wave and
the amplitude of the reflected part of the second electromagnetic.

M32. The method according to any of the preceding embodiments and with the features of embodiment M7, wherein determining the reflection property of the radome (15) comprises determining a reflection coefficient of the radome (15).

M33. The method according to the preceding embodiment, wherein determining a reflection coefficient of the radome (15) comprises determining a ratio of

the amplitude of a reflection created by the second side (154) when an electromagnetic wave is incident on the second side (154) over
the amplitude of the electromagnetic wave incident on the second side (154).

It will be understood that the above ratio is generally a constant depending on physical and/or chemical properties of the radome.

M34. The method according to any of the preceding embodiments and with the features of embodiments M8 and M28, wherein the method comprises

determining the transmission property of the radome (15) based on a sum of the amplitude of the received portion of the first electromagnetic wave and the amplitude of the received portion of the second electromagnetic wave.

M35. The method according to any of the preceding embodiments and with the features of embodiment M23 and M28, wherein the method comprises

calculating an amplitude of the transmitted part of the first electromagnetic wave and/or an amplitude of the transmitted part of the second electromagnetic wave

based on a difference between the amplitude of the received portion of the first electromagnetic wave and the amplitude of the received portion of the second electromagnetic wave.

M36. The method according to the two preceding embodiments, wherein determining the transmission property of the radome (15) based on a sum of the amplitude of the received portion of the first electromagnetic wave and the amplitude of the received portion of the second electromagnetic wave comprises determining the reflection property based on at least one of

the amplitude of the transmitted part of the first electromagnetic wave and
the amplitude of the transmitted part of the second electromagnetic.

M37. The method according to any of the preceding embodiments and with the features of embodiment M8, wherein determining the transmission property of the radome (15) comprises determining a transmission coefficient of the radome (15).

M38. The method according to the preceding embodiment, wherein determining a transmission coefficient of the radome (15) comprises determining a ratio of

the amplitude of an electromagnetic wave after traversing through the radome (15) from the first side (152) to the second side (154) over the amplitude of the electromagnetic wave before traversing the radome (15) and when it became incident on the first side (152).

It will be understood that the above ratio is generally a constant depending on physical and/or chemical properties of the radome.

M39. The method according to any of the preceding embodiments, wherein the method comprises defining a target area (56) of the radome (15).

M40. The method according to the preceding embodiment, wherein the method comprises defining a plurality of measurement cells (54) within the target area (56).

M41. The method according to the preceding embodiment, wherein defining a plurality of measurement cells (54) within the target area (56) comprises

defining the measurement cells (54) within the target area (56) with a density of 5 to 10 measurement cells (54) per centimeter square, such as, 8 measurement cells (54) per centimeter square.

M42. The method according to any of the 2 preceding embodiments, wherein the measurement cells (54) are uniformly distributed on the target area (56).

M43. The method according to any of the 3 preceding embodiments, wherein each of the measurement cells (54) comprises an area between 50 to 500 millimeter square, preferably 130 to 150 millimeter square, such as, 140 millimeter square.

M44. The method according to any of the preceding embodiments, wherein the method comprises

changing the relative position between the radome (15) and the at least one transmitting antenna (10T) while maintaining the first distance between the radome (15) and the at least one receiving antenna (10R) and
changing the relative position between the radome (15) and the at least one transmitting antenna (10T) while maintaining the second distance between the radome (15) and the at least one receiving antenna (10R).

M45. The method according to the preceding embodiment, wherein

changing the relative position between the radome (15) and the at least one transmitting antenna (10T) while maintaining the first distance between the radome (15) and the at least one receiving antenna (10R) comprises a first set of sub-motions and
changing the relative position between the radome (15) and the at least one transmitting antenna (10T) while maintaining the second distance between the radome (15) and the at least one receiving antenna (10R) comprises a second set of sub-motions.

M46. The method according to the preceding embodiment, wherein the method comprises performing the second set of sub-motions after performing the first set of sub-motions.

M47. The method according to the preceding embodiment, wherein the method comprises before performing the second set of sub-motions, restoring the relative position between the radome (15) and the at least one transmitting antenna (10T) to the relative position before performing the first set of sub-motions.

M48. The method according to any of the 2 preceding embodiments, wherein the method comprises before performing the second set of sub-motions, changing the distance between the radome and the at least one receiving antenna (10R) from the first distance to the second distance.

M49. The method according to any of the 4 preceding embodiments, wherein the first set of sub-motions and the second set of sub-motions are identical.

M50. The method according to any of the 5 preceding embodiments, wherein

after each sub-motion of the first set of sub-motions the method comprises the at least one transmitting antenna (10T) emitting the first electromagnetic wave and the at least one receiving antenna (10R) receiving a portion of the first electromagnetic wave and

after each sub-motion of the second set of sub-motions the method comprises the at least one transmitting antenna (10T) emitting the second electromagnetic wave and the at least one receiving antenna (10R) receiving a portion of the second electromagnetic wave.

M51. The method according to the preceding embodiment and with the features of embodiment M40, wherein

the first electromagnetic wave emitted after each sub-motion of the first set of sub-motions becomes incident on a respective measurement cell (54) and

the second electromagnetic wave emitted after each sub-motion of the second set of sub-motions becomes incident on a respective measurement cell (54).

M52. The method according to the preceding embodiment, wherein each measurement cell (54) is traversed at least once by the first electromagnetic wave and at least once by the second electromagnetic wave.

M53. The method according to the preceding embodiment, wherein determining the property of the radome (15) comprises determining the property of the radome (15) for each measurement cell (54).

M54. The method according to any of the preceding embodiments, wherein the at least one transmitting antenna (10T) emitting a first electromagnetic wave comprises emitting the first electromagnetic wave with a frequency of at least 20 GHz and at most 160 GHz, preferably, at least 70 GHz and at most 90 GHz.

M55. The method according to any of the preceding embodiments, wherein the at least one transmitting antenna (10T) emitting a first electromagnetic wave comprises emitting the first electromagnetic wave such that an incidence angle of the first electromagnetic wave on the first side (152) is at least 80° and at most 100°, preferably 90°.

M56. The method according to any of the preceding embodiments, wherein determining the property of the radome (15) based on the received portion of the first electromagnetic wave and the received portion of the second electromagnetic wave is performed by a measuring device (14).

M57. The method according to the preceding embodiment, wherein the method comprises connecting the measuring device (14) to the at least transmitting antenna (10T) and to the at least one receiving antenna (10R) by a respective connector (142), and wherein the connector (142) comprise electrical conductors and/or waveguides.

M58. The method according to any of the 2 preceding embodiments, wherein the method comprises utilizing at least one frequency converter, such as,

at least one frequency up-converter between the measuring device (14) and the at least one transmitting antenna (10T), for translating a signal generated by the measuring device (14) to a higher frequency band before providing it to the at least one transmitting antenna (10T) and

at least one frequency down-converter between the measuring device (14) and the at least one receiving antenna (10R), configured to translate a signal received from the at least one receiving antenna (10R) to a lower frequency band before providing it to the measuring device (14).

M59. The method according to any of the preceding embodiments, wherein the method comprises

utilizing a transmitter mount (11T) and a receiver mount (11R) for supporting the at least one transmitting antenna

(10T) and the at least one receiving antenna (10R),
mounting the at least one transmitting antenna (10T) on the transmitter mount (11T) and
mounting the at least one receiving antenna (10R) on the receiver mount (11R).

M60. The method according to any of the preceding embodiments, wherein the method comprises utilizing a clamp structure (20) for supporting the at least one transmitting antenna (10T) and the at least one receiving antenna (10R) wherein the clamp structure (20) comprises

a transmitter mount of the clamp (24T),
a receiver mount of the clamp (24R) and
a base frame (22) and

wherein the transmitter mount of the clamp (24T) and the receiver mount of the clamp (24R) extend from the same side of the base frame (22).

M61. The method according to the preceding embodiment, wherein the method comprises

mounting the at least one transmitting antenna (10T) on the transmitter mount of the clamp (24T) and
mounting the at least one receiving antenna (10T) on the receiver mount of the clamp (24R).

M62. The method according to any of the preceding embodiments, wherein the method comprises utilizing a positioning apparatus (30) to move the at least one transmitting antenna (10T) and the at least one receiving antenna (10R) relative to the radome (15).

M63. The method according to the 2 preceding embodiments, wherein the clamp structure (20) is attached to the positioning apparatus (30) and the method comprises

the positioning apparatus (30) moving the clamp structure (20) to move the at least one transmitting antenna (10T) and the at least one receiving antenna (10R) relative to the radome (15).

M64. The method according to any of the 3 preceding embodiments, wherein the positioning apparatus (30) is a robotic arm (30).

M65. The method according to any of the preceding embodiments, wherein the method comprises utilizing a radome handling apparatus (40) to move the radome (15) relative to the at least one transmitting antenna (10T) and to the at least one receiving antenna (10R).

M66. The method according to any of the preceding embodiments, wherein a distance between the at least one transmitting antenna (10T) and the at least one receiving antenna (10R) is at least 10 cm and at most 1 m, such as, 25 cm.

M67. The method according to any of the preceding embodiments, wherein the method comprises providing reference data.

M68. The method according to the preceding embodiment, wherein the reference data comprise path loss reference data that indicate an attenuation caused by the environment between the at least one transmitting antenna (10T) and the at least one receiving antenna (10R) without the radome (15).

M69. The method according to the preceding embodiment, wherein the method comprises measuring the path loss reference data.

M70. The method according to the preceding embodiment, wherein measuring the path loss reference data comprises

while no radome (15) is present between the at least one transmitting antenna (10T) and the at least one receiving antenna (10R), the at least one transmitting antenna (10T) emitting a first reference electromagnetic signal and the at least one receiving antenna (10R) receiving the first reference electromagnetic signal and
determining the path loss reference data based on a difference between the first reference electromagnetic signal as emitted by the at least one transmitting antenna (10T) and the first reference electromagnetic signal as received by the at least one receiving antenna (10R).

M71. The method according to any of the 2 preceding embodiments, wherein the method comprises measuring the path loss reference data prior to emitting the first electromagnetic signal.

M72. The method according to any of the 5 preceding embodiments, wherein the reference data comprise reflection reference data.

M73. The method according to the preceding embodiment and with the features of embodiment M30 and M8, wherein the reflection reference data comprise a function that
receives as an input the amplitude of the reflected part of the first electromagnetic wave and/or the amplitude of the reflected part of the second electromagnetic wave and outputs the reflection property of the radome (15).

M74. The method according to any of the 2 preceding embodiments, wherein the reflection reference data comprise a reflectivity of the at least one receiving antenna (10R) and/or the reflectivity of a surface facing the second side (154).

M75. The method according to any of the 3 preceding embodiments, wherein the method comprises determining the reflection reference data.

M76. The method according to the preceding embodiment, wherein determining the reflection reference data comprises

while a sample with known properties, instead of the radome (15), is present between the at least one transmitting antenna (10T) and the at least one receiving antenna (10R), the at least one transmitting antenna (10T) emitting a second reference electromagnetic signal and the at least one receiving antenna (10R) receiving the second reference electromagnetic signal and

determining the reflection reference data based on a difference between the second reference electromagnetic signal as emitted by the at least one transmitting antenna (10T) and the second reference electromagnetic signal as received by the at least one receiving antenna (10R).

M77. The method according to any of the preceding embodiments, wherein the first side (152) is a transmission side (132) of the radome (15) and the second side (154) is a reception side (134) of the radome (15).

M78. The method according to the preceding embodiment and with the features of embodiment M8, wherein determining a transmission property comprises

determining a transmission coefficient of the transmission side (134) of the radome (15).

The transmission coefficient of the transmission side of the radome may be referred to as the forward gain $S_{21}$ or as the first transmission coefficient T1.

M79. The method according to any of the 2 preceding embodiments and with the features of embodiment M7, wherein determining a reflection property comprises

determining a reflection coefficient of the reception side (134) of the radome (15).

The reflection coefficient of the reception side of the radome may be referred to as the output port reflection coefficient $S_{22}$ or as the second reflection coefficient R2.

M80. The method according to any of the preceding embodiments, wherein the first side (152) is a reception side (134) of the radome (15) and the second side (154) is a transmission side (132) of the radome (15).

M81. The method according to the preceding embodiment and with the features of embodiment M8, wherein determining a transmission property comprises

determining a transmission coefficient of the reception side (134) of the radome (15).

The transmission coefficient of the reception side of the radome may be referred to as the reverse gain $S_{12}$ or as the second transmission coefficient T2.

M82. The method according to any of the 2 preceding embodiments and with the features of embodiment M7, wherein determining a reflection property comprises

determining a reflection coefficient of the transmission side (132) of the radome (15).

The reflection coefficient of the transmission side of the radome may be referred to as the input port reflection coefficient $S_{11}$ or as the first reflection coefficient R1.

M83. The method according to any of the preceding embodiments and with the features of at least one of embodiments M28 to M31, M33 to M36 and M38

wherein the amplitude is an absolute amplitude.

M84. The method according to any of the preceding embodiments and with the features of at least one of embodiments M28 to M31, M33 to M36 and M38

wherein the amplitude is a complex amplitude.

M85. The method according to any of the preceding embodiments and with the features of embodiment M67, wherein the method comprises determining the property based on the reference data.

Below, system embodiments will be discussed. These embodiments are abbreviated by the letter "S" followed by a number. When reference is herein made to system embodiments, these embodiments are meant.

S1. A system for measuring a property of a radome (15), the system comprising

at least one transmitting antenna (10T) facing a first side (152) of the radome (15) and at least one receiving antenna (10R) facing a second side (154) of the radome (15), wherein the first side (152) is opposite to the second side (154);
a positioning system configured to change a relative position between the radome (15) and the at least one receiving antenna;
wherein

while the radome (15) is positioned at a first distance from the at least one receiving antenna (10R) the at least one transmitting antenna (10T) is configured to emit a first electromagnetic wave and the at least one receiving antenna (10R) is configured to receive a portion of the first electromagnetic wave;

while the radome (15) is positioned at a second distance from the at least one receiving antenna (10R), the at least one transmitting antenna (10T) is configured to emit a second electromagnetic wave and the at least one receiving antenna (10R) is configured to receive a portion of the second electromagnetic wave.

S2. The system according to the preceding embodiment, wherein the system further comprises

a data processing device configured to determine the property of the radome (15) based on the received portion of the first electromagnetic wave and the received portion of the second electromagnetic wave.

S3. The system according to any of the preceding system embodiments, wherein the at least one transmission antenna (10T) is configured to emit electromagnetic waves with a frequency of at least 20 GHz and at most 160 GHz, preferably, at least 70 GHz and at most 90 GHz.

S4. The system according to any of the preceding system embodiments, wherein the at least one receiving antenna (10T) is configured to receive electromagnetic waves with a frequency of at least 20 GHz and at most 160 GHz, preferably, at least 70 GHz and at most 90 GHz.

S5. The system according to any of the preceding system embodiments, wherein the at least one transmitting antenna (10T) and the radome (15) are configured, such that, the boresight of the at least one transmitting antenna (10T) is perpendicular to the radome (15).

S6. The system according to any of the preceding system embodiments, wherein the system further comprises a measuring device (14).

S7. The system according to the preceding system embodiment, wherein the measuring device (14) is connected to the at least transmission antenna (10T) and to the at least one receiving antenna (10R) by a respective connector (142).

S8. The system according to the preceding system embodiment, wherein the system comprises at least one frequency converter, such as:

at least one frequency up-converter and wherein the measuring device (14) is connected to the at least one transmission antenna (10T) through the frequency up-converter and wherein the frequency up-converter is configured to translate a signal from the measuring device (14) to a higher frequency band before providing it to the at least one transmission antenna (10T) and

at least one frequency down-converter and wherein the measuring device (14) is connected to the at least one receiving antenna (10R) through the frequency down-converter and wherein the frequency down-converter is configured to translate the signal received from the at least one receiving antenna (10R) to a lower frequency band before providing it to the measuring device (14).

S9. The system according to any of the preceding system embodiments, wherein the system comprises

a transmitter mount (11T) configured for mounting therein at least one transmitting antenna (10T) and
a receiver mount (11R) configured for mounting therein at least one receiving antenna (10R).

S10. The system according to any of the preceding system embodiments, wherein the system comprises a clamp structure (20), the clamp structure (20) comprising:

a transmitter mount of the clamp (24T) configured for mounting therein at least one transmission antenna (10T) and
a receiver mount of the clamp (24R) configured for mounting therein at least one receiver antenna (10R) and
a base frame (22), wherein the transmitter mount of the clamp (24T) and the receiver mount of the clamp (24R) extend from the same side of the base frame (22).

511. The system according to the preceding embodiment, wherein the clamp structure (20) is formed as a single part - i.e. without mounting or assembling or attaching smaller parts together.

S12. The system according to any of the preceding system embodiments, wherein the positioning system comprises at least one positioning apparatus (30), said positioning apparatus (30) configured to move the at least one transmission antenna (10T) and the at least one receiving antenna (10R).

S13. The system according to the preceding embodiment and with the features of embodiment S10, wherein the clamp structure (20) is attached to the positioning apparatus (30) and the positioning apparatus (30) is configured to move the clamp structure (20).

S14. The system according to any of the preceding 2 embodiments, wherein the positioning apparatus (30) is a robotic arm (30) and wherein the robotic arm (30) comprises a:

a robotic arm base (31) configured to support the robotic arm (30) and
a first prolonged member (32) attached on one of its ends with the robotic arm base (31) and on the other end with a second prolonged member (34) and
wherein the second prolonged member (34) is configured to support the at least one transmission antenna (10T) and the at least one receiving antenna (10R) and/or respective mounting structures of the at least one transmission antenna (10T) and the at least one receiving antenna (10R).

S15. The system according to the preceding embodiment, wherein the robotic arm (30) is configured to allow at least one of:

relative motion between the robotic arm base (31) and first prolonged member (32),
relative motion between the first prolonged member (32) and second prolonged member (34).

S16. The system according to any of the 3 preceding embodiments, wherein a joint between the clamp structure (20) and the positioning apparatus (30) is configured to provide rotation of the clamp structure (20).

S17. The system according to any of the preceding system embodiments, wherein the positioning system comprises a radome handling apparatus (40) to move the radome (15).

S18. The system according to any of the preceding system embodiments, wherein the distance between the at least one transmitting antenna (10T) and the at least one receiving antenna (10R) is between 10 cm to 1 m, such as, 25 cm.

S19. The system according to any of the preceding system embodiments, wherein the at least one transmission antenna (10T) and the at least one receiving antenna (10R) are configured as transceiver antennas (10).

S20. The system according to any of the preceding system embodiments, wherein the system can comprise 1 to 100 transmission antennas (10T) and 1 to 100 receiving antennas (10R).

S21. The system according to any of the preceding system embodiments, wherein the positioning system comprises a first robotic arm configured to support and handle at least one transmission antenna (10T) and a second robotic arm configured to support and handle at least one receiving antenna (10R).

S22. The system according to any of the preceding system embodiments, wherein the at least one transmission antenna (10T) and the at least one receiving antenna (10R) are aligned, such that, the main lobe of the at least one transmission antenna (10T) and the main lobe of the at least one receiving antenna (10R) intersect.

S23. The system according to any of the preceding system embodiments and with the features of embodiment S2, wherein the data processing device is configured to control the positioning system.

S24. The system according to any of the preceding system embodiments and with the features of embodiment S2, wherein the data processing device is configured to control the at least one transmitting antenna (10T) and the at least one receiving antenna (10R).

S25. The system according to any of the preceding system embodiments and with the features of embodiment S2 and S6, wherein the data processing device comprises the measuring device (14).

S26. The system according to any of the preceding system embodiments, wherein the system is configured to carry out the method according to any of the preceding method embodiments.

S26. The system according to any of the preceding system embodiments, wherein the system is configured to carry out the method according to any of the preceding method embodiments to determine the property of the radome.

Below, use embodiments will be discussed. These embodiments are abbreviated by the letter "U" followed by a number. Whenever reference is herein made to "use embodiments", these embodiments are meant.

U1. Use of the system according to any of the preceding system embodiments and/or the method according to any of the preceding method embodiments
to measure the effects of a radar cover on electromagnetic waves traversing through the radar cover and wherein the radar cover is intended for covering at least one radar.

U2. The use according to the preceding embodiment, wherein the radar cover is a radome (15).

U3. Use of the system according to any of the preceding system embodiments and/or the method according to any of the preceding method embodiments
to measure the effects of a radar cover on electromagnetic waves traversing through the radar cover and wherein the radar cover is intended for covering at least one radar used in a vehicle.

U4. The use according to the preceding embodiment, wherein the radar cover is a bumper of the vehicle.

U5. The use according to the preceding embodiment, wherein the radar cover is an emblem of the vehicle.

U6. Use of the system according to any of the preceding system embodiments and/or the method according to any of the preceding method embodiments
during the development and/or production and/or manufacturing of a radar cover or system comprising the radar cover.

U7. Use of the system according to any of the preceding system embodiments and/or the method according to any of the preceding method embodiments

during the development and/or production and/or manufacturing of a vehicle.

Below, production system embodiments will be discussed. These embodiments are abbreviated by the letter "P" followed by a number. Whenever reference is herein made to "production system embodiments", these embodiments are meant.

P1. A production system comprising the system according to any of the preceding system embodiments.

P2. A production system according to the preceding embodiment, wherein the production system is configured to produce radomes and test at least one of the produced radomes using the system according to any of the preceding system embodiments.

P3. A production system according to any of the 3 preceding embodiments, wherein the production system is configured

to manufacture vehicles, wherein at least one of the vehicles comprises a radar cover

to test the radar cover using the system according to any of the preceding system embodiments.

P4. A production system according to any of the 4 preceding embodiments, wherein the system according to any of the preceding system embodiments tests the radome using the method according to any of the preceding method embodiments.

## Brief description of the figures

Figs. 1a and 1b illustrate a radar covered by a radome;

Figs. 2a and 2b depict a flowchart representing a method of determining a property of a radome;

Fig. 3a illustrates transmitted and reflected parts of a first electromagnetic wave emitted during the method of determining a property of the radome;

Fig. 3b illustrates transmitted and reflected parts of a second electromagnetic wave emitted during the method of determining a property of the radome;

Fig. 4 illustrates phase differences between the transmitted and reflected parts of the first and second electromagnetic waves;

Figs. 5a and 5b illustrate different positions of the radome;

Fig. 6 depicts further steps of the method of determining a property of a radome, wherein reference data is utilized;

Fig. 7 depicts a schematic of a radome measuring system according to an embodiment of the present invention;

Fig. 8 depicts a schematic of a radome measuring system comprising a clamp structure;

Figs. 9a and 9b depict a schematic of a radome measuring system comprising at least one positioning apparatus and a clamp structure;

Fig. 10 depicts a schematic of a radome measuring system comprising a radome handling apparatus and a clamp structure;

Fig. 11 depicts a schematic of a radome measuring system comprising multiple transmitting antennas and multiple receiving antennas mounted in a clamp structure;

Figs. 12a and 12b illustrate how an area of a radome can be measured;

Fig. 13 illustrates a grid measurement.

## Detailed description of the figures

Throughout the description of the drawings, like features are denoted by like reference numerals. However, for ease of illustration and brevity of the description, some reference numerals may be omitted in some of the Figures.

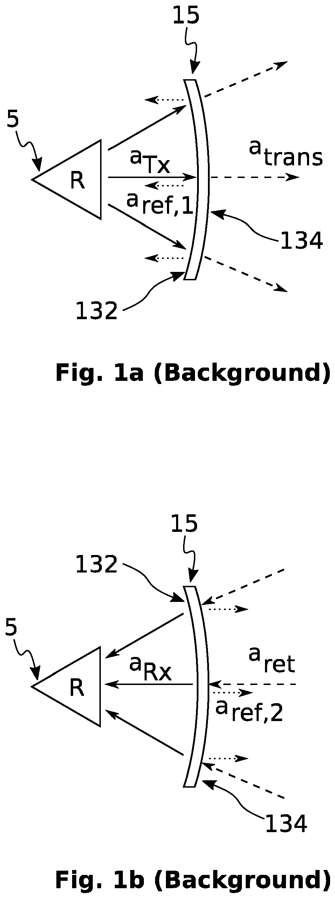

Figs. 1a and 1b illustrates a radar 5 which can be covered by a radome 15. The radar 5 can be configured to emit and receive electromagnetic waves with a frequency between 30 GHz to 160 GHz, such as, between 70 GHz and 90GHz. The radar 5 can typically be used in object detection systems for detecting the presence, position and/or velocity of the objects. For example, the radar 5 can be an automotive radar 5. The radar 5 can be used in a vehicle for assisting automotive operations of the vehicle. For example, the radar 5 can be used in parking assistant systems, blind spot monitoring systems and bake assistant systems within a vehicle.

For example, the radar 5 can be a short-range radar (SRR) which are typically utilized for short range applications like blind-spot detection, parking aid or obstacle detection and collision avoidance. Another example of the radar 5 is the long-range radar (LRR). The LRRs typically provide better accuracy and better resolution. They can be used for measuring the distance, speed and position of objects e.g. for cross traffic alert systems. LRRs typically comprise directive antennas that can provide a higher resolution within a more limited scanning range. Long-range radar (LRR) systems can measure within ranges of 80m to 200m or greater.

The radar 5 can operate in the 77 GHz band (i.e. from 76 GHz to 77GHz) and/or in the 79 GHz band (i.e. from 77GHz to 81 GHz). The 77 GHz frequency band is generally the preferred range for radars 5 used in the automotive industry.

The radar 5 can be placed behind the radome 15 such that the saliency of the radar 5 can be reduced (i.e. the radar 5 can be hidden from view) and the radar 5 can be protected, e.g., from environmental conditions. Thus, electromagnetic waves traverse through the radome after they are emitted from the radar 5 (Fig. 1a) and before being received by the radar 5 (Fig. 1b).

As illustrated in Fig. 1a, the radar 5 can emit electromagnetic waves $a_{Tx}$. The emitted electromagnetic waves $a_{Tx}$ become incident on a transmission side 132 of the radome 15. A part of the emitted electromagnetic wave $a_{Tx}$, which can be referred to as the reflected part $a_{ref,1}$, can be reflected by the transmission side 132 of radome 15. Another part of the emitted electromagnetic wave $a_{Tx}$, which can be referred to as the transmitted part $a_{trans}$, can be transmitted through the radome 15. The transmitted part $a_{trans}$ of the emitted electromagnetic wave $a_{Tx}$ can reach objects in the detection range of the radar 5 and once they become incident on a surface of an object they can be reflected.

A part of the electromagnetic waves reflected by the objects can be directed towards the radar 5. These electromagnetic waves, which can be referred to as returned part $a_{ret}$, can become incident on a reception side 134 of the radome 15. A part of the returned electromagnetic waves $a_{ret}$, which can be referred to as the reflected part $a_{ref,2}$ (not to be confused with $a_{ref,1}$), can be reflected by the reception side 134. Another part of the returned electromagnetic wave $a_{ret}$, which can be referred to as the received part $a_{Rx}$, can be transmitted through the radome 15 and can be received by the radar.

For an efficient operation of the radar 5, it can be advantageous for the radome 15 to be as transparent as possible to the electromagnetic waves transmitted by the radar 5 or to the electromagnetic waves being returned to the radar 5. That is, it can be advantageous for most of the emitted electromagnetic waves $a_{Tx}$ to be transmitted through the radome 15, i.e., the transmitted part $a_{trans}$ to be as large as possible. Similarly, it can be advantageous for most of the returned electromagnetic waves $a_{ret}$ to be transmitted through the radome 15, i.e., the received part $a_{Rx}$ to be as large as possible. In general, it can be advantageous for the radome 15 a change as small as possible on the amplitude, phase, frequency and direction of the electromagnetic waves traversing through the radome 15.

The effect the radome 15 can have on the transmitted and returned electromagnetic wave can depend, inter alia, on the dielectric properties of the radome 15. For example, the effect the radome 15 can have on electromagnetic waves traversing through it can depend on the scattering parameters (i.e. S-parameters) of the radome 15, such as, the transmission coefficient (i.e. transmissivity) and the reflections parameter (i.e. reflectivity) of the radome 15. Moreover, knowing any of the above properties of the radome 15 can facilitate predicting or modelling the effect that the radome 15 can have on electromagnetic waves traversing through it. In addition, it can facilitate designing and manufacturing radomes 15 with a minimal effect on the electromagnetic waves traversing through it. Further still, it can facilitate detecting radomes 15 and/or portions of radome 15 with a minimal (or maximal) effect on the electromagnetic waves traversing through it. The latter can further facilitate a quality control process of radomes 15 and/or determining the most efficient positioning of the radome 15 and the radar 5 to minimize the effect of the radome 15 on the electromagnetic waves traversing through the radome 15.

The present invention provides methods and systems for measuring and/or testing radomes. In particular, the dielectric properties of a radome can be measured, such as, the scattering parameters, e.g., the transmissivity and reflectivity. Additionally or alternatively, the effect of a radome 15 on electromagnetic waves that become incident on a surface of the radome can be measured. The measured effects may comprise an attenuation, a phase shift, a frequency shift, a change of the waveform and/or a change of the direction of travel. The measurement(s) can be performed on a transmission side 132 and/or on a reception side 134 of the radome 15. The measurement(s) can be performed on multiple areas of the radome (e.g. as a grid measurement) thus facilitating the generation of a transmission and/or reflection maps corresponding to each measured radome 15.

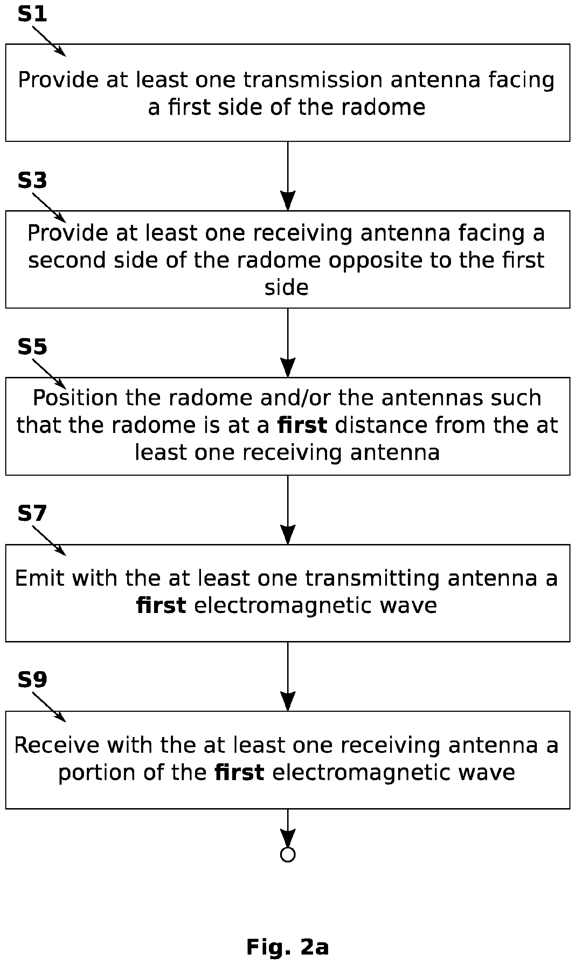

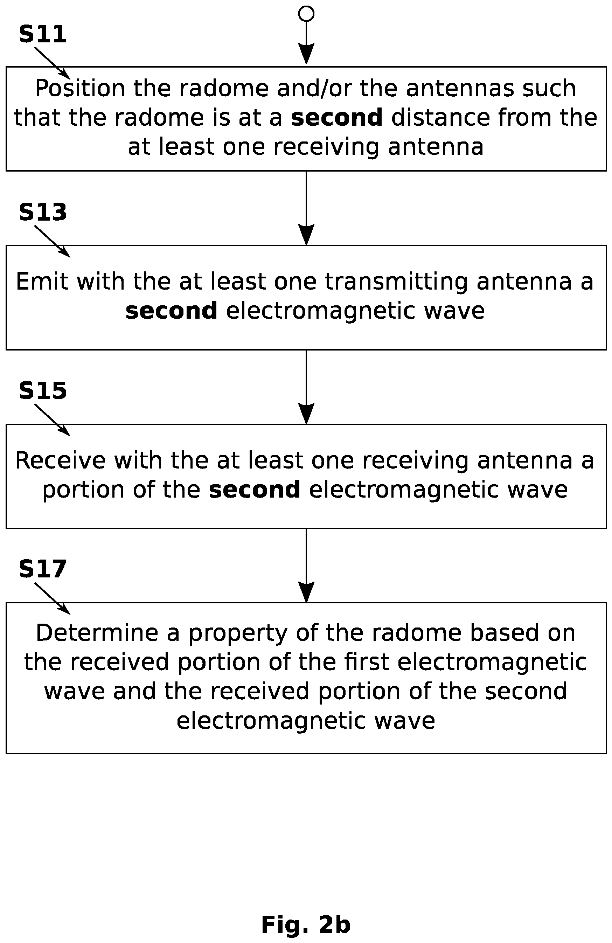

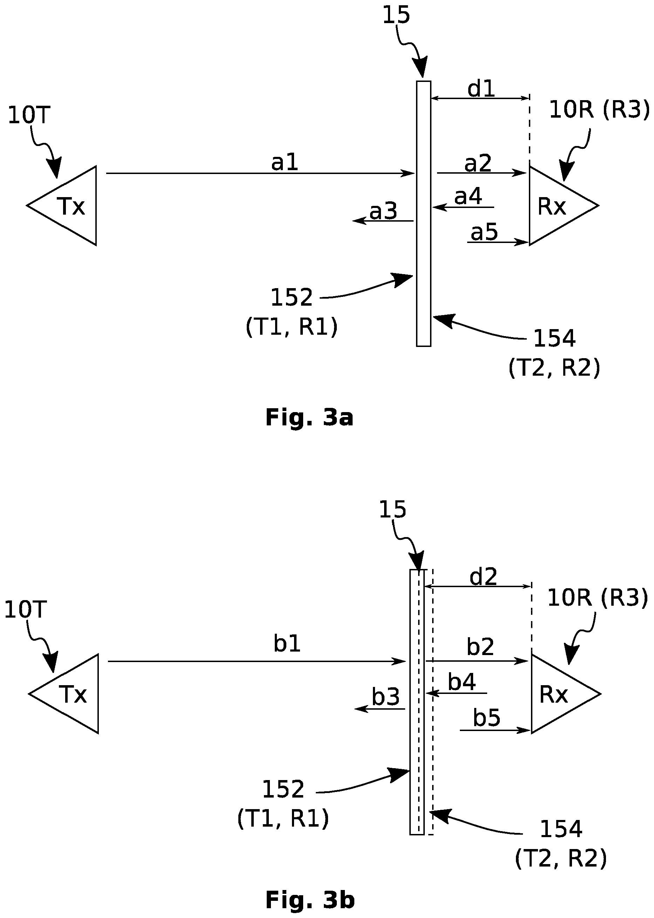

Figs. 2a and 2b depict a flowchart of a method of determining a property of a radome 15, such as, a scattering parameter of the radome 15. The method can be particularly advantageous for determining a transmission coefficient and/or a reflection coefficient of the radome 15. The method can be further particularly advantageous for determining a transmission coefficient of the transmission side 132 of the radome 15 (see Figs. 1a, 1b) and for determining a reflection coefficient of the reception side 134 of the radome 15 (see Figs. 1a, 1b). However, the person skilled in the art will appreciate that the method can be similarly performed to determine a reflection coefficient of the transmission side 132 of the radome 15 (see Figs. 1a, 1b) and for determining a transmission coefficient of the reception side 134 of the radome 15 (see Figs. 1a, 1b). Figs. 3a and 3b illustrate the steps of the method. In the following, the method will be discussed with reference to Figs. 2a to 3b.

In a step S1 the method can comprise providing at least one transmitting antenna 10T facing a first side 152 of the radome 15. The transmitting antenna 10T can also be referred to as the transmission antenna 10T.

Each transmitting antenna 10T can be configured for emitting or radiating electromagnetic waves with a certain frequency, such as, at least 20 GHz and at most 160 GHz, preferably at least 70 GHz and at most 90 GHz. For example, each transmitting antenna 10T can be configured to emit electromagnetic waves in the 77 GHz band (i.e. 76-77 GHz) and/or electromagnetic waves in the 79 GHz band (i.e. 77-81 GHz). Moreover, each transmitting antenna 10T can be configured to emit electromagnetic waves towards the radome 15 and more particularly towards the first side 152 of the radome 15. That is, the main lobe of each transmitting antenna 10T can be directed towards the first side 152 of the radome 15. Each transmitting antenna 10T can be configured to transmit electromagnetic waves with a power of at least 1 microwatt (i.e. -30dBm) and at most 1 watt (i.e. 30 dBm).

Preferably, the at least one transmitting antenna 10T can be similar to the transmitting antenna of the radar 5. For example, the at least one transmitting antenna 10T can emit electromagnetic waves with the same frequency as the antenna of the radar 5 and/or can comprise the same or similar polarization and/or field of view size and shape with the antenna of the radar 5. For example, the at least one transmitting antenna 10T can comprise the same or similar antenna pattern with the antenna of the radar 5.

In a step S3, the method can comprise providing at least one receiving antenna facing a second side 154 of the radome 15, wherein the second side 154 is opposite to the first side 152. Each receiving antenna 10R can be configured for receiving electromagnetic waves with a certain frequency, such as, at least 20 GHz and at most 160 GHz, preferably at least 70 GHz and at most 90 GHz. For example, each receiving antenna 10R can be configured to receive electromagnetic waves in the 77 GHz band (i.e. 76-77 GHz) and/or electromagnetic waves in the 79 GHz band (i.e. 77-81 GHz). The receiving antenna 10R can be provided such that the main lobe of each receiving antenna 10R is directed towards the second side 154 of the radome 15.

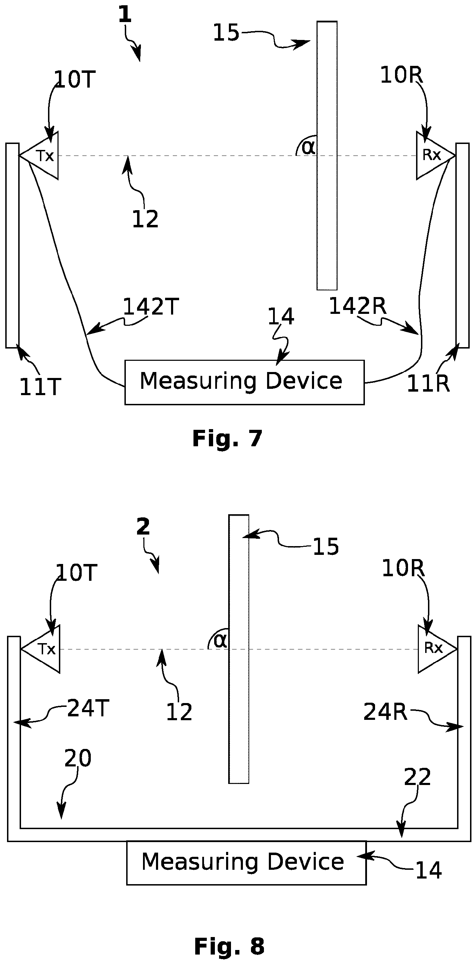

Moreover, the at least one transmitting antenna 10T can be aligned with the at least one receiving antenna 10R. In embodiments of the present invention, a clamp structure 20 can be provided (see Fig. 8), wherein the at least one transmitting antenna 10T and the at least one receiving antenna 10R can be mounted and aligned with each other. That is, the transmitting antenna 10T and receiving antenna 10R can be provided such that the main lobe of the transmitting antenna 10T and the main lobe of the receiving antenna 10R can intersect with each-other. For example, for each transmitting antenna 10T there can be at least one receiving antenna 10R that can receive the electromagnetic waves emitted by the transmitting antenna 10T. Alternatively or additionally, each receiving antenna 10R can receive electromagnetic waves transmitted by at least one transmitting antenna 10T. In other words, in steps S1 and S3 the transmitting antenna(s) and receiving antenna(s) can be provided according to any of the following arrangements: single-input and single output (SISO), single input and multiple output (SIMO), multiple input and single output (MISO) and multiple-input and multiple output (MIMO). Each of the arrangements can be associated with a trade-off between complexity of the system, amount of data generated (simultaneously), total time for measuring a radome and/or the area of the radome measured per unit time.

Put simply, the radome 15 and the antennas 10T, 10R can be positioned such that the radome 15 is placed between the antennas 10T, 10R such that an electromagnetic wave emitted by each of the at least one transmitting antennas 10T can traverse through the radome 15 before being received by the at least one receiving antenna 10R. This can allow for a property of the radome 15 to be measured.

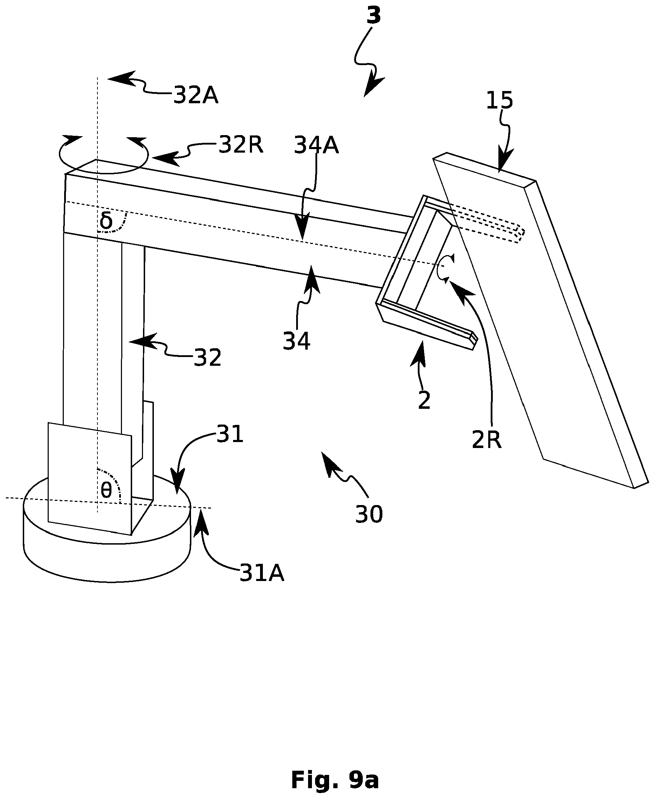

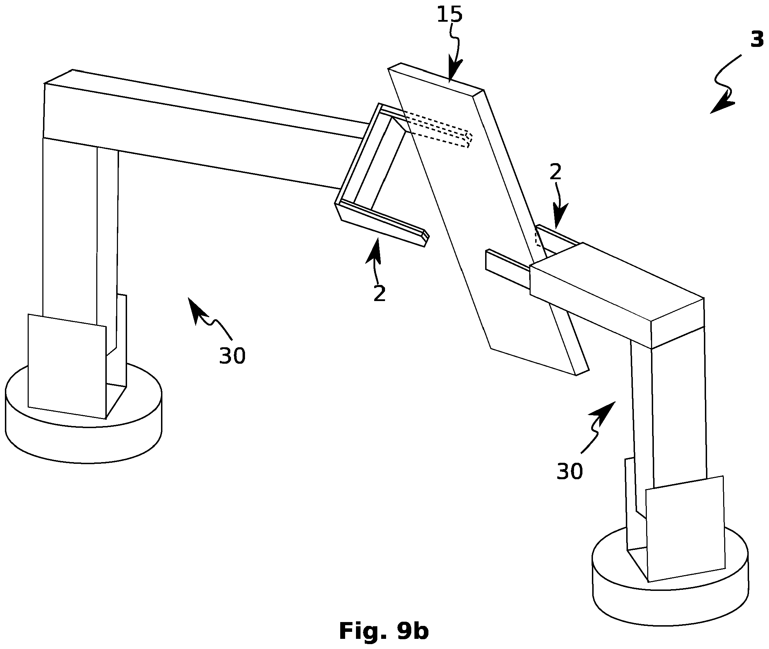

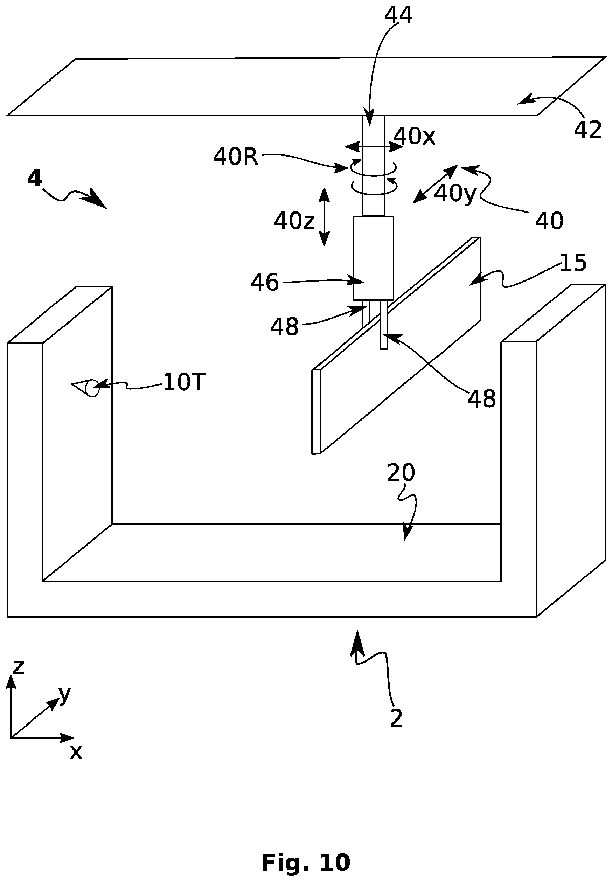

In a step S5, the method can comprise positioning the radome and/or the antennas 10T, 10R such that the radome is at a first distance d1 from the at least one receiving antenna 10R. Step S5 can comprise moving the radome 15 (e.g. see Fig. 10) and/or moving the antenna 10T, 10R (e.g. see Figs. 9a, 9b).

In a step S7 the method can comprise emitting with the at least one transmitting antenna 10T a first electromagnetic wave a1. The first electromagnetic wave a1 can comprise a short duration (i.e. short length). For example, the electromagnetic wave a1 can comprise a duration of at least $10\mu s$ and at most 100ms, preferably at least 1ms and at most 10ms. This can be advantageous as it can decrease the time required to perform a measurement.

In a step S9 the method can comprise the at least one receiving antenna 10R receiving a portion of the first electromagnetic wave a1. That is, during step S9 the receiving antenna 10R senses a portion of the energy radiated by the at least one transmitted antenna 10 (during step S7) in the form of electromagnetic waves.

As illustrated in Fig. 3a, the transmitting antenna 10T can emit the first electromagnetic wave a1 which becomes incident on the first side 152 of the radome 15. Therein, a part of the first electromagnetic wave a1 is reflected, as indicated by the reflected part a3. In addition, another part of the first electromagnetic wave a1 is transmitted through the radome 15 towards the receiving antenna 10R, as indicated by the transmitted part a2. The energy of the transmitted part a2 can depend on a first transmission coefficient T1 of the radome 15. The first transmission coefficient T1 of the radome 15 can represent a ratio of the amplitude of a transmitted part of an electromagnetic wave incident on the first side 152 over the amplitude of the electromagnetic wave incident on the first side 152. For example, the first transmission coefficient T1 of the radome 15 can be calculated as

$$T1 = \frac{|a2|}{|a1|} \qquad (Eq. 1)$$

wherein |a1| is the amplitude of the first electromagnetic wave a1 when it is incident on the first side 152 and |a2| is the amplitude of the transmitted part a2 when it exits from the second side 154.

On the other hand, the energy of the reflected part a3 can depend on a first reflection coefficient R1 of the radome 15. The first reflection coefficient R1 of the radome 15 can represent a ratio of the amplitude of a reflection of an electromagnetic wave, said reflection created when the electromagnetic wave is incident on the first side 152 of the radome 15, over the amplitude of the electromagnetic wave incident on the first side 152 of the radome 15. For example, the first reflection coefficient R1 of the radome 15 can be calculated as

$$R1 = \frac{|a3|}{|a1|} \qquad (Eq. 2)$$

wherein |a3| is the amplitude of the reflection a3 created when the first electromagnetic wave a1 becomes incident on the first side 152.

It can be advantageous for the first transmission coefficient T1 to be as close to 1 as possible and for the first reflection coefficient R1 to be as close to 0 as possible. This would result in a radome that is as much transparent as possible in the transmission direction (i.e. Fig. 1a).

The transmitted part a2 of the first electromagnetic wave a1 can be received by the receiving antenna 10R. However, when the transmitted part a2 becomes incident on surfaces of the receiving antenna 10R, reflections can be created which can bounce back and forth between the receiving antenna 10R and the second side 154 of the radome 15, as illustrated by the reflected parts a4 and a5. In other words, the receiving antenna 10R can sense a portion of the first electromagnetic wave a1, said portion comprising a2 and a5. The energy of a4 can depend on an antenna reflectivity R3 of the receiving antenna 10R. The antenna reflectivity R3 of the receiving antenna 10R can represent a ratio of the amplitude of a reflection of an electromagnetic wave, said reflection created when the electromagnetic wave is incident on the receiving antenna 10R, over the amplitude of the electromagnetic wave incident on the receiving antenna 10R. For example, the antenna reflectivity R3 of the receiving antenna 10R can be calculated as

$$R3 = \frac{|a4|}{|a2|} \qquad (Eq. 3)$$

wherein |a2| is the amplitude of the electromagnetic wave incident on the receiving antenna 10R (i.e. the amplitude of the transmitted part a2 of the first electromagnetic wave a1) and |a4| is the amplitude of the reflection a4 created when the transmitted part a2 of the first electromagnetic wave a1 becomes incident on the receiving antenna 10R.

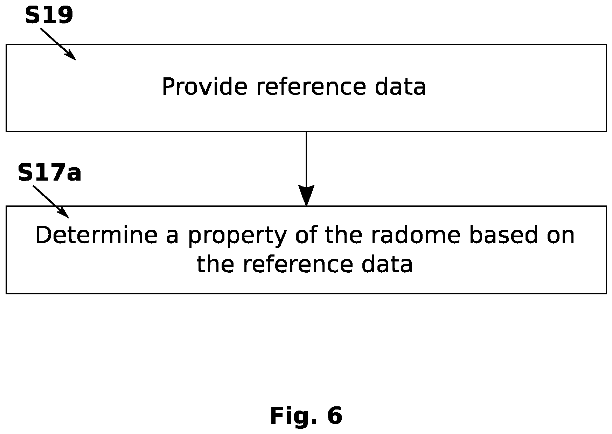

In general, R3 can be an internal parameter of the system used to determine a property of the radome. R3 can typically depend on the shape, size and material of the at least one receiving antenna 10R. R3 can be provided (e.g. it can be part of reference data, see Fig. 6) and/or can be determined during a calibration step (i.e. during a reference measurement, e.g., measuring a radome with known properties).

In addition, the radome 15 can comprise a second reflection coefficient R2 and a second transmission coefficient T2. T2 and R2 can be defined in a similar manner to T1 and R1 and can correspond to the case when an electromagnetic wave is incident on the second side 154. For example, the second reflection coefficient R2 can represent a ratio of the amplitude of a reflection of an electromagnetic wave, said reflection created when the electromagnetic wave is incident on the second side 154 of the radome 15, over the amplitude of the electromagnetic wave incident on the second side 154 of the radome 15. For example, the second reflection coefficient R2 of the radome 15 can be calculated as

$$R2 = \frac{|a4|}{|a5|} \qquad (Eq.\,4)$$

wherein |a5| is the amplitude of the reflection a5 created when reflection a4 is incident on the second side 154.

Put differently and modeling the radome 15 as a 2-port network then:

- the first reflection coefficient R1 can be equivalent to the input port reflection coefficient (i.e. scattering parameter $S_{11}$);
- the first transmission coefficient T1 can be equivalent to the forward gain (i.e. S-parameter $S_{21}$),
- the second reflection coefficient R2 can be equivalent to the output port reflection coefficient (i.e. scattering parameter $S_{22}$); and
- the second transmission coefficient T2 can be equivalent to the reverse gain (i.e. S-parameter $S_{12}$).

That is, the following can be an S-parameter matrix corresponding to a radome 15 (or to an area of the radome 15):

$$\begin{pmatrix} S_{11} & S_{12} \\ S_{21} & S_{22} \end{pmatrix} = \begin{pmatrix} R1 & T2 \\ T1 & R2 \end{pmatrix}$$

Typically, for a radome 15 covering a radar determining the first transmission coefficient T1 and the second reflection coefficient R2 can be of particularly advantageous. T1 can facilitate determining the effect that the radome 15 can have on the electromagnetic waves emitted by the radar, while R2 can facilitate determining the effect that the radome 15 can have on the electromagnetic waves returned to the radar (i.e. reflected by the objects to be detected).

As illustrated in Fig. 3a (and steps S1 to S9 of Fig. 2a), a transmission measurement can be performed. That is, a transmitted part a2 of the first electromagnetic wave a1 can be sensed by the receiving antenna 10R. However, the transmission measurement can be noisy due to the interference caused by the reflected part a5, which can also be received by the receiving antenna 10R. For an accurate transmission measurement, it can be advantageous to remove the interference caused by the reflected part a5. That is, it can be advantageous to separate the reflected part a5 from the transmitted part a2. However, due to the small difference between the distance of the path followed by the transmitted part a2 and the distance of the path followed by the reflected part a5, it can be challenging and complex to separate the reflected part a5 from the transmitted part a2. For example, time gating, which is a typical method used to suppress the unwanted signals (separation of signals using different path length and thus time-of-flight differences) may not be sufficient as it would require a very high frequency bandwidth.

To alleviate this, the present method comprises performing a second transmission measurement while the radome is positioned at a second distance from the at least one receiving antenna, as depicted in Fig. 2b and illustrated in Fig. 3b.

In a step 511, the method may further comprise positioning the radome and/or the antennas 10T, 10R such that the radome 15 is at a second distance d2 from the at least one receiving antenna 10R. Step S11 can comprise moving the radome 15 (e.g. see Fig. 10) and/or moving the antenna 10T, 10R (e.g. see Figs. 9a, 9b). In Fig. 3b, the radome 15 at the previous location (i.e. at the location during steps S5 to S9) is depicted with dashed lines.

In a step S13, the method can comprise emitting with the at least one transmitting antenna 10T a second electromagnetic wave b1 (see Fig. 3b). Step S13 can be performed similarly to step S7. That is, the first and the second electromagnetic waves a1, b1 can be emitted with same properties, such as, with the same frequency. A delay between steps S13 and S7 can be provided such that interference that can be caused by the first electromagnetic wave a1 and its reflections can be minimized. However, this may not be critical as generally the wave propagation will be in the range of ns, while the time between the two measurements may be in the range of ms (e.g. 10ms to 1s). In other words, the change of the relative position between the radome 15 and the antenna 10T, 10R may provide sufficient time for the first electromagnetic wave a1 and its respective reflections to be removed. Thus, no further delay may be required.

In a step S15, the method can comprise the at least one receiving antenna 10R receiving a portion of the second electromagnetic wave b1. That is, similar to step S9, during step S15 the receiving antenna 10R can sense a portion of the energy radiated by the at least one transmitted antenna 10 (during step S13) in the form of electromagnetic waves. Similar to the above, the portion of the second electromagnetic wave b1 that can be received by the receiving antenna 10R can comprise the transmitted part b2 and the reflected part b5. Again, a separation between the transmitted part b2 and the reflected part b5 may be complex, may require complex electronic equipment and a very high bandwidth (e.g. for performing time-gating).

The present invention alleviates this by performing two transmission measurements, as discussed above, while the radome 15 is at a first distance d1 and at a second distance d2, respectively, from the receiving antenna 10R. Moreover, steps S7 and/or S9 can be performed such that a difference between the first distance d1 and the second distance d2 can be equal to a quarter of the wavelength of the first and second electromagnetic waves multiplied by an odd integer. That is:

$$|d1 - d2| = \frac{\lambda_0}{4} + N \cdot \frac{\lambda_0}{2} \qquad (Eq.\,5)$$

wherein $\lambda_0$ is the wavelength of the emitted electromagnetic waves and N is a non-negative integer and can, e.g., be 0. Selecting the difference between the two positions of the radome 15 as above can be advantageous as it can ensure that the reflected part a5 during the first measurement comprises a phase difference of 180° with the reflected part b5 during the second measurement.

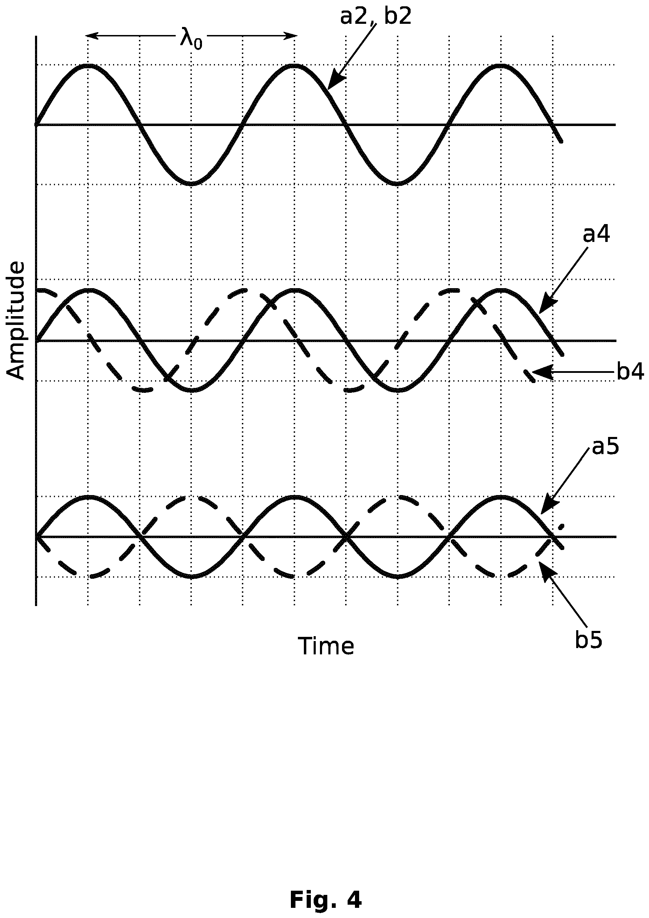

Fig. 4 illustrates the phase differences between the transmitted and reflected parts of the first and second electromagnetic waves. It will be understood, that Fig. 4 provides an example of the reflected and transmitted parts of the first and second electromagnetic waves. Moreover, it will be understood that the waveforms of the first and second electromagnetic waves may not necessarily be sine waves (as illustrated) and may not necessarily comprise a single frequency.

In the upper part of Fig. 4, the amplitude versus time of the transmitted part a2 of the first electromagnetic wave a1 is plotted with a filled line and the amplitude versus time of the transmitted part b2 of the second electromagnetic wave b1 is plotted with a dashed line. These two plots depict the transmitted parts a2 and b2 at the receive antenna 10R (i.e., when the transmitted parts a2 and b2 become incident on the receive antenna 10R). Both the transmitted parts a2 and b2 coincide with each other. That is, the transmitted parts a2 and b2 are received at the receive antenna 10R in-phase with each other. This is because the distance between the transmitting antenna 10T and the receiving antenna 10R is not changed during the measurements. As such, the transmitted parts a2 and b2 follow the same path.

In some embodiments, the first and the second electromagnetic waves a1 and b1 can be emitted with the same phase. Thus, the transmitted parts a2 and b2 arrive with the same phase at the receiving antenna 10R. However, it will be understood that this may not be necessary. In some embodiments, the transmitted parts a2 and b2 can be shifted such that they can coincide with each other and/or they phases are the same, e.g., as depicted in the upper part of Fig. 4. In other words, in some embodiments, an initial phase difference between the transmitted parts a2 and b2 (which may be present if the first and the second electromagnetic waves a1 and b1 are emitted with different initial phases) can be detected and it can be used to synchronize the phases of transmitted and reflected parts during the first and second measurements. For the sake of brevity, in the following the initial phase difference is assumed to be zero or to be compensated for. That is, only the phase difference as a result of the different path lengths followed by the reflected parts will be discussed.

In the middle part of Fig. 4, the amplitude versus time of the reflection a4 generated by the surfaces of the receiving antenna 10R when the transmitted part a2 becomes incident on the receiving antenna 10R is plotted with a filled line. In addition, the amplitude versus time of the reflection b4 generated by the surfaces of the receiving antenna 10R when the transmitted part b2 becomes incident on the receiving antenna 10R is plotted with a dashed line. These two plots depict the reflections a4 and b4 at the second side 154 of the radome 15 (i.e., when the reflections a4 and b4 become incident on the second side 154). As illustrated, the reflections a4 and b4 comprise a phase difference of 90° when they become incident on the second side 154. This is because the reflections a4 and b4 follow paths with different lengths. More particularly, the difference of the path lengths followed by the reflections a4 and b4 can be a quarter of the wavelength of the first and second electromagnetic waves multiplied by an odd integer, thus, causing a 90° phase shift between the reflections a4 and b4.

It will be understood, that the reflected part a4 may arrive at the second side 154 with a different phase. Generally, this depends on the distance between the second side 154 and the at least one receiving antenna 10R. The example of Fig. 4 may indicate a particular scenario when the transmitted part a2 arrives at the receiving antenna 10R with a crest or with a trough.

In the bottom part of Fig. 4, the amplitude versus time of the reflection a5 generated by the second side 154 when the reflection a4 becomes incident on second side 154 is plotted with a filled line. In addition, the amplitude versus time of the reflection b5 generated by the second side 154 when the reflection b4 becomes incident on second side 154 is plotted with a dashed line. These two plots depict the reflections a5 and b5 at the receiving antenna 10R (i.e., when the reflections a5 and b5 become incident on receiving antenna 10R). Again, the difference in the path lengths followed by a5 and b5 will cause a further phase shift between the reflections a5 and b5. If the difference between the positions of the radome 15 during the first and second measurements is a quarter of the wavelength of the first and second electromagnetic waves multiplied by an odd integer, then the reflection parts a5 and b5 will be received completely out of phase (i.e. with a phase shift of 180°) at the receiving antenna. This can facilitate separating the transmitted parts from the reflected parts.

Again, the phase shift between the reflections a5 and b5 at the receiving antenna 10R can be 180° plus the initial phase difference between the first and second electromagnetic waves a1 and b1. However, as discussed, the initial phase difference may be zero and/or it can be detected and compensated for. In some embodiments, phase synchronization can be used to deal with the initial phase difference between the first and second electromagnetic waves a1 and b1.

More particularly, the electromagnetic wave received by the receiving antenna during the first and second measurement (i.e. during steps S7 and S15, respectively) can be represented as:

$$Rx(z, d_1) = \alpha_{trans} \cdot e^{-i\phi(z)} + \alpha_{ref} e^{-i\phi(z+d_1)} \qquad (Eq. 6)$$

$$Rx(z, d_2) = \beta_{trans} \cdot e^{-i\phi(z)} + \beta_{ref} \cdot e^{-i\phi(z+d_2)} \qquad (Eq. 7)$$

wherein

- z represents the distance between the transmitting antenna 10T and the receiving antenna 10R;
- d1 represents the first distance between the radome 15 and the receiving antenna 10R and d2 represents the second distance between the radome 15 and the receiving antenna 10R;
- Rx(z, d1) represents the amplitude of the portion of the first electromagnetic wave received by the receiving antenna 10R in step S7 and Rx(z, d1) represents the amplitude of the portion of the second electromagnetic wave received by the receiving antenna 10R in step S15;

- $\alpha_{trans}$ represents the received (i.e. sensed) amplitude of the transmitted part (i.e. a2, Fig. 3a) of the first electromagnetic wave and $\beta_{trans}$ represents the received (i.e. sensed) amplitude of the transmitted part (i.e. b2, Fig. 3b) of the second electromagnetic wave;
- $\alpha_{ref}$ represents the received (i.e. sensed) amplitude of the reflected part (i.e. a5, Fig. 3a) of the first electromagnetic wave and $\beta_{ref}$ represents the received (i.e. sensed) amplitude of the reflected part (i.e. b5, Fig. 3b) of the second electromagnetic wave;
- $\phi(\cdot)$ represent the phase of the corresponding electromagnetic wave as a function of the path distance traveled by the electromagnetic wave.

The paths followed by the transmitted parts comprise the same distance (represented by z in the above equations). Thus, the transmitted parts of the first and second electromagnetic waves can be received with same amplitude (i.e. $\alpha_{trans} = \beta_{trans}$) and phase. The paths followed by the reflected parts differ by 2 times |d2-d1|. As such, the reflected parts can experience different attenuations. Thus, the amplitudes of the reflected parts can comprise a difference. However, due to the small difference between d2 and d1 (e.g. a quarter of the wavelength), the difference in the amplitudes of the reflected parts can be negligible. Thus, the amplitudes of the reflected parts can be assumed to be equal (i.e. $\alpha_{ref} = \beta_{ref}$), without introducing significant errors. Alternatively, in some embodiments, an attenuation function can be obtained, determined and/or measured and can be used to calculate the values of $\alpha_{trans}$ and $\beta_{trans}$. Moreover, selecting the difference between d2 and d1 to be a quarter of the wavelength multiplied by an odd constant, it can be shown (e.g. see Fig. 4) that:

$$\phi(z + d_2) = \phi(z + d_1) + \pi \cdot (2N + 1) \qquad (Eq. 8)$$

wherein N is an integer such that the radome is positioned between the antennas 10T, 10R during the second measurement.

Based on the above rationales, the electromagnetic wave received by the receiving antenna 10R during the first and second measurements (i.e. during steps S7 and S15, respectively) can be represented as:

$$Rx(z, d_1) = \alpha_{trans} \cdot e^{-i\phi(z)} + \alpha_{ref} e^{-i\phi(z+d_1)} \qquad (Eq. 9)$$

$$Rx(z, d_2) = \alpha_{trans} \cdot e^{-i\phi(z)} - \alpha_{ref} \cdot e^{-i\phi(z+d_1)} \qquad (Eq. 10)$$

Thus, the amplitude of the transmission part and the reflection part can be determined using:

$$\alpha_{trans} = \frac{1}{2}|Rx(z, d_1) + Rx(z, d_2)| \qquad (Eq. 11)$$

$$\alpha_{ref} = \frac{1}{2}|Rx(z, d_1) - Rx(z, d_2)| \qquad (Eq. 12)$$

Hence, the present invention can facilitate the separation of the transmitted part through the radome 15 and reflected part by the radome 15 using two measurements, with the radome placed, respectively, at two different positions. In one hand, the method increases the accuracy of a transmission measurement (e.g. measuring the electromagnetic wave that is transmitted through the radome and/or determining a transmissivity of the radome) as it can alleviates the inaccuracies introduced by the interference of the reflected parts on the transmitted parts. More particularly, the present invention can alleviate the interference caused by the reflected part a5, which is generally the reflection that reaches the receiving antenna 10R with the highest power compared to other reflections (as it follows the shortest path compared to other reflections that may reach the receiving antenna 10R). On the other hand, the method allows for performing a reflections measurement of the radome (e.g., measuring the electromagnetic wave reflected by the radome and/or determining the reflectivity of the radome). That is, the present technology uses the same two measurements to determine the transmissivity and reflectivity of the radome 15.

For example, a first transmission coefficient of the radome 15 can be determined using

$$T1 = \frac{|a2|}{|a1|} = \frac{|\alpha_{trans}|}{|a1|} \qquad (Eq. 13)$$

In some embodiments, the accuracy of calculating the first transmission coefficient T1 can be improved by considering the attenuation caused to the transmitted part a2 in the path between the second side 154 and the receiving antenna 10R. For example, the first transmission coefficient may be determined using:

$$T1 = \frac{|a2|}{|a1|} = \frac{\alpha_{trans} \cdot \alpha_{loss}}{|a1|} \qquad (Eq. 14)$$

wherein $\alpha_{loss}$ can be a constant that can be used to compensate for the attenuation caused to the transmitted part a2 in the path between the second side 154 and the receiving antenna 10R. The constant $\alpha_{loss}$ can be determined analytically (e.g. using path loss models and antenna loss models) and/or empirically (e.g. measuring reference radomes with known parameters to determined reference data comprising the constant $\alpha_{loss}$, see Fig. 6).

The second reflection coefficient R2 of the radome 15 can be determined using

$$R2 = \frac{|a5|}{|a4|} = \frac{\alpha\_ref}{R3 \cdot |a2|} \qquad (Eq. 15)$$

wherein R3, as discussed, represent the reflection coefficient of the receiving antenna 10R. The antenna reflectivity R3 can be a pre-determined parameter (e.g. determined by measuring reference radomes with known parameters to determined reference data comprising the antenna reflectivity R3, see Fig. 6) and/or can be provided by the manufacturer of the receiving antenna 10R.

In some embodiments, the accuracy of calculating the second reflection coefficient R2 can be improved by considering path losses. It will be understood that $\alpha\_ref$ represents the amplitude of a5 at the receiving antenna 10R. Similarly, $R3 \cdot |a2|$ represents the amplitude of the reflection a4 at the receiving antenna 10R. However, the second reflection coefficient R2 represents a parameter determined or measured at the second side 154 of the radome. Thus, $\alpha\_ref$ can be an underestimation of the amplitude of a5 at the moment it is reflected by the second side 154 and $R3 \cdot |a2|$ can be an overestimation of the reflection a4 when it becomes incident on the second side 154. To compensate for the above, the second reflection coefficient R2 may be determined, for example, using:

$$R2 = \frac{|a5|}{|a4|} = \frac{\alpha_{ref} \cdot \beta_{loss}}{R3 \cdot |a2| \cdot \gamma_{loss}} \qquad (Eq.\,16)$$

wherein $\beta_{loss}$ indicates the attenuation of the reflection a5 when travelling from the second side 154 to the receiving antenna 10R and $\gamma_{loss}$ indicates the attenuation of the reflection a4 when travelling from the receiving antenna 10R to the second side 154. The constants $\beta_{loss}$ and $\gamma_{loss}$ can be determined analytically (e.g. using path loss models and antenna loss models) and/or empirically (e.g. measuring reference radomes with known parameters to determined reference data comprising $\beta_{loss}$ and $\gamma_{loss}$, see Fig. 6).

It will be understood, that Eq. 14 and Eq. 16 are merely exemplary equations for calculating T1 and R2, respectively, while considering attenuation. The person skilled in the art will appreciate that other path loss models or functions may be utilized in the respective equations.

Thus, referring back to Fig 2b, in a step S17 the method can comprise determining a property of the radome 15 based on the received portion of the first electromagnetic wave (e.g. Rx(z1,d1) and the received portion of the second electromagnetic wave (e.g. Rx(z,d2)). More particularly, in step S17 a transmission property of the radome can be determined. For example, the first transmission coefficient T1 of the radome 15 can be determined. In addition, in step S17 a reflection property of the radome can be determined. For example, the second reflection coefficient R2 of the radome 15 can be determined.

In general, in step S17 at least one scattering parameter of the radome 15 can be determined, preferably at least 2 scattering parameters of the radome 15. In some embodiments, all 4 scattering parameters of the radome 15 can be determined. In such embodiments, it may be advantageous to perform 2 pairs of measurements (i.e. at least 4 measurements) to determine all the scattering parameters. That is, a first electromagnetic wave and a second electromagnetic wave can be emitted such that they traverse the radome 15 from the first side 152 to the second side 154. Using the above steps, T1 and R2 can be determined. In addition, a third electromagnetic wave and a fourth electromagnetic wave can be emitted such that they traverse the radome 15 in a reverse direction, i.e., from the second side 154 to the first side 152. This can be performed by either rotating the radome 15 and/or the antennas 10T, 10R such that the at least one transmission antenna 10T faces the second side 154 and the at least one receiving antenna 10R faces the first side or by further providing at least one further transmitting antenna 10T facing the second side 154 and at least one further receiving antenna 10R facing the first side 152 or by providing the at least one transmitting antenna 10T and the at least one receiving antenna 10R as transceiver antennas. Using the same techniques discussed above, T2 and R1 can be determined. For the sake of brevity, the invention is discussed mainly with reference to the transmission of the first and second electromagnetic waves and the corresponding measurements.

As discussed above, the radome 15 and the antennas 10T, 10R can be arranged such that the radome 15 is positioned between the at least one transmitting antenna 10T and the at least one receiving antenna 10R. This can allow an electromagnetic wave emitted by the at least one transmitting antenna 10T to traverse through the radome 15 before being received by the at least one receiving antenna 10R.

In some embodiments, it can be advantageous to position the radome 15 and/or the antennas 10T, 10R such that the radome 15 can be closer to the at least one receiving antenna 10R than to the at least one transmitting antenna 10T. That is, the distance between the radome 15 and the at least one receiving antenna 10R can be smaller than the distance between the radome 15 and the at least one transmitting antenna 10T. Put differently, a ratio of the distance between the radome 15 and the at least one receiving antenna 10R over the distance between the at least one transmitting antenna 10T and the at least one receiving antenna 10R can be smaller than 0.5. For example, the ratio can be at most 0.4, preferably at most 0.2. Alternatively or additionally, the ratio can be at least 0.01, preferably at least 0.04. For example, the ratio can be at least 0.01 and at most 0.4, preferably at least 0.04 and at most 0.2. For example, the distance between the transmission antenna 10T and the receiving antenna 10R can be 250mm, and the distance between the radome 15 and the receiving antenna 10R can be 10 mm to 50 mm. Generally, it can be advantageous for the distance between the radome 15 and the receiving antenna 10R to be smaller (preferably much smaller) than the half of the distance between the transmitting antenna 10T and the receiving antenna 10R.

Placing the radome 15 near the receiving antenna 10R can comprise several advantages. As an initial matter, the reflections between the receiving antenna 10R and the radome 15, can be received with a higher amplitude at the receiving antenna 10R, due to the shorter path length that the reflections can follow before being received at the receiving antenna 10R. As such, measuring a reflection property of the radome 15 can be facilitated.

Additionally, a small distance between the radome 15 and the receiving antenna 10R can increase the likelihood of the reflections created by the second side 154 of the radome 15 being received by the receiving antenna 10R. That is, advantageously the radome 15 and the antennas 10T, 10R can be arranged (i.e. positioned) such that boresights of the antennas 10T, 10R are perpendicular to the first side 152 and second side 154. However, small misalignments may be introduced during the positioning of the radome 15 and/or antennas 10T, 10R. Additionally or alternatively, the first side 152 and the second side 154 may comprise curvatures. Thus, reflections created by the radome 15 may not always be directed towards the receiving antenna 10R. However, a smaller distance between the receiving antenna 10R and the radome 15 can increase the likelihood that the reflections can be received by the receiving antenna 10R. As such, the reflection measurement can further be facilitated.

Moreover, the radome 15 and the antennas 10T, 10R can be placed such that radome 14 is substantially perpendicular to the boresight of the antennas 10T, 10R. Thus, the electromagnetic waves emitted by the at least one transmitting antenna 10T can be substantially perpendicular to the radome 15 (e.g. to the first side 152). This can particularly facilitate measuring the transmitted part of the emitted electromagnetic waves. Similarly, the reflections can be substantially perpendicular to the radome 15 (e.g. to the second side 154). This can increase the likelihood of the reflections being received by the at least one receiving antenna 10R, thus, facilitating a reflection measurement of the radome 15. For example, if the radome is inclined, then the reflections can be directed away from the antennas. While this can typically be advantageous for measuring a transmitted part of the emitted electromagnetic waves, it makes it challenging to measure the reflected part. Hence, as the present invention can allow for both transmission and reflection measurements to be performed, it can be advantageous for the radome 15 to be perpendicular to the boresight of the antennas 10T, 10R.

However, the latter may facilitate the creation of multiple reflections bouncing back-and-forth on each side of the radome 15. This can superimpose and can prevent an accurate measurement of the reflection parts. However, this can be alleviated by placing the sample close to the receiving antenna 10R as discussed above. This can facilitate separating a reflection coming for the receiving antenna 10R to the radome 15 and back to the receiving antenna 10R, from other reflections.

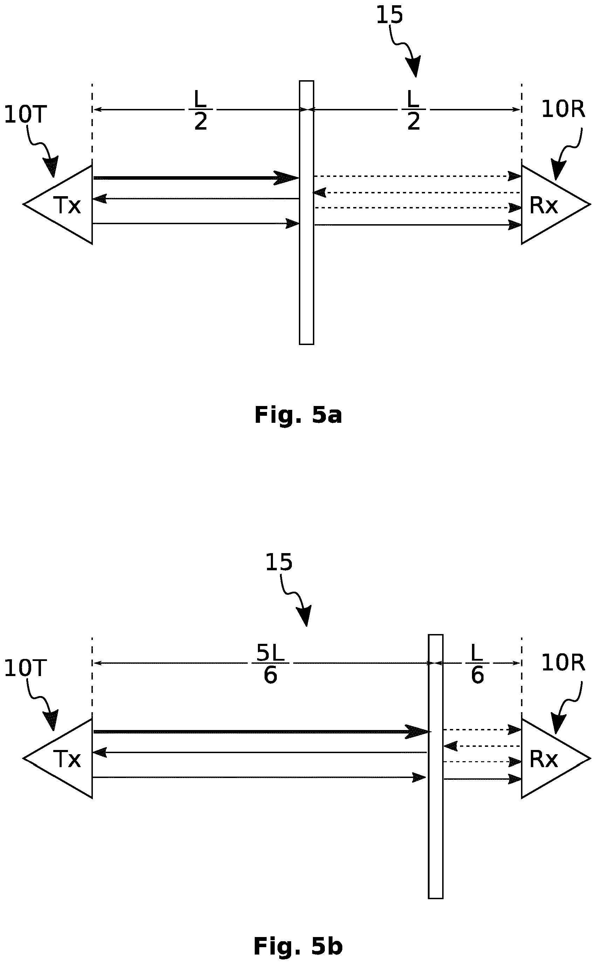

Figs. 5a and 5b illustrate the above. Fig. 5a depicts a non-advantageous position of the radome 15 between the antennas 10T, 10R. More particularly, in Fig. 5a the radome 15 is positioned exactly in the middle of the antennas 10T, 10R (i.e. with a distance of L/2 from the antennas). Such a positioning can be non-advantageous because it can allow multiple reflections to be superimposed at the receiving antenna 10R, hence interfering with a reflection measurement of the radome. More particularly, in Fig. 5a, the bold arrow represents the emitted electromagnetic wave, the continuous-line arrows represent a first reflection path and the dashed arrows represent a second reflection path. Both reflection paths comprise the same distance of 4 times L/2. Thus, the two reflections can be received at the same time at the receiving antenna 10R.

Fig. 5b illustrates an advantageous positioning of the radome 15 closer to the receiving antenna 10R. Just as an example, the distance between the radome 15 and the receiving antenna 10R is selected to be a fifth of the distance between the radome 15 and the transmitting antenna 10T. Thus, the first reflection path (depicted by the continuous-line arrows) comprises a distance of 16 times L/6, while the second reflection path (depicted by the dashed arrows) comprises a distance of 8 times L/6 (i.e. half the distance of the first reflection path). As such, the two exemplary reflections can reach the receiving antenna 10R at different times. Thus, the reflection on the receiver side of the radome depicted by the dashed arrows can be more easily separated from other reflections, as it follows the shortest path compared to other reflections. Again, this can be achieved by providing the radome closer to the receiving antenna 10R. Hence a reflection measurement can be facilitated.

Fig. 6 depicts further steps of the method. More particularly in a step S19 the method can comprise providing reference data. In such embodiments, in step S17 (Fig. 2b) the method can comprise a step S17a wherein the property of the radome 15 can be determined based on, inter alia, the reference data.

The reference data can, e.g., comprise data indicating a path loss (e.g. path loss exponent) corresponding to the space between the antennas 10T, 10R excluding the radome 15. For example, the path loss that can be caused by the (empty) space (i.e. air) between the antennas 10T, 10R can be obtained by performing an empty measurement without placing a radome between the antennas 10T, 10R. More particularly, during the empty measurement a reference electromagnetic signal can be emitted by the at least one transmitting antenna 10T and can be received by the at least one receiving antenna 10R. The reference electromagnetic signal traverses though the air between the at least one transmitting antenna 10T and the at least one receiving antenna 10R, before being received by the at least one receiving antenna 10R. The amplitude and/or power of the reference electromagnetic signal can be measured at the at least one receiving antenna 10R and can be compared with amplitude and/or power of the reference electromagnetic signal as emitted by the at least one transmitting antenna 10T. Based thereon, the attenuation that can be caused by environment between the antennas 10T and 10R (without the radome) can be determined. For example, based on the empty measurement $\alpha_{loss}$ (see Eq. 14), $\beta_{loss}$ (see Eq. 16) and/or $\gamma_{loss}$ (see Eq. 16) can be determined.

Alternatively or additionally, the reference data can comprise reflection reference data. The reflection reference data can facilitate determining a reflection property of the radome 15. For example, the measured reflection (i.e. $\alpha_{ref}$) can be compared with the reflection reference data and based thereon the reflection property (e.g. reflectivity) of a radome 15 can be determined. The reflection reference data can be obtained by performing the method illustrated in Figs. 2a and 2b, while a sample with known properties is used instead of the radome 15. For example, the transmissivity and reflectivity of the sample can be known. This can allow, e.g., for R3 (see Eq. 15 and Eq. 16), i.e., the reflectivity of the at least one receiving antenna 10R and/or of any other surface facing the second side 154 to be determined. Based thereon, the reflectivity R2 of the radome 15 can be determined.

In some embodiments, the reflection reference data can comprise a function which matches the amplitude of the reflected part with the reflectivity of the radome 15. For example, the function can receive as an input the measured amplitude of the reflected part $\alpha_{ref}$ and can output the reflectivity R2 of the radome 15. The function can be learned or determined by measuring at least one sample with known parameters (e.g. with known S-parameters, such as, with known reflectivity), as discussed above.

For example, a sample with a reflection loss of 10dB can be provided. During the reference measurement the reflection loss of the sample can be measured to be 11dB. While measuring the radome 15, a reflection loss of 12dB can be obtained. However, the measurement of the reflection loss of the radome 15 is affected by other factors, such as, e.g., the path loss and/or inaccuracies while performing the measurement. Using the reference data (i.e. the fact that a sample with a 10dB reflection loss was measured to be 11dB), it can be determined that the radome 15 comprises a reflection loss of 11dB. The corrected value of 11dB can be more accurate than the measured value of 12dB, as factors interfering with the measurement can be compensated for.

Fig. 7 depicts a first radome measuring system 1 according to an embodiment of the present invention. The radome measuring system 1 can be configured for performing radome measurements. More particularly, the radome measuring system 1 can be configured for carrying out the method discussed above with reference to Figs. 2 to 6.

The radome measuring system 1 can comprise at least one transmitting antenna 10T (also referred to as transmitter 10T) and at least one receiving antenna 10R (also referred to as receiver 10R), which can comprise any of the features discussed above.

Further, the radome measuring system 1 can comprise antenna mounts 11, more particularly, by a transmitter mount 11T and a receiver mount 11R. The antenna mounts 11 can be configured, such that, at least one antenna 10T, 10R can be mounted therein. Furthermore, each of the antenna mounts 11 can be configured to support the respective mounted antennas 10T, 10R. Furthermore, the transmitter mount 11T and the receiver mount 11R can be configured to facilitate the alignment between the at least one transmitting antenna 10T and the at least one receiving antenna 10R. For example, a transmitting antenna 10T can be mounted on the transmitter mount 11T and a receiving antenna 10R can be mounted on a receiver mount 11R and this can arrange the transmitting antenna 10T in alignment with the receiving antenna 10R (i.e. without any further aligning efforts). That is, by simply mounting the antennas 10T, 10R to the respective antenna mounts 11T, 11R, can position the antennas 10T, 10R within line of sight of each other.

Between the antennas 10T, 10T an object under test 15 can be positioned. The object under test 15 can be a radome 15 or part of a radome 15 or a sample taken from a radome 15. Thus, the radome 15 can be placed in the space between the transmitting antenna 10T and the receiving antenna 10R. Hence, the electromagnetic waves emitted by the transmitting antenna 10T, can contact the radome 15 and part of the emitted waves (referred to as the transmitted part) can traverse through the radome 15 and can be received by the receiving antenna 10R. In addition, a part of the transmitted part can be reflected back to the radome 15 by the receiving antenna 10R and then back again to the receiving antenna 10R by the radome 15. Thus, the at least one receiving antenna 10R can receive a transmitted part and a reflected part of the electromagnetic wave emitted by the at least one transmitting antenna 10T.

Further, the radome 15 can be perpendicular to the boresight of the antennas 10T and 10R, represented in Fig. 7 by the dashed line 12. That is, the angle $\alpha$ can be substantially perpendicular.

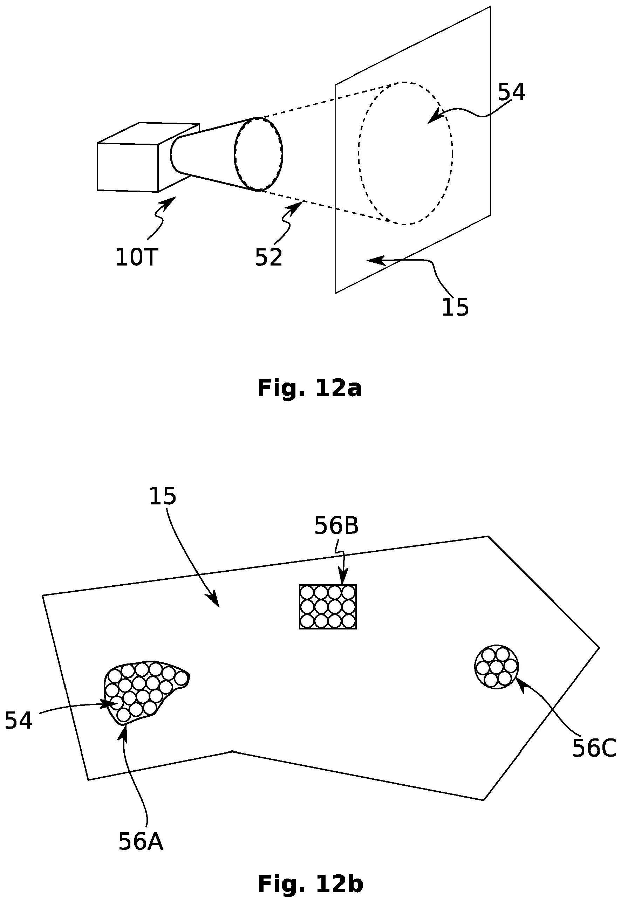

In a preferred embodiment, the at least one transmitting antenna 10T and the at least one receiving antenna 10R ca be horn antennas. The horn antennas can be advantageous due to their substantial directivity which can facilitate directing the emitted electromagnetic waves toward a preferred direction, such as, towards the radome 15 in a substantially perpendicular angle with the surface of the radome. Thus, the transmitter horn antenna 10T can be used to emit electromagnetic waves toward the radome 15 or toward a part of the radome 15 (e.g. the smallest part of the radome 15 that can be measured without changing the relative position between the antennas 10 and the radome 15, see Fig. 12A). Further, a horn antenna can also be advantageous as it can allow a gradual transition structure, realizing impedance matching with open air hence allowing for efficient emission/reception of the electromagnetic waves.

Furthermore, horn antennas can emit linearly polarized electromagnetic waves. It can be advantageous to match the polarization of the transmitting antenna 10T and receiving antenna 10R with the polarization of the radar 5 (Fig. 1) that will be covered by the radome 15. This can allow for more accurate results to be obtained based on the rationale that the more similar the test conditions are to the real conditions the more accurate results can be obtained. A radar 5 (Fig. 1) can be configured to transmit electromagnetic waves with different polarizations, such as, linear (horizontal or vertical), circular (clockwise or anti-clockwise), epileptic, etc. Usually radar sensors are configured to emit electromagnetic waves with linear polarization. Thus, the utilization of horn antennas can be advantageous for testing radomes 15 of radars 5 that emit linearly polarized electromagnetic waves. Nevertheless, the transmitting antenna 10T and receiving antenna 10R, can also be configured for emitting and/or receiving electromagnetic waves with other polarizations, such as, circular or epileptic polarization.

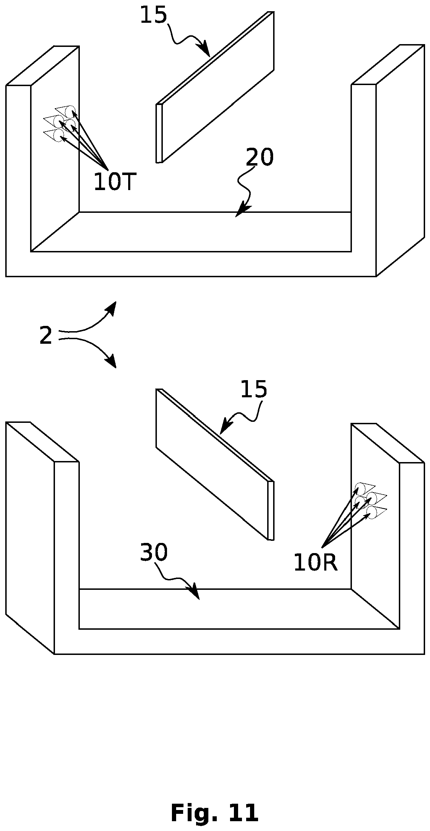

Additionally, the radome measuring system 1 can comprise a measuring device 14. The measuring device 14 can be connected with the transmitting antenna 10T by a transmitter connector 142T and with the receiving antenna 10R by a receiver connector 142R. The measuring device 14 can trigger the transmitting antenna 10T to emit an electromagnetic wave with a certain pattern in time and frequency. For example, the measuring device 14 can trigger the transmitting antenna 10T to emit pulses of electromagnetic waves with a certain bandwidth centered around a certain frequency. As it can be understood, the measuring device 14 can trigger the transmitting antenna 10T to emit electromagnetic waves within the range of frequencies and bandwidths supported by the transmitting antenna 10T (i.e. based on the geometry or physical structure of the transmitting antenna 10T a certain range of frequencies can be transmitted efficiently). The measuring device can trigger the at least one transmitting antenna to transmit single tones, wherein each tone is transmitted at a time and with a frequency within a certain frequency range (e.g. corresponding to the bandwidth that the radome should be measured). Alternatively, when multiple measurements can be performed simultaneously (e.g. multiple transmission and receiving antennas are provided, see Fig. 11) the measuring device can trigger each transmitting antenna to transmit a unique tone. Thus, multiple tones can be transmitted at a time. Alternatively, the measuring signal can trigger the at least one transmitting antenna 10T to transmit a modulated signal (i.e. a composed signal of multiple single tones) - which can allow multiple tones to be transmitted simultaneously.

Similarly, the measuring device 14 can receive signals provided by the receiving antenna 10R. The measuring device 14 can be configured to identify signal reception by the receiving antenna 10R (or alternatively identify when the receiving antenna 10R is simply "listening" to background noise). When a signal reception is identified, the measuring device 14 can use information regarding the transmitted signal and information regarding the receiving signal to measure dielectric properties of the medium(s) between the transmitting antenna 10T and receiving antenna 10R.

The differentiation of signal reception (i.e. reception of the signal that is transmitted by the transmitting antenna 10T) from background noise (and/or interference) at the receiving antenna 10R can be done using power squelching - i.e. only signals above a certain power level can be considered as signal reception, while the rest is considered as background noise.

As discussed, during the transmission of a signal from the transmitting antenna 10T to the receiving antenna 10R, reflections and/or diffractions can be created by the surfaces (and/or edges) of the radome 15 and the antennas 10.

The transmitter connector 142T and receiver connector 142R can be electrical conductors, such as, wires - e.g. coaxial cables. In such embodiments, the measuring device 14 can trigger the antenna 10T by sending an electrical signal through the conductor 142T and the transmitter antenna 10T converts the electrical signals into electromagnetic radiation. The receiving antenna 10R, converts electromagnetic radiation into electrical signals and transmits them to the measuring device 14 through the conductor 142R.

In another embodiment, the transmitter connector 142T and receiver connector 142R can be waveguides 142. In such embodiments, the measuring device 14 can be configured to trigger the transmitting antenna 10T by generating electromagnetic waves and transmitting those through the waveguide 142T to the transmitter antenna 10T. The transmitter antenna 10T provides the interface between the waveguide 142T and open-air for an efficient transmission of the waves. The receiving antenna 10R receives electromagnetic radiation and transmits it through the waveguide 142R to the measuring device 14.

In some embodiments, the received signal can be provided to the measuring signal in the same frequency range as transmitted from the transmitting antenna 10T and received by the receiving antenna 10R, i.e. the RF signal is directly distributed to the measuring device 14.

In another embodiment, a frequency converter can be used at the transmitter antenna 10T and receiving antenna 10R. More particularly, an up-converter can be used between the measuring device 14 and the transmitter antenna 10T and a down-converter can be used between the receiving antenna 10R and the measuring device 14. Thus, the measuring device 14 can operate at an intermediate frequency IF (e.g. 1 - 6 GHz) or at baseband (0 - 3 GHz), while the antennas 10 can transmit and/or receive RF signal at higher frequencies (i.e. RF range, e.g. 70 - 90 GHz). This can be advantageous as the measuring device 14 can be configured to operate at a certain low frequency range (e.g. IF range or baseband) independent of the RF range of the signals transmitted between the transmitting antenna 10T and receiving antenna 10R.

Thus, the measuring device can operate at an intermediate frequency (IF), e.g. 1 - 6 GHz, or at baseband (e.g. 0 - 3 GHz), while the antennas can transmit and/or receive RF signal at higher frequencies (i.e. RF range, e.g. 70 - 90 GHz).

Fig. 8 depicts a schematic of a second radome measuring system 2, also referred to as the radome measuring system with clamp 2 (or for brevity as a radome measuring clamp 2). In addition to the radome measuring system 1 discussed with respect to Fig. 7, the radome measuring clamp 2 can comprise a clamp structure 20 (also referred to as a clamp 20). The clamp 20 can comprise a base frame 22. On the base frame 22, two antenna mounts 24 can be attached. More particularly, on one of the ends of the base frame 22, a transmitter mount of the clamp 24T can be attached and on the other end, a receiver mount of the clamp 24R can be attached. Hence, the transmitter mount of the clamp 24T and the receiver mount of the clamp 24R and the base frame 22 can create a U-shaped structure or a "clamp" shaped structure.

In some embodiments, the clamp 20 can be manufactured by attaching or fixating the transmitter mount of the clamp 24T and the receiver mount of the clamp 24R on two opposing sides of the base frame 22. In some other embodiments, the clamp 20 can be created by attaching the antenna mounts 11T, 11R (see Fig. 7) on opposing sides of the base frame 22. In yet some other embodiments, the clamp 20 can be manufactured as a single part - i.e. without mounting or assembling or attaching smaller parts together to form the clamp 20.

The clamp 20 can provide a stable structure for the antennas 10T, 10R to be mounted. As discussed, it can be advantageous to have the transmitting antenna 10T and the receiving antenna 10R aligned with each-other such that most of the radiated electromagnetic waves emitted by the transmitting antenna 10T can be received by the receiving antenna 10R. The shape of the clamp structure 20 can facilitate this alignment. Further, it can be advantageous that the distance between the two antennas 10 to be kept constant, at least during a radome measurement. The clamp structure 20, more particularly the base frame 22, can facilitate keeping the distance between the transmitting antenna 10T and receiving antenna 10R constant.

The clamp structure 20 can further facilitate the handling of the at least one transmitting antenna 10T and the at least one receiving antenna 10R, without changing the relative position between the at least one transmitting antenna 10T and the at least one receiving antenna 10R.

The clamp structure 20 can also be configured to allow the fixation of the antenna mounts 24T and 24R on different parts of the base frame 22. This can allow the adjustment of the relative position between the two antenna mounts 24T and 24R, such as, the adjustment of the distance between the antenna mounts 24T and 24R. For example, the base frame 22 can comprise multiple attaching elements (not shown), wherein the antenna mounts 24T and 24R can be attaching to the base frame 22.

The radome measuring clam 2 can also comprise the transmitter connector 142T and the receiver connector 142R (see Fig. 7) which can be provided hidden inside the clamp structure 20.

Fig. 9a depicts a third radome measuring system 3. The third radome measuring system 3 comprises the radome measuring clamp 2 mounted on a positioning apparatus 30, such as, a on a robotic arm 30. The robotic arm 30 depicted in Figs. 9a and 9b, is only a specific example of a positioning apparatus 30. In general, any actuator system can be used for handling, carrying and/or moving the measuring clamp 2. For brevity, not all element of the radome measuring clamp 2 are depicted in Fig. 9a. However, for further details on the radome measuring clamp 2 refer to Fig. 8 and the corresponding descriptions.

The robotic arm 30 can comprise a first prolonged member 32 attached to a robotic arm base 31. The attachment between the first prolonged member 32 and the robotic arm base 31 can be configured to allow for the adjustment of the angle θ created between the vertical central axis 32A of the first prolonged member and a horizontal line 31A parallel to the upper surface of the robotic arm base 31. More generally, the first prolonged member 32 can be inclined with respect to the robotic arm base 31, hence causing the angle θ to change or the change of angle θ can cause inclination of the first prolonged member 32 to change.

Further, the robotic arm 30 can comprise a second prolonged member 34. The second prolonged member 34 can be attached with the first prolonged member 32. The angle δ created between the central axis 34A of the second prolonged member and the central axis 32A of the first prolonged member can be allowed to change by the joint between the first prolonged member 32 and the second prolonged member 34. Put simply, the second prolonged member 34 can be moved relative to the first prolonged member 32.

Additionally, the rotational motion of the second prolonged member 34 as indicated by the circular double arrow 32R can be provided. This rotational motion can be provided by allowing the second prolonged member 34 to rotate with respect to the first prolonged member 32 and/or allowing the first prolonged member 32 and the second prolonged member 34 to jointly rotate with respect to the robotic arm base 31 and/or by allowing the robotic arm base 31, the first prolonged member 32 and the second prolonged member 34 to rotate as indicated by the circular double arrow 32R.

As discussed, the second prolonged member 34 can be attached on one of its ends to the first prolonged member 32. On the other end of the second prolonged member 34, the radome measuring clamp 2 can be attached. The joint between the radome measuring clamp 2 and the second prolonged member 34 can be configured to allow a rotational motion of the radome measuring clamp 2 as indicated by the circular double arrow 2R.

Each of the movements of the robotic arm 30, as discussed in the previous paragraphs, can be facilitated using actuators (such as motors) on the respective joints. The motors (not shown) can be controlled (e.g. by the measuring device 14, see Fig. 8). The use of actuators can be advantageous as it can allow the robotic arm 30 to be automatically controlled.

The movements of the robotic arm 30 and the radome measuring clamp 2 can facilitate the positioning the radome 15 perpendicular to the boresight of the antennas 10T, 10R and/or the positioning of the radome 15 at a first distance from the at least one receiving antenna 10R and/or the positioning of the radome 15 at a second distance from the at least one receiving antenna 10R.

The robotic arm 30 can approach the radome measuring clamp 2 towards a radome 15, as shown in Fig. 9a, such that the transmitting and receiving antennas 10T and 10R mounted on the clamp structure are on opposing sides of the radome 15. Hence, a radome measurement can be conducted. Furthermore, by moving the radome measuring clamp 2, a first measurement can be performed while the radome 15 is at a first distance from the at least one receiving antenna (i.e. steps S5 to S9, Fig. 2a) and a second measurement can be performed while the radome 15 is at a second distance from the at least one receiving antenna (i.e. steps S11 to S15, Fig. 2b). In addition, moving the radome measuring clamp 2 can facilitate performing the measurements on multiple areas of the radome 15. For example, the robotic arm 30 can move the radome measuring clamp 2, such that a scanning of a part (or all) of the radome 15 can be achieved. This can be particularly advantageous for generating transmissivity and/or reflectivity maps corresponding to the radome 15.

The third radome measuring system 3 can be particularly advantageous for use when the radome 15 to be measured is large. The robotic arm 30 can move the radome measuring clamp 2 in a regular pattern, such that, a part or all the radome 15 can be scanned and measured.

The third radome measuring system 3 can also be advantageous for use in production lines of the radome 15 and/or in production lines of a system that may comprise the radome 15. The radomes 15 can directly be measured during production, manufacturing or assembling. The robotic arm 30 can allow for the integration of the third radome measuring system 3 in the production line, such that, it can work in synchronization with the other stages of the production line. In other words, the third radome measuring system 3 can facilitate the integration of radome measurements in production lines of radomes 15 and/or systems comprising the radome 15. An example may be the integration of the radome measurements in the car production line. In a car, the radar systems can be implemented behind the bumpers or emblems of the car - hence the bumpers or emblems act as radomes 15. During the manufacturing of the car, the effect of the radomes (e.g. bumpers, emblems) on the radar systems can be measured and tested.

In some embodiments, the third radome measuring system 3 can comprise multiple measuring clamps 2, each attached to a respective robotic arm 30. Fig. 9b, illustrates an embodiment of the third radome measuring system 3 comprising two robotic arms 30, each of them being attached to a corresponding radome measuring clamp 2. The two measuring clamps 2 can be used to simultaneously measure different parts of the radome 15. The third radome measuring system 3 with multiple robotic arms 30, wherein each of them can handle a respective radome measuring clamp 2, can be used to measure multiple targeted areas 56 (see Fig. 7B) of the same radome 15 or object under test 15.

Fig. 10 depicts a fourth radome measuring system 4. The fourth radome measuring system 4 can comprise a radome handling apparatus 40. Further, the fourth radome measuring system 4 can comprise the radome measuring clamp 2. A 3-dimensional cartesian reference system is also provided in Fig. 10 and is herein used as reference for describing the movements of the radome 15.

As it will be clarified by the following description, the difference between the fourth radome measuring system 4, depicted in Fig. 10 and the third radome measuring system 3 depicted in Figs. 9a and 9b, is that the radome 15 can be moved instead of the measuring clamp 2. That is, in the embodiment of Figs. 9a and 9b, the measuring clamp 2 can be attached to the positioning apparatus 30 which can be configured to move the measuring clamp 2 in different positions. In the embodiment of Fig. 10, the radome 15 can be attached to a radome handling apparatus 40 which can be configured for moving the radome 15. Furthermore, though not depicted in any of the figures, a combination of both can be possible or even preferable. That is, both the measuring clamp 2 and the radome 15 can be handled by respective apparatuses (i.e. positioning apparatus 30 and radome handling apparatus 40).

The radome handling apparatus 40 can be configured for moving the radome 15. It can comprise a mounting frame 40. The mounting frame 40 can be configured to support the weight of the radome handling apparatus 40 and the radome 15.

Attached to the mounting frame 42 can be an elongated component 44. The elongated component 44 can be joint on the other end with the grabbing element 46. The grabbing element 46 can slide through the elongated component 44, thus realizing a movement according to the z-axis as depicted by the arrow 40z.

The grabbing element 46 can be configured for grabbing and holding the radome 15. The grabbing element can comprise attaching elements 48, such as, two attaching elements 48 that can be positioned on two sides of the radome 15, attached with the radome 15 and fix the radome 15 to the grabbing element 15. The grabber element 46 can be configured to also release the radome 15. In other words, the grabber element 40 can be configured to grab and release the radome 15 multiple times.

Further, the elongated member 44 and the grabber element 46 can be moved according to the x- and y- axis as depicted by the arrows 40x and 40y respectively. Thus, the radome 15 can be moved in space according to the x-, y- and z- directions, with reference to the reference system provided in Fig. 4. Additionally, the elongated member 44 and the grabber element 46 can be rotated clockwise and counter-clockwise, with respect to the z-axis as also indicated by the circular arrows 40R. Additionally, the radome 15 can be inclined (i.e. the incidence angle $\alpha$ illustrated in Fig. 7 can be adjusted).

Preferably, the movements of the radome handling apparatus 40 can be generated by actuators (not shown). In such embodiments a control system (e.g. within the measuring device 14) can be configured to control the actuators of the radome handling system 40, to move the radome 15. Hence, the movement of the radome can be automatically done.

The mounting frame 42 can further be configured to guide the movements of the radome handling apparatus 40, particularly the movements according to the x- and y- axis. For example, guiding tracks can be provided in the mounting frame 42, wherein the elongated component 44 can slide or be guided.

The radome handling apparatus 40 can be particularly advantageous for use when the radome 15 to be measured is large. The radome handling apparatus 40 can move the radome 15 with respect to the radome measuring clamp 2, such that, part or all of the radome 15 can be measured (i.e. can be positioned within the line-of-sight of the transmitting antenna 10T and receiving antenna 10R, see Figs. 2A, 2B).

The radome handling apparatus 40 can also be advantageous for use in production lines of the radome 15 and/or a system that may comprise the radome 15. The radomes 15 can directly be measured during production, manufacturing or assembling. The radome handling apparatus 40 can allow for the integration of a radome measuring stage in the production line and can be configured to work in synchronization with the other stages and devices of the production line. For example, the radome handling system 40 can transport a radome 15 from a first location (e.g. a storing or buffering location for the radomes 15) to the radome measuring clamp 2, wherein the radome can be measured. Further, the radome moving system 40 can transport the radome 15 to another buffering location or stage of the production line. Afterwards, the radome handling system 40 can repeat this process with another radome 15 and thus multiple radomes 15 can be sequentially measured by the radome measuring clamp.

The radome handling apparatus 40 can further be advantageous for moving the radome along the x direction from a first position to a second position. For example, the radome handling apparatus 40 can move the radome 15 along the axial direction by a quarter of the wavelength of the emitted electromagnetic waves multiplied by an odd integer.

Fig. 11 depicts a further embodiment of the radome measuring clamp 2 (see also Fig. 8). In the embodiment depicted in Fig. 8, the radome measuring clamp 2 comprises one transmitting antenna 10T and one receiving antenna 10R. In the embodiment depicted in Fig. 11, the radome measuring clamp 2 instead comprises multiple transmitting antennas 10T and multiple receiving antennas 10R. The multiple transmitting antennas 10T and multiple receiving antennas 10R can be aligned with each other. For example, the transmitting antennas 10T and receiving antennas 10R can be aligned in pairs, such that, a signal transmitted from the transmitting antenna 10T of a pair is received by the receiving antenna 10R of the pair.

The multiple antennas 10 can also be arranged such that, the electromagnetic waves transmitted by at least one single transmitting antenna 10T are received by multiple receiving antennas 10R or vice-versa electromagnetic waves transmitted by multiple transmitting antennas 10T are received by at least one single receiving antennas 10R.

The use of multiple antennas 10T and 10R can be advantageous as it can allow the measuring of multiple areas of the radome 15 simultaneously. Hence, the process of radome measuring can be achieved in a shorter time as compared to the time needed when only one pair of antennas 10 is used.

A single radome measurement, in this embodiment, can consist of triggering all the transmitting antennas 10T and all the receiving antennas 10R. In this case, multiple measurement cells 54 (see Fig. 7) can be simultaneously measured. A measurement can also be realized by activating different numbers of transmitting antennas 10T and receiving antennas 10R. For example, one transmitting antenna 10T can be triggered and four receiving antennas 10R can be activated to receive the electromagnetic waves emitted by the transmitting antenna 10T.

Throughout the description of the various embodiments with respect to Figs. 1a to 11, the transmitting antenna 10T is described as an electromagnetic wave radiator and the receiving antenna 10R is described an electromagnetic wave receiver. However, in some embodiments, the transmitting antenna 10T and receiving antenna 10R can be configured as transceiver antennas 10, that is, can transmit and receive electromagnetic waves. In some embodiments, transmission and receiving of electromagnetic waves can be multiplexed in time i.e. the transceiver antenna 10 can act for a period of time as a transmitting antenna 10T and for another period of time as a receiving antenna 10R. Alternatively or additionally, the transmission and receiving of electromagnetic waves can be multiplexed in the frequency domain - i.e. the transceiver antenna 10 can simultaneously act as a receiving antenna 10R and transmitting antenna 10T, however using different frequency bands for each mode of operation. Using time multiplexing and/or frequency multiplexing can avoid the interference that can be created between the signals that are transmitted and signals that are received. Alternatively, the transceiver antennas 10 can operate as a transmitter and receiver simultaneously and on the same frequency band and signal processing techniques can be used to avoid the interference caused by the transmitted and receiving signals operating on the same frequency and time band.

Figs. 12a and 12b illustrate how an area of a radome 15 can be measured. In Fig. 12A a transmitting antenna 10T is depicted. For example, the transmitting antenna 10T can be a horn antenna 10T. The transmitting antenna 10T can be configured to emit electromagnetic waves in a specific direction, as depicted by the transmission beam 52. The transmission beam 52 represents the volume wherein most of the electromagnetic energy radiated by the transmitting antenna 10T can be concentrated. The transmission beam 52 may correspond to the main lobe of the transmitting antenna 10T. In Fig. 7A, the transmission beam 52 is depicted as truncated-cone-shaped. In general, the shape of the transmission beam 52 depends on the shape, structure, type of antenna 10T and/or on the operational frequency band of the transmitting antenna 10T.

The intersection of the transmission beam 52 with the radome 15 comprises the measurement cell 54. The measurement cell 54 can be the smallest area of a radome 15 that can be measured using one transmitting antenna 10T and during one measurement, i.e. during one transmission of electromagnetic waves from the transmitting antenna 10T to the receiving antenna 10R (not shown in this figure). The measurement cell 54 can also be defined as the part of the radome 15 that is traversed by electromagnetic waves that are transmitted by the transmitting antenna 10T and are received by the at least one receiving antenna 10R (not shown in this figure) during one measurement. That is, after one measurement is completed (i.e. one measurement can correspond to one cycle of the method depicted in Figs. 2a and 2b) the measurement cell 54 of the radome can be measured.

Fig. 12b illustrates the measuring of only some targeted areas of the radome 15. The targeted area 56 can comprise the part of the radome 15 that need to be measured. The targeted area can include the entire area of the radome 15 or a part of it. In the latter case, multiple targeted areas 56 can be required to be measured. As depicted in Fig. 12b, 3 targeted areas 56A, 56B and 56C are required to be measured. The targeted areas 56 can comprise regular shapes, such as, rectangular (e.g. target area 56B), triangular, elliptic (e.g. targeted area 56C), hexagonal, octagonal, etc. In general, the targeted shape can comprise any shape, e.g. the irregular shape of the targeted area 56A.

The targeted area 56 can be measured by "scanning" it, using any of the described radome measurement systems and methods. The targeted area 56 can be measured by measuring at least one measurement cell 54 that lies within or partly within the targeted area 56.

In some embodiments, a radome 15 can be measured by first positioning the radome 15 at a first distance from the at least one receiving antenna 10R. Then, without changing the distance between the radome 15 and the at least one receiving antenna, the relative positioning between the radome 15 and the antennas 10T, 10R can be changed (e.g. in a zig-zag, i.e., scanning manner). At each position, steps S7 and S9 are performed. Then, the distance between the radome and the at least one receiving antenna 10R can be changed, e.g., by a quarter of the wavelength of the emitted electromagnetic waves multiplied by an odd integer. Then, without changing the distance between the radome 15 and the at least one receiving antenna, the relative positioning between the radome 15 and the antennas 10T, 10R can be changed (e.g. in a zig-zag, i.e., scanning manner). At each position, steps S13 and S15 can be performed.

The above can allow for a particularly time efficient way of determining a respective property for multiple areas of the radome.

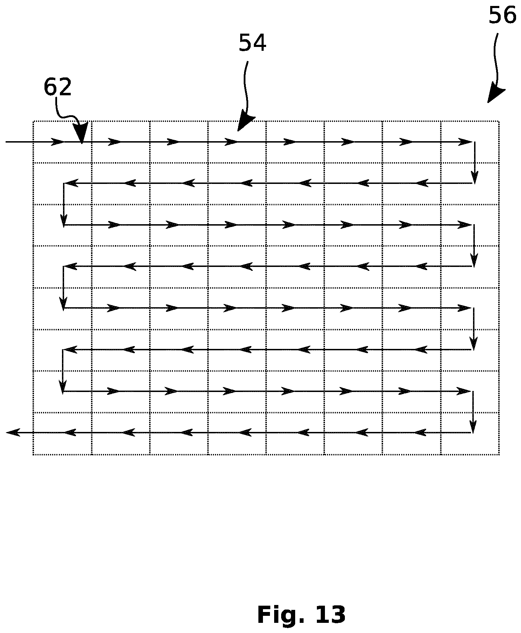

Fig. 13 illustrates how an area of a radome 15 can be measured. More particularly, Fig. 3 illustrates a target area 56 of a radome can be measured or tested. In the target area 56 a plurality of measurement cells 54 can be defined. The measurement cells 54 can be defined within the target area 56 with a density of 5 to 10 measurement cells 54 per centimeter square, such as, 8 measurement cells 54 per centimeter square. Moreover, the measurement cells 54 can be uniformly distributed within the targeted area 54. As illustrated in Fig. 13 the measurement cells 54 are arranged to form a grid within the targeted area 54.

The measurement cells 54 can comprise an area between 50 to 500 millimeter square, preferably 130 to 150 millimeter square, such as, 140 millimeter square. For example, the measurement cells 54 can comprise a width of 14 mm and a height of 10 mm.

The relative position between the radome 15 and the antennas 10T, 10R can be changed such that each measurement cell 54 can be measured. This can be performed based on a plurality of sub-motions 62 of the radome 15 and/or of the antennas 10T, 10R. For example, after each sub-motion 62 the radome 15 and the antennas 10T, 10R can be arranged such that the boresight of the antennas 10T, 10R intercepts with a respective measurement cell.

Each sub-motion 62 can be performed with a speed of 200 mm/s.

In a preferred embodiment, the method can be performed by first arranging the radome 15 and the antennas 10T, 10R such that the radome 15 comprises the first distance from the at least one receiving antenna 10R. Then, a first set of sub-motions 62 can be performed, e.g., as illustrated in Fig. 13, while maintaining the first distance between the radome 15 and the at least one receiving antenna 10R. After each sub-motion, the at least one transmitting antenna 10T can, respectively, emit a first electromagnetic wave and the at least one receiving antenna (10R) can receive a portion of the first electromagnetic wave. Based thereon, a first set of measurements can be obtained, wherein each measurement in the first set of measurement corresponds to a respective measurement cell 54.

Afterwards, the relative position between the radome 15 and the antennas 10T, 10R can be restored to the position before performing the first set of sub-motions.

Then, the radome 15 and the antennas 10T, 10R can be arranged such that the radome 15 comprises the second distance from the at least one receiving antenna 10R. While maintaining the second distance between the radome 15 and the at least one receiving antenna 10R, a second set of sub-motions 62 can be performed, preferably identical to the first set of sub-motions. After each sub-motion, the at least one transmitting antenna 10T can, respectively, emit a second electromagnetic wave and the at least one receiving antenna 10R can receive a portion of the second electromagnetic wave. Based thereon, a second set of measurements can be obtained, wherein each measurement in the second set of measurement corresponds to a respective measurement cell 54.

Thus, each measurement cell 54 is traversed by a respective first electromagnetic wave, while being positioned at the first distance from the at least one once receiving antenna 10R and by a respective second electromagnetic wave, while being positioned at the second distance from the at least one once receiving antenna 10R. As such, for each measurement cell 54 a respective property can be determined.

Hence, a plurality of properties corresponding to the radome 15 can be determined, wherein each property corresponds to a particular part (i.e. measurement cell 54) of the radome 15. This can allow to generate property maps corresponding to the radome, e.g., reflectivity maps and transmissivity maps.

As used herein, including in the claims, singular forms of terms are to be construed as also including the plural form, unless the context indicates otherwise. Thus, it should be noted that as used herein, the singular forms "a," "an," and "the" include plural references unless the context clearly dictates otherwise.

Throughout the description a0nd claims, the terms "comprise", "including", "having", and "contain" and their variations should be understood as meaning "including but not limited to", and are not intended to exclude other components.

The present invention also covers the exact terms, features, values and ranges etc. in case these terms, features, values and ranges etc. are used in conjunction with terms such as about, around, generally, substantially, essentially, at least etc. (i.e., "about 3" shall also cover exactly 3 or "substantially constant" shall also cover exactly constant).

The term "at least one" should be understood as meaning "one or more", and therefore includes both embodiments that include one or multiple components. Furthermore, dependent claims that refer to independent claims that describe features with "at least one" have the same meaning, both when the feature is referred to as "the" and "the at least one".

It will be appreciated that variations to the foregoing embodiments of the invention can be made while still falling within the scope of the appended claims.

Use of exemplary language, such as "for instance", "such as", "for example" and the like, is merely intended to better illustrate the invention and does not indicate a limitation on the scope of the invention unless so claimed. Any steps described in the specification may be performed in any order or simultaneously, unless the context clearly indicates otherwise.

All of the features and/or steps disclosed in the specification can be combined in any combination, except for combinations where at least some of the features and/or steps are mutually exclusive. In particular, preferred features of the invention are applicable to all aspects of the invention and may be used in any combination.

## Claims

1. A method of measuring a property of a radome (15), the method comprising

utilizing at least one transmitting antenna (10T) facing a first side (152) of the radome (15) and utilizing at least one receiving antenna (10R) facing a second side (154) of the radome (15), wherein the first side (152) is opposite to the second side (154);
while the radome (15) is positioned at a first distance from the at least one receiving antenna (10R), the at least one transmitting antenna (10T) emitting a first electromagnetic wave and the at least one receiving antenna (10R) receiving a portion of the first electromagnetic wave;
while the radome (15) is positioned at a second distance from the at least one receiving antenna (10R), the at least one transmitting antenna (10T) emitting a second electromagnetic wave and the at least one receiving antenna (10R) receiving a portion of the second electromagnetic wave;
determining the property of the radome (15) based on the received portion of the first electromagnetic wave and the received portion of the second electromagnetic wave;
wherein the relative position between the at least one transmitting antenna (10T) and the at least one receiving antenna (10R) is maintained fixed.

2. The method according to the preceding claim,

wherein the first and the second electromagnetic waves are emitted with a same wavelength,
wherein a difference between the first distance and the second distance depends on the wavelength of the first electromagnetic wave and the wavelength of the second electromagnetic wave and
wherein the difference between the first distance and the second distance is equal to a quarter of the wavelength of the first and second electromagnetic waves multiplied by an odd integer.

**3.** The method according to any of the preceding claims, wherein

while the radome (15) is positioned at the first distance from the at least one receiving antenna (10R) the first distance is smaller than the distance of the radome (15) from the at least one transmitting antenna (10T) and while the radome (15) is positioned at the second distance from the at least one receiving antenna (10R) the second distance is smaller than the distance of the radome from the at least one transmitting antenna (10T).

**4.** The method according to any of the preceding claims, wherein

the at least one receiving antenna (10R) receiving a portion of the first electromagnetic comprises measuring an amplitude of the received portion of the first electromagnetic wave and the at least one receiving antenna (10R) receiving a portion of the second electromagnetic comprises measuring an amplitude of the received portion of the second electromagnetic wave.

**5.** The method according to any of the preceding claims, wherein determining the property of the radome (15) comprises determining a reflection property of the radome (15) based on a difference between the received portion of the first electromagnetic wave and the received portion of the second electromagnetic wave.

**6.** The method according to any of the preceding claims, wherein determining the property of the radome (15) comprises determining a transmission property of the radome (15) based on a sum between the received portion of the first electromagnetic wave and the received portion of the second electromagnetic wave.

**7.** The method according to any of the preceding claims, wherein the method comprises

changing the relative position between the radome (15) and the at least one transmitting antenna (10T) while maintaining the first distance between the radome (15) and the at least one receiving antenna (10R), changing the relative position between the radome (15) and the at least one transmitting antenna (10T) while maintaining the second distance between the radome (15) and the at least one receiving antenna (10R), wherein changing the relative position between the radome (15) and the at least one transmitting antenna (10T) while maintaining the first distance between the radome (15) and the at least one receiving antenna (10R) comprises a first set of sub-motions, wherein changing the relative position between the radome (15) and the at least one transmitting antenna (10T) while maintaining the second distance between the radome (15) and the at least one receiving antenna (10R) comprises a second set of sub-motions, wherein the method comprises performing the second set of sub-motions after performing the first set of sub-motions, wherein the method comprises before performing the second set of sub-motions, restoring the relative position between the radome (15) and the at least one transmitting antenna (10T) to the relative position before performing the first set of sub-motions, wherein the method comprises before performing the second set of sub-motions, changing the distance between the radome and the at least one receiving antenna (10R) from the first distance to the second distance, wherein after each sub-motion of the first set of sub-motions the method comprises the at least one transmitting antenna (10T) emitting the first electromagnetic wave and the at least one receiving antenna (10R) receiving a portion of the first electromagnetic wave and wherein after each sub-motion of the second set of sub-motions the method comprises the at least one transmitting antenna (10T) emitting the second electromagnetic wave and the at least one receiving antenna (10R) receiving a portion of the second electromagnetic wave.

**8.** The method according to the preceding claim, wherein the method comprises defining a target area (56) of the radome (15) and defining a plurality of measurement cells (54) within the target area (56) and wherein

the first electromagnetic wave emitted after each sub-motion of the first set of sub-motions becomes incident on a respective measurement cell (54) and the second electromagnetic wave emitted after each sub-motion of the second set of sub-motions becomes incident on a respective measurement cell (54).

**9.** The method according to any of the preceding claims, wherein the method comprises

utilizing a clamp structure (20) for supporting the at least one transmitting antenna (10T) and the at least one receiving antenna (10R) wherein the clamp structure (20) comprises a transmitter mount of the clamp (24T), a receiver mount of the clamp (24R) and a base frame (22) and wherein the transmitter mount of the clamp (24T) and the receiver mount of the clamp (24R) extend from the same side of the base frame (22)

mounting the at least one transmitting antenna (10T) on the transmitter mount of the clamp (24T) and mounting the at least one receiving antenna (10T) on the receiver mount of the clamp (24R).

10. The method according to the preceding claim, wherein the method comprises

utilizing a positioning apparatus (30) to move the at least one transmitting antenna (10T) and the at least one receiving antenna (10R) relative to the radome (15) and
wherein the clamp structure (20) is attached to the positioning apparatus (30) and the method comprises the positioning apparatus (30) moving the clamp structure (20) to move the at least one transmitting antenna (10T) and the at least one receiving antenna (10R) relative to the radome (15).

11. The method according to any of the preceding claims, wherein the method comprises utilizing a radome handling apparatus (40) to move the radome (15) relative to the at least one transmitting antenna (10T) and to the at least one receiving antenna (10R).

12. The method according to any of the preceding claims, wherein a distance between the at least one transmitting antenna (10T) and the at least one receiving antenna (10R) is at least 10 cm and at most 1 m, such as, 25 cm.

13. The method according to any of the preceding claims, wherein the method comprises

providing reference data and determining the property based on the reference data,
wherein providing the reference data comprises measuring the reference data,
wherein measuring the reference data comprises
while a sample with known properties, instead of the radome (15), is present between the at least one transmitting antenna (10T) and the at least one receiving antenna (10R), the at least one transmitting antenna (10T) emitting a second reference electromagnetic signal and the at least one receiving antenna (10R) receiving the second reference electromagnetic signal and
determining the reference data based on a difference between the second reference electromagnetic signal as emitted by the at least one transmitting antenna (10T) and the second reference electromagnetic signal as received by the at least one receiving antenna (10R).

14. A system for measuring a property of a radome (15), the system comprising

at least one transmitting antenna (10T) facing a first side (152) of the radome (15) and at least one receiving antenna (10R) facing a second side (154) of the radome (15), wherein the first side (152) is opposite to the second side (154);
a positioning system configured to change a relative position between the radome (15) and the at least one receiving antenna;
wherein
while the radome (15) is positioned at a first distance from the at least one receiving antenna (10R) the at least one transmitting antenna (10T) is configured to emit a first electromagnetic wave and the at least one receiving antenna (10R) is configured to receive a portion of the first electromagnetic wave;
while the radome (15) is positioned at a second distance from the at least one receiving antenna (10R), the at least one transmitting antenna (10T) is configured to emit a second electromagnetic wave and the at least one receiving antenna (10R) is configured to receive a portion of the second electromagnetic wave,
wherein the system is configured to carry out the method according to any of the preceding claims.

15. Use of the system according to the preceding claim and/or the method according to any of the preceding claims 1 to 13, to measure the effects of a radar cover on electromagnetic waves traversing through the radar cover and wherein the radar cover is intended for covering at least one radar.

**Patentansprüche**

1. Verfahren zum Messen einer Eigenschaft eines Radoms (15), wobei das Verfahren umfasst

   Verwenden von mindestens einer Sendeantenne (10T), die einer ersten Seite (152) des Radoms (15) zugewandt ist, und Verwenden von mindestens einer Empfangsantenne (10R), die einer zweiten Seite (154) des Radoms (15) zugewandt ist, wobei die erste Seite (152) der zweiten Seite (154) gegenüberliegt;
   während das Radom (15) in einem ersten Abstand von der mindestens einen Empfangsantenne (10R) angeordnet ist, Emittieren einer ersten elektromagnetischen Welle durch die mindestens eine Sendeantenne (10T) und Empfangen eines Teils der ersten elektromagnetischen Welle durch die mindestens eine Empfangsantenne (10R);
   während das Radom (15) in einem zweiten Abstand von der mindestens einen Empfangsantenne (10R) angeordnet ist, Emittieren einer zweiten elektromagnetischen Welle durch die mindestens eine Sendeantenne (10T) und Empfangen eines Teils der zweiten elektromagnetischen Welle durch die mindestens eine Empfangsantenne (10R);
   Bestimmen der Eigenschaft des Radoms (15) auf der Grundlage des empfangenen Teils der ersten elektromagnetischen Welle und des empfangenen Teils der zweiten elektromagnetischen Welle;
   wobei die relative Position zwischen der mindestens einen Sendeantenne (10T) und der mindestens einen Empfangsantenne (10R) beibehalten wird.

2. Verfahren nach dem vorhergehenden Anspruch,

   wobei die erste und die zweite elektromagnetische Welle mit einer gleichen Wellenlänge emittiert werden,
   wobei eine Differenz zwischen dem ersten Abstand und dem zweiten Abstand von der Wellenlänge der ersten elektromagnetischen Welle und der Wellenlänge der zweiten elektromagnetischen Welle abhängt und
   wobei die Differenz zwischen dem ersten Abstand und dem zweiten Abstand gleich einem Viertel der Wellenlänge der ersten und zweiten elektromagnetischen Welle multipliziert mit einer ungeraden ganzen Zahl ist.

3. Verfahren nach einem der vorhergehenden Ansprüche, wobei

   während das Radom (15) in dem ersten Abstand von der mindestens einen Empfangsantenne (10R) positioniert ist, der erste Abstand kleiner ist als der Abstand des Radoms (15) von der mindestens einen Sendeantenne (10T) und
   während das Radom (15) in dem zweiten Abstand von der mindestens einen Empfangsantenne (10R) positioniert ist, der zweite Abstand kleiner ist als der Abstand des Radoms von der mindestens einen Sendeantenne (10T).

4. Verfahren nach einem der vorhergehenden Ansprüche, wobei

   das Empfangen eines Teils der ersten elektromagnetischen Welle durch die mindestens eine Empfangsantenne (10R) das Messen einer Amplitude des empfangenen Teils der ersten elektromagnetischen Welle umfasst und
   das Empfangen eines Teils der zweiten elektromagnetischen Welle durch die mindestens eine Empfangsantenne (10R) das Messen einer Amplitude des empfangenen Teils der zweiten elektromagnetischen Welle umfasst.

5. Verfahren nach einem der vorhergehenden Ansprüche, wobei das Bestimmen der Eigenschaft des Radoms (15) das Bestimmen einer Reflexionseigenschaft des Radoms (15) auf der Grundlage einer Differenz zwischen dem empfangenen Teil der ersten elektromagnetischen Welle und dem empfangenen Teil der zweiten elektromagnetischen Welle umfasst.

6. Verfahren nach einem der vorhergehenden Ansprüche, wobei das Bestimmen der Eigenschaft des Radoms (15) das Bestimmen einer Sendeeigenschaft des Radoms (15) auf der Grundlage einer Summe zwischen dem empfangenen Teil der ersten elektromagnetischen Welle und dem empfangenen Teil der zweiten elektromagnetischen Welle umfasst.

7. Verfahren nach einem der vorhergehenden Ansprüche, wobei das Verfahren umfasst:

   Ändern der relativen Position zwischen dem Radom (15) und der mindestens einen Sendeantenne (10T) unter Beibehaltung des ersten Abstands zwischen dem Radom (15) und der mindestens einen Empfangsantenne (10R),

Ändern der relativen Position zwischen dem Radom (15) und der mindestens einen Sendeantenne (10T) unter Beibehaltung des zweiten Abstands zwischen dem Radom (15) und der mindestens einen Empfangsantenne (10R),

wobei das Ändern der relativen Position zwischen dem Radom (15) und der mindestens einen Sendeantenne (10T) unter Beibehaltung des ersten Abstands zwischen dem Radom (15) und der mindestens einen Empfangsantenne (10R) einen ersten Satz von Teilbewegungen umfasst,

wobei das Ändern der relativen Position zwischen dem Radom (15) und der mindestens einen Sendeantenne (10T) unter Beibehaltung des zweiten Abstands zwischen dem Radom (15) und der mindestens einen Empfangsantenne (10R) einen zweiten Satz von Teilbewegungen umfasst,

wobei das Verfahren das Durchführen des zweiten Satzes von Teilbewegungen nach dem Durchführen des ersten Satzes von Teilbewegungen umfasst,

wobei das Verfahren vor dem Durchführen des zweiten Satzes von Teilbewegungen das Wiederherstellen der relativen Position zwischen dem Radom (15) und der mindestens einen Sendeantenne (10T) auf die relative Position vor dem Durchführen des ersten Satzes von Teilbewegungen umfasst,

wobei das Verfahren vor dem Durchführen des zweiten Satzes von Teilbewegungen das Ändern des Abstands zwischen dem Radom und der mindestens einen Empfangsantenne (10R) von dem ersten Abstand auf den zweiten Abstand umfasst,

wobei das Verfahren nach jeder Teilbewegung des ersten Satzes von Teilbewegungen das Emittieren der ersten elektromagnetischen Welle durch die mindestens eine Sendeantenne (10T) und das Empfangen eines Teils der ersten elektromagnetischen Welle durch die mindestens eine Empfangsantenne (10R) umfasst und wobei das Verfahren nach jeder Teilbewegung des zweiten Satzes von Teilbewegungen das Emittieren der zweiten elektromagnetischen Welle durch die mindestens eine Sendeantenne (10T) und das Empfangen eines Teils der zweiten elektromagnetischen Welle durch die mindestens eine Empfangsantenne (10R) umfasst.

8.  Verfahren nach dem vorhergehenden Anspruch, wobei das Verfahren das Definieren eines Zielbereichs (56) des Radoms (15) und das Definieren einer Vielzahl von Messzellen (54) innerhalb des Zielbereichs (56) umfasst und wobei

die erste elektromagnetische Welle, die nach jeder Teilbewegung des ersten Satzes von Teilbewegungen emittiert wird, auf eine entsprechende Messzelle (54) auftrifft und

die zweite elektromagnetische Welle, die nach jeder Teilbewegung des zweiten Satzes von Teilbewegungen emittiert wird, auf eine entsprechende Messzelle (54) auftrifft.

9.  Verfahren nach einem der vorhergehenden Ansprüche, wobei das Verfahren umfasst:

Verwenden einer Klammerstruktur (20) zum Tragen der mindestens einen Sendeantenne (10T) und der mindestens einen Empfangsantenne (10R), wobei die Klammerstruktur (20) eine Senderhalterung der Klammer (24T), eine Empfängerhalterung der Klammer (24R) und einen Grundrahmen (22) umfasst und wobei sich die Senderhalterung der Klammer (24T) und die Empfängerhalterung der Klammer (24R) von derselben Seite des Grundrahmens (22) erstrecken,

Montieren der mindestens einen Sendeantenne (10T) an der Senderhalterung der Klammer (24T) und

Montieren der mindestens einen Empfangsantenne (10T) an der Empfängerhalterung der Klammer (24R).

10. Verfahren nach dem vorhergehenden Anspruch, wobei das Verfahren umfasst:

Verwenden einer Positionierungsvorrichtung (30) zum Bewegen der mindestens einen Sendeantenne (10T) und der mindestens einen Empfangsantenne (10R) relativ zu dem Radom (15) und

wobei die Klammerstruktur (20) an der Positionierungsvorrichtung (30) angebracht ist und das Verfahren umfasst, dass die Positionierungsvorrichtung (30) die Klammerstruktur (20) bewegt, um die mindestens eine Sendeantenne (10T) und die mindestens eine Empfangsantenne (10R) relativ zu dem Radom (15) zu bewegen.

11. Verfahren nach einem der vorhergehenden Ansprüche, wobei das Verfahren das Verwenden einer Radom-Handhabungsvorrichtung (40) umfasst, um das Radom (15) relativ zu der mindestens einen Sendeantenne (10T) und zu der mindestens einen Empfangsantenne (10R) zu bewegen.

12. Verfahren nach einem der vorhergehenden Ansprüche, wobei ein Abstand zwischen der mindestens einen Sendeantenne (10T) und der mindestens einen Empfangsantenne (10R) mindestens 10 cm und höchstens 1 m beträgt,

**EP 4 214 801 B1**

z.B. 25 cm.

13. Verfahren nach einem der vorhergehenden Ansprüche, wobei das Verfahren umfasst:

Bereitstellen von Referenzdaten und Bestimmen der Eigenschaft auf der Grundlage der Referenzdaten, wobei das Bereitstellen der Referenzdaten das Messen der Referenzdaten umfasst, wobei das Messen der Referenzdaten Folgendes umfasst während sich eine Probe mit bekannten Eigenschaften anstelle des Radoms (15) zwischen der mindestens einen Sendeantenne (10T) und der mindestens einen Empfangsantenne (10R) befindet, Emittieren eines zweiten elektromagnetischen Referenzsignals durch die mindestens eine Sendeantenne (10T) und Empfangen des zweiten elektromagnetischen Referenzsignals durch die mindestens eine Empfangsantenne (10R) und Bestimmen der Referenzdaten auf der Grundlage einer Differenz zwischen dem zweiten elektromagnetischen Referenzsignal, wie es von der mindestens einen Sendeantenne (10T) emittiert wird, und dem zweiten elektromagnetischen Referenzsignal, wie es von der mindestens einen Empfangsantenne (10R) empfangen wird.

14. System zum Messen einer Eigenschaft eines Radoms (15), wobei das System umfasst

mindestens eine Sendeantenne (10T), die einer ersten Seite (152) des Radoms (15) zugewandt ist, und mindestens eine Empfangsantenne (10R), die einer zweiten Seite (154) des Radoms (15) zugewandt ist, wobei die erste Seite (152) der zweiten Seite (154) gegenüberliegt; ein Positionierungssystem, das dazu konfiguriert ist, eine relative Position zwischen dem Radom (15) und der mindestens einen Empfangsantenne zu ändern; wobei während das Radom (15) in einem ersten Abstand von der mindestens einen Empfangsantenne (10R) angeordnet ist, die mindestens eine Sendeantenne (10T) dazu konfiguriert ist, eine erste elektromagnetische Welle zu emittieren und die mindestens eine Empfangsantenne (10R) dazu konfiguriert ist, einen Teil der ersten elektromagnetischen Welle zu empfangen; während das Radom (15) in einem zweiten Abstand von der mindestens einen Empfangsantenne (10R) angeordnet ist, die mindestens eine Sendeantenne (10T) dazu konfiguriert ist, eine zweite elektromagnetische Welle zu emittieren und die mindestens eine Empfangsantenne (10R) dazu konfiguriert ist, einen Teil der zweiten elektromagnetischen Welle zu empfangen, wobei das System dazu konfiguriert ist, das Verfahren nach einem der vorhergehenden Ansprüche durchzuführen.

15. Verwendung des Systems nach dem vorhergehenden Anspruch und/oder des Verfahrens nach einem der vorhergehenden Ansprüche 1 bis 13, um die Auswirkungen einer Radarabdeckung auf elektromagnetische Wellen zu messen, die die Radarabdeckung durchqueren, und wobei die Radarabdeckung zur Abdeckung mindestens eines Radars bestimmt ist.

**Revendications**

1. - Procédé de mesure d'une propriété d'un radôme (15), le procédé comprenant :

utiliser au moins une antenne d'émission (10T) faisant face à un premier côté (152) du radôme (15) et utiliser au moins une antenne de réception (10R) faisant face à un second côté (154) du radôme (15), le premier côté (152) étant opposé au second côté (154) ; alors que le radôme (15) est positionné à une première distance de l'au moins une antenne de réception (10R), l'au moins une antenne d'émission (10T) émet une première onde électromagnétique et l'au moins une antenne de réception (10R) reçoit une partie de la première onde électromagnétique ; alors que le radôme (15) est positionné à une seconde distance de l'au moins une antenne de réception (10R), l'au moins une antenne d'émission (10T) émet une seconde onde électromagnétique et l'au moins une antenne de réception (10R) reçoit une partie de la seconde onde électromagnétique ; déterminer la propriété du radôme (15) sur la base de la partie reçue de la première onde électromagnétique et de la partie reçue de la seconde onde électromagnétique ; la position relative entre l'au moins une antenne d'émission (10T) et l'au moins une antenne de réception (10R) étant maintenue.

**2.** - Procédé selon la revendication précédente,

dans lequel les première et seconde ondes électromagnétiques sont émises avec une même longueur d'onde, dans lequel une différence entre la première distance et la seconde distance dépend de la longueur d'onde de la première onde électromagnétique et de la longueur d'onde de la seconde onde électromagnétique, et dans lequel la différence entre la première distance et la seconde distance est égale à un quart de la longueur d'onde des première et seconde ondes électromagnétiques multiplié par un nombre entier impair.

**3.** - Procédé selon l'une quelconque des revendications précédentes, dans lequel

alors que le radôme (15) est positionné à la première distance de l'au moins une antenne de réception (10R), la première distance est inférieure à la distance du radôme (15) à l'au moins une antenne d'émission (10T) et alors que le radôme (15) est positionné à la seconde distance de l'au moins une antenne de réception (10R), la seconde distance est inférieure à la distance du radôme à l'au moins une antenne d'émission (10T).

**4.** - Procédé selon l'une quelconque des revendications précédentes, dans lequel

l'au moins une antenne de réception (10R) recevant une partie de la première onde électromagnétique comprend mesurer une amplitude de la partie reçue de la première onde électromagnétique et l'au moins une antenne de réception (10R) recevant une partie de la seconde onde électromagnétique comprend mesurer une amplitude de la partie reçue de la seconde onde électromagnétique.

**5.** - Procédé selon l'une quelconque des revendications précédentes, dans lequel déterminer la propriété du radôme (15) comprend déterminer une propriété de réflexion du radôme (15) sur la base d'une différence entre la partie reçue de la première onde électromagnétique et la partie reçue de la seconde onde électromagnétique.

**6.** - Procédé selon l'une quelconque des revendications précédentes, dans lequel déterminer la propriété du radôme (15) comprend déterminer une propriété de transmission du radôme (15) sur la base d'une somme entre la partie reçue de la première onde électromagnétique et la partie reçue de la seconde onde électromagnétique.

**7.** - Procédé selon l'une quelconque des revendications précédentes, dans lequel le procédé comprend :

changer la position relative entre le radôme (15) et l'au moins une antenne d'émission (10T) tout en maintenant la première distance entre le radôme (15) et l'au moins une antenne de réception (10R), changer la position relative entre le radôme (15) et l'au moins une antenne d'émission (10T) tout en maintenant la seconde distance entre le radôme (15) et l'au moins une antenne de réception (10R), changer la position relative entre le radôme (15) et l'au moins une antenne d'émission (10T) tout en maintenant la première distance entre le radôme (15) et l'au moins une antenne de réception (10R) comprenant un premier ensemble de sous-mouvements, changer la position relative entre le radôme (15) et l'au moins une antenne d'émission (10T) tout en maintenant la seconde distance entre le radôme (15) et l'au moins une antenne de réception (10R) comprenant un second ensemble de sous-mouvements, le procédé comprenant mettre en oeuvre le second ensemble de sous-mouvements après la mise en oeuvre du premier ensemble de sous-mouvements, le procédé comprenant, avant la mise en oeuvre du second ensemble de sous-mouvements, rétablir la position relative entre le radôme (15) et l'au moins une antenne d'émission (10T) à la position relative avant la mise en oeuvre du premier ensemble de sous-mouvements, le procédé comprenant, avant la mise en oeuvre du second ensemble de sous-mouvements, changer la distance entre le radôme et l'au moins une antenne de réception (10R) de la première distance à la seconde distance, après chaque sous-mouvement du premier ensemble de sous-mouvements, le procédé comprenant l'au moins une antenne d'émission (10T) émettant la première onde électromagnétique et l'au moins une antenne de réception (10R) recevant une partie de la première onde électromagnétique et après chaque sous-mouvement du second ensemble de sous-mouvements, le procédé comprenant l'au moins une antenne d'émission (10T) émettant la seconde onde électromagnétique et l'au moins une antenne de réception (10R) recevant une partie de la seconde onde électromagnétique.

**8.** - Procédé selon la revendication précédente, le procédé comprenant définir une zone cible (56) du radôme (15) et définir une pluralité de cellules de mesure (54) à l'intérieur de la zone cible (56), et dans lequel

la première onde électromagnétique émise après chaque sous-mouvement du premier ensemble de sous-mouvements devient incidente sur une cellule de mesure respective (54), et

la seconde onde électromagnétique émise après chaque sous-mouvement du second ensemble de sous-mouvements devient incidente sur une cellule de mesure respective (54).

9.  - Procédé selon l'une quelconque des revendications précédentes, le procédé comprenant :

utiliser une structure d'élément de serrage (20) pour supporter l'au moins une antenne d'émission (10T) et l'au moins une antenne de réception (10R), la structure de pince de serrage (20) comprenant un support d'émetteur de la pince de serrage (24T), un support de récepteur de la pince de serrage (24R), et un cadre de base (22), et le support d'émetteur de la pince de serrage (24T) et le support de récepteur de la pince de serrage (24R) s'étendant à partir du même côté du cadre de base (22),
monter l'au moins une antenne d'émission (10T) sur le support d'émetteur de la pince de serrage (24T), et
monter l'au moins une antenne de réception (10T) sur le support de récepteur de la pince de serrage (24R).

10. - Procédé selon la revendication précédente, le procédé comprenant :

utiliser un appareil de positionnement (30) pour déplacer l'au moins une antenne d'émission (10T) et l'au moins une antenne de réception (10R) par rapport au radôme (15) et
la structure de pince de serrage (20) étant fixée à l'appareil de positionnement (30) et le procédé comprenant l'appareil de positionnement (30) déplaçant la structure de pince de serrage (20) pour déplacer l'au moins une antenne d'émission (10T) et l'au moins une antenne de réception (10R) par rapport au radôme (15).

11. - Procédé selon l'une quelconque des revendications précédentes, le procédé comprenant utiliser un appareil de manipulation de radôme (40) pour déplacer le radôme (15) par rapport à l'au moins une antenne d'émission (10T) et à l'au moins une antenne de réception (10R).

12. - Procédé selon l'une quelconque des revendications précédentes, dans lequel une distance entre l'au moins une antenne d'émission (10T) et l'au moins une antenne de réception (10R) est d'au moins 10 cm et d'au plus 1 m, par exemple 25 cm.

13. - Procédé selon l'une quelconque des revendications précédentes, le procédé comprenant :

se procurer des données de référence et déterminer la propriété sur la base des données de référence,
se procurer les données de référence comprenant mesurer les données de référence,
mesurer les données de référence comprenant
alors qu'un échantillon ayant des propriétés connues, au lieu du radôme (15), est présent entre l'au moins une antenne d'émission (10T) et l'au moins une antenne de réception (10R), l'au moins une antenne d'émission (10T) émet un second signal électromagnétique de référence et l'au moins une antenne de réception (10R) reçoit le second signal électromagnétique de référence et
déterminer les données de référence sur la base d'une différence entre le second signal électromagnétique de référence tel qu'émis par l'au moins une antenne d'émission (10T) et le second signal électromagnétique de référence tel que reçu par l'au moins une antenne de réception (10R).

14. - Système pour mesurer une propriété d'un radôme (15), le système comprenant

au moins une antenne d'émission (10T) faisant face à un premier côté (152) du radôme (15) et au moins une antenne de réception (10R) faisant face à un second côté (154) du radôme (15), le premier côté (152) étant opposé au second côté (154) ;
un système de positionnement configuré pour changer une position relative entre le radôme (15) et l'au moins une antenne de réception ;
alors que le radôme (15) est positionné à une première distance de l'au moins une antenne de réception (10R), l'au moins une antenne d'émission (10T) étant configurée pour émettre une première onde électromagnétique et l'au moins une antenne de réception (10R) étant configurée pour recevoir une partie de la première onde électromagnétique ;
alors que le radôme (15) est positionné à une seconde distance de l'au moins une antenne de réception (10R), l'au moins une antenne d'émission (10T) étant configurée pour émettre une seconde onde électromagnétique et l'au moins une antenne de réception (10R) étant configurée pour recevoir une partie de la seconde onde électromag nétiq ue,
le système étant configuré pour mettre en oeuvre le procédé selon l'une quelconque des revendications précédentes.

15. - Utilisation du système selon la revendication précédente et/ou du procédé selon l'une quelconque des revendications précédentes 1 à 13, pour mesurer les effets d'une couverture de radar sur des ondes électromagnétiques traversant la couverture de radar et dans laquelle la couverture de radar est destinée à couvrir au moins un radar.

**Fig. 1a (Background)**

$a_{trans}$

$a_{Tx}$

$a_{ref,1}$

**Fig. 1b (Background)**

$a_{ret}$

$a_{Rx}$

$a_{ref,2}$

**S1**

Provide at least one transmission antenna facing a first side of the radome

**S3**

Provide at least one receiving antenna facing a second side of the radome opposite to the first side

**S5**

Position the radome and/or the antennas such that the radome is at a **first** distance from the at least one receiving antenna

**S7**

Emit with the at least one transmitting antenna a **first** electromagnetic wave

**S9**

Receive with the at least one receiving antenna a portion of the **first** electromagnetic wave

**Fig. 2a**

**S11**

Position the radome and/or the antennas such that the radome is at a **second** distance from the at least one receiving antenna

**S13**

Emit with the at least one transmitting antenna a **second** electromagnetic wave

**S15**

Receive with the at least one receiving antenna a portion of the **second** electromagnetic wave

**S17**

Determine a property of the radome based on the received portion of the first electromagnetic wave and the received portion of the second electromagnetic wave

**Fig. 2b**

15

10T

d1

10R (R3)

a1

a2

a3

a4

a5

Tx

Rx

152
(T1, R1)

154
(T2, R2)

**Fig. 3a**

15

10T

d2

10R (R3)

b1

b2

b3

b4

b5

Tx

Rx

152
(T1, R1)

154
(T2, R2)

**Fig. 3b**

**Fig. 4**

15

L/2   L/2

10T

10R

Tx   Rx

**Fig. 5a**

15

5L/6   L/6

10T

10R

Tx   Rx

**Fig. 5b**

**S19**

Provide reference data

**S17a**

Determine a property of the radome based on the reference data

**Fig. 6**

**1**

10T

15

10R

Tx

α

Rx

142T

14

142R

11T

Measuring Device

11R

12

**Fig. 7**

**2**

10T

15

10R

Tx

α

Rx

24T

12

24R

20

22

Measuring Device

14

**Fig. 8**

**3**

**Fig. 9a**

Fig. 9b

**Fig. 10**

**Fig. 11**

**Fig. 12a**

**Fig. 12b**

**Fig. 13**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5371505 A
- US 3936736 A
- EP 3258288 A1
- US 5066921 A
- FR 2692360 A1
- US 2020049751 A

**Non-patent literature cited in the description**

- **Z. QAMAR ; N. ABOSERWAL ; J. L. SALA-ZAR-CERRENO.** An Accurate Method for Designing, Characterizing, and Testing a Multi-Layer Radome for mm-Wave Applications. *IEEE Access,* 2020, vol. 8, 23041-23053